(19) Europäisches Patentamt
European Patent Office
Office européen des brevets

(11) **EP 4 143 953 B1**

(12) **EUROPÄISCHE PATENTSCHRIFT**

(45) Veröffentlichungstag und Bekanntmachung des Hinweises auf die Patenterteilung:
**01.11.2023 Patentblatt 2023/44**

(21) Anmeldenummer: **21732250.2**

(22) Anmeldetag: **09.06.2021**

(51) Internationale Patentklassifikation (IPC):
*H02K 41/03* (2006.01)   *H02P 6/00* (2016.01)
*H02P 25/06* (2016.01)   *H01L 21/68* (2006.01)

(52) Gemeinsame Patentklassifikation (CPC):
**H02P 6/006; H01L 21/68; H02K 41/031; H02P 25/06**

(86) Internationale Anmeldenummer:
**PCT/EP2021/065425**

(87) Internationale Veröffentlichungsnummer:
**WO 2021/250077 (16.12.2021 Gazette 2021/50)**

(54) **VERFAHREN ZUM STEUERN EINES PLANARANTRIEBSSYSTEMS UND PLANARANTRIEBSSYSTEM**

METHOD FOR CONTROLLING A PLANAR DRIVE SYSTEM, AND PLANAR DRIVE SYSTEM

PROCÉDÉ DE COMMANDE D'UN SYSTÈME D'ENTRAÎNEMENT PLAN ET SYSTÈME D'ENTRAÎNEMENT PLAN

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **10.06.2020 DE 102020115449**

(43) Veröffentlichungstag der Anmeldung:
**08.03.2023 Patentblatt 2023/10**

(73) Patentinhaber: **Beckhoff Automation GmbH 33415 Verl (DE)**

(72) Erfinder:
• **NEUMANN, Klaus**
  **33332 Gütersloh (DE)**
• **JURKE, Benjamin**
  **33332 Gütersloh (DE)**
• **WEDDEMANN, Alexander**
  **59558 Lippstadt (DE)**
• **SENSEN, Dominik**
  **33647 Bielefeld (DE)**
• **MAGUIRE, Keir**
  **Vancouver, British Columbia V6K 4S7 (CA)**

(74) Vertreter: **Patentanwaltskanzlei WILHELM & BECK
Prinzenstraße 13
80639 München (DE)**

(56) Entgegenhaltungen:
WO-A1-2015/017933       DE-A1-102017 131 314
DE-A1-102017 131 320

• **CHEN LONGMIN ET AL: "A 6-DOF Measurement Solution for Permanent Magnet Synchronous Planar Motors Based on Motion Continuity Principle", IEEE TRANSACTIONS ON INSTRUMENTATION AND MEASUREMENT, IEEE SERVICE CENTER, PISCATAWAY, NJ, US, Bd. 65, Nr. 3, 1. März 2016 (2016-03-01), Seiten 643-655, XP011598034, ISSN: 0018-9456, DOI: 10.1109/TIM.2015.2509218 [gefunden am 2016-02-08]**

EP 4 143 953 B1

**Beschreibung**

Die Erfindung betrifft ein Verfahren zum Steuern eines Planarantriebssystems und ein Planarantriebssystem, das eingerichtet ist, das Verfahren zum Steuern eines Planarantriebssystems auszuführen.

Diese Patentanmeldung beansprucht die Priorität der deutschen Patentanmeldung DE 10 2020 115 449.6. Planarantriebssysteme können unter anderem in der Automatisierungstechnik, insbesondere der Fertigungstechnik, der Handhabungstechnik und der Verfahrenstechnik eingesetzt werden. Mittels Planarantriebssystemen kann ein bewegliches Element einer Anlage oder Maschine in mindestens zwei linear unabhängigen Richtungen bewegt oder positioniert werden. Planarantriebssysteme können einen permanenterregten elektromagnetischen Planarmotor mit einem planaren Stator und einem auf dem Stator in mindestens zwei Richtungen beweglichen Läufer umfassen.

Bei einem permanenterregten elektromagnetischen Planarmotor wird dadurch eine Antriebskraft auf den Läufer ausgeübt, dass stromdurchflossene Leiter mit Antriebsmagneten einer Magnetanordnung magnetisch wechselwirken. Die Erfindung betrifft insbesondere Ausgestaltungen von Planarantriebssystemen, bei denen die Antriebsmagneten eines elektrischen Planarmotors an dem Läufer und die stromdurchflossenen Leiter des Planarmotors in einem ortsfest angeordneten planaren Stator angeordnet sind.

Bei einem derartigen Antriebssystem umfasst der Läufer mindestens eine erste Magneteinheit für den Antrieb des Läufers in eine erste Richtung und eine zweite Magneteinheit für den Antrieb des Läufers in eine von der ersten Richtung linear unabhängige, beispielsweise in eine zu der ersten Richtung orthogonale, zweite Richtung. Der planare Stator umfasst mindestens eine Gruppe erster bestrombarer Leiter, welche mit den Magneten der ersten Magneteinheit magnetisch wechselwirken, um den Läufer in die erste Richtung anzutreiben, sowie eine Gruppe zweiter bestrombarer Leiter, welche mit den Magneten der zweiten Magneteinheit magnetisch wechselwirken, um den Läufer in die zweite Richtung anzutreiben. Die ersten und zweiten Gruppen von Leitern sind in der Regel unabhängig voneinander bestrombar, um voneinander unabhängige Bewegungen des Läufers in die erste und zweite Richtung zu ermöglichen. Sind die Leiter der ersten und zweiten Gruppe selbst zumindest in Teilen unabhängig voneinander bestrombar, können auf einem Stator zeitgleich mehrere Läufer unabhängig voneinander bewegt werden.

Zur Steuerung eines Läufers eines Planarantriebssystems ist es maßgeblich, eine Position des Läufers relativ zu dem Statormodul beziehungsweise zu den Statormodulen des Planarantriebssystems bestimmen zu können. Hierzu weist jedes Statormodul wenigstens ein Sensormodul mit einer Mehrzahl von Magnetfeldsensoren auf, die eingerichtet sind, das Magnetfeld des Läufers zu detektieren, wodurch eine Positionsbestimmung des Läufers relativ zu dem jeweiligen Sensormodul beziehungsweise relativ zu dem jeweiligen Statormodul ermöglicht wird. Für eine präzise und energiesparende Steuerung eines Planarantriebssystems ist essenziell, nur die Magnetfeldsensoren des Sensormoduls auszuwählen und bei der Positionsbestimmung des zu steuernden Läufers auszuwählen, die zur Positionsbestimmung einen relevanten Beitrag leisten können.

Aus der Druckschrift WO 2015/017933 A1 sind Läufer eines Planarantriebssystems und Verfahren und Vorrichtung zum Bestimmen einer Bewegung der Läufer bekannt. Aus der Druckschrift DE 10 2017 131320 A1 sind ein Planarantriebssystem, ein Statormodul und ein Sensormodul bekannt. Aus der Druckschrift DE 10 2017 131314 A1 ist ein Statormdul für ein Planarantriebssystem bekannt. Aus der Druckschrift CHEN LNGMIN ET AL:" A 6-DOF Measurement Solution for Permanent Magnet Synchronous Planar Motors Based on Motion Continuity Principle", IEEE TRANSACTION, IEEE SERVICE CENTER, PISCATAWAY, NJ, US, Bd. 65, Nr. 3, 1. März 2016 (2016-03-01), Seiten 643-655, ISSN: 0018-9456, DOI: 10.1109TIM.2015.2509218 ist eine messtechnische Lösung unter Berücksichtigung von sechs Freiheitsgraden für Permanentmagnet-Synchron-Planarmotoren basierend auf einem Bewegungskontinuitätsprinzip bekannt.

Es ist daher eine Aufgabe der Erfindung, ein Verfahren zum Steuern eines Planarantriebssystems bereitzustellen, das aufgrund einer effizienten Auswahl der relevanten Magnetfeldsensoren zur Bestimmung einer Position eines Läufers ein verbessertes und präziseres Steuern des Läufers ermöglicht. Eine weitere Aufgabe der Erfindung ist es, ein Planarantriebssystem bereitzustellen, das eingerichtet ist, das erfindungsgemäße Verfahren auszuführen.

Die Aufgaben werden durch ein Verfahren zum Steuern eines Planarantriebssystems und ein Planarantriebssystem gemäß den unabhängigen Ansprüchen gelöst. Bevorzugte Ausführungsformen sind in den abhängigen Ansprüchen angegeben.

Nach einem Aspekt der Erfindung wird ein Verfahren zum Steuern eines Planarantriebssystems, wobei das Planarantriebssystem wenigstens eine Steuereinheit, ein Statormodul und einen Läufer umfasst, wobei der Läufer über eine magnetische Kopplung zwischen einem Läufermagnetfeld des Läufers und einem Statormagnetfeld des Statormoduls antreibbar und steuerbar ist, wobei das Statormodul zum Bestimmen einer Position des Läufers ein Sensormodul mit einer Mehrzahl von Magnetfeldsensoren umfasst, und wobei jeder Magnetfeldsensor eingerichtet ist, für einen Raumbereich das Läufermagnetfeld zu bestimmen, umfassend:

  Steuern des Läufers entlang eines Steuerpfads ausgehend von einer ersten Position auf dem Statormodul, in einem Steuerschritt;

Bestimmen eines Sensormusters der Magnetfeldsensoren des Sensormoduls in einem Sensormusterbestimmungsschritt, wobei ein Sensormuster eine Teilmenge der Magnetfeldsensoren des Sensormoduls des Statormoduls umfasst, wobei das Sensormodul wenigstens einen Magnetfeldsensor umfasst, der nicht vom Sensormuster umfasst ist, und wobei eine Fläche des Sensormusters vom Läufer in einer Position entlang des Steuerpfads wenigstens teilweise abgedeckt ist;

Messen von Messwerten des Läufermagnetfelds durch die Magnetfeldsensoren des Sensormusters in einem Läufermagnetfeldbestimmungsschritt;

Detektieren des Läufers und Bestimmen einer zweiten Position des Läufers auf Basis der von den Magnetfeldsensoren des Sensormusters gemessenen Messwerte des Läufermagnetfels in einem Positionsbestimmungsschritt.

Hierdurch wird der technische Vorteil erreicht, dass ein Verfahren zum Steuern eines Planarantriebssystems bereitgestellt werden kann, bei dem für eine Positionsbestimmung des Läufers auf dem Statormodul des Planarantriebssystems ausschließlich relevante Magnetfeldsensoren des Sensormoduls des Statormoduls ausgewählt werden.

Hierzu wird in einem Sensormusterbestimmungsschritt ein Sensormuster der Magnetfeldsensoren des Sensormoduls bestimmt, mittels denen in einem Läufermagnetfeldbestimmungsschritt Messwerte des Läufermagnetfelds des Läufers aufgenommen werden. Hierdurch wird erreicht, dass ausschließlich die Magnetfeldsensoren des Sensormusters zur Bestimmung der Position des Läufers durch Aufnehmen entsprechender Messwerte des Läufermagnetfelds verwendet werden. Das Sensormuster kann hierbei derart ausgewählt werden, dass für eine zu bestimmende Position alle Magnetfeldsensoren des ausgewählten Sensormusters von dem Läufer abgedeckt werden.

Hierdurch kann erreicht werden, dass zur Positionsbestimmung ausschließlich Magnetfeldsensoren verwendet werden, die einen relevanten Betrag des Läufermagnetfelds aufnehmen können. Dies trägt zur Präzision der Bestimmung des Läufermagnetfelds und damit verbunden zur Positionsbestimmung des Läufers auf dem Statormodul bei. Darüber hinaus kann durch die Beschränkung der für eine Positionsbestimmung verwendeten Magnetfeldsensoren auf die Magnetfeldsensoren des ausgewählten Sensormusters erreicht werden, dass für jede Positionsbestimmung des Läufers auf dem Statormodul lediglich eine minimale Anzahl der Magnetfeldsensoren des Sensormoduls ausgewertet werden müssen. Hierdurch kann eine beschleunigte Verarbeitung der aufgenommenen Messwerte und damit verbunden eine beschleunigte Positionsbestimmung des Läufers auf dem Statormodul erreicht werden. Außerdem wird durch das Auswählen der Magnetfeldsensoren, die zur Bestimmung des Läufermagnetfelds einen substantiellen Beitrag leisten können, Rechenkapazität der Steuerung eingespart. Darüber hinaus kann durch die Auswahl der geeigneten Magnetfeldsensoren das Datenvolumen der zur Bestimmung des Läufermagnetfelds zu verarbeitenden Messwerte der Magnetfeldsensoren reduziert werden.

Ein Sensormuster ist im Sinne der Anmeldung eine Menge von Magnetfeldsensoren des Sensormoduls, die einen zusammenhängenden Flächenbereich des Statormoduls abdecken. Ein Sensormuster kann hierbei eine beliebige zweidimensionale Gestalt aufweisen und eine beliebige Anzahl von Magnetfeldsensoren umfassen. Ein Sensormuster kann auf dem Statormodul beliebig verschoben werden, wodurch das jeweilige Sensormuster unterschiedliche Magnetfeldsensoren des Sensormoduls umfasst. Ein Sensormuster kann darüber hinaus Magnetfeldsensoren mehrerer aneinandergekoppelter, beziehungsweise nebeneinander angeordneter und/oder aneinander angrenzender, Statormodule umfassen. Über ein Sensormuster kann ein entsprechendes Muster an Messwerten der Magnetfeldsensoren des Sensormusters aufgenommen werden, über die eine zweidimensionale Beschreibung des Läufermagnetfelds für die durch das Sensormuster abgedeckte zusammenhängende Fläche eines oder mehrerer Statormodule ermöglicht ist.

Der Sensormusterbestimmungsschritt umfasst hierbei:

Bestimmen eines ersten zentralen Magnetfeldsensors und Bestimmen eines zweiten zentralen Magnetfeldsensors und/oder Bestimmen eines dritten zentralen Magnetfeldsensors und Bestimmen eines vierten zentralen Magnetfeldsensors in einem Magnetfeldsensorbestimmungsschritt, wobei der erste zentrale Magnetfeldsensor und der zweite zentrale Magnetfeldsensor und/oder der dritte zentrale Magnetfeldsensor und der vierte zentrale Magnetfeldsensor zur ersten Position direkt benachbart sind und kürzeste Abstände zur ersten Position aufweisen;

Ermitteln einer vorbestimmten Mehrzahl von ersten Magnetfeldsensoren, die den ersten zentralen Magnetfeldsensor umgeben und Identifizieren der Mehrzahl von ersten Magnetfeldsensoren als erstes Sensormuster in einem ersten Identifikationsschritt, wobei der erste zentrale Magnetfeldsensor in einem ersten geometrischen Zentrum des ersten Sensormusters angeordnet ist;

Ermitteln einer vorbestimmten Mehrzahl von zweiten Magnetfeldsensoren, die den zweiten zentralen Magnetfeldsensor umgeben, und Identifizieren der Mehrzahl von zweiten Magnetfeldsensoren als zweites Sensormuster in einem zweiten Identifikationsschritt, wobei der zweite zentrale Magnetfeldsensor in einem zweiten geometrischen Zentrum des zweiten Sensormusters angeordnet ist; und/oder

Das Sensormuster umfasst wenigstens ein erstes Sensormuster und ein zweites Sensormuster, wobei das erste Sensormuster und das zweite Sensormuster in eine erste Orientierungsrichtung gegeneinander verschoben sind, und wobei der Läufermagnetfeldbestimmungsschritt umfasst:

Messen von ersten Messwerten des Läufermagnetfelds durch die Magnetfeldsensoren des ersten Sensormusters in einem ersten Läufermagnetfeldteilbestimmungsschritt;

Messen von zweiten Messwerten des Läufermagnetfelds durch die Magnetfeldsensoren des zweiten Sensormusters in einem zweiten Läufermagnetfeldteilbestimmungsschritt;

Wobei der Positionsbestimmungsschritt umfasst:

Detektieren des Läufers und Bestimmen einer ersten Teilposition des Läufers auf Basis der von den Magnetfeldsensoren des ersten Sensormusters gemessenen ersten Messwerte des Läufermagnetfels in einem ersten Läuferteildetektionsschritt;

Detektieren des Läufers und Bestimmen einer zweiten Teilposition Läufers auf Basis der von den Magnetfeldsensoren des zweiten Sensormusters gemessenen Messwerte des Läufermagnetfels in einem zweiten Läuferteildetektionsschritt;

Bestimmen eines ersten Gewichtungswerts des ersten Sensormusters und eines zweiten Gewichtungswerts des zweiten Sensormuster in einem Gewichtungsschritt; und

Bestimmen der zweiten Position des Läufers als einen gewichteten Mittelwert aus der ersten Teilposition und der zweiten Teilposition unter Berücksichtigung des ersten Gewichtungswerts und des zweiten Gewichtungswerts in einem Mittelwertbildungsschritt.

Hierdurch wird der technische Vorteil erreicht, dass eine präzise Auswahl der für eine Positionsbestimmung relevanten Magnetfeldsensoren ermöglicht ist. Hierzu weist das Sensormuster ein erstes Sensormuster und ein zweites Sensormuster auf, die jeweils in einer ersten Richtung zueinander verschoben sind. Beide Sensormuster weisen einen Überlappungsbereich auf, in dem die jeweiligen Magnetfeldsensoren sowohl vom ersten Sensormuster als auch vom zweiten Sensormuster umfasst sind. Über die Magnetfeldsensoren der beiden Sensormuster können individuell Messwerte des Läufermagnetfelds aufgenommen und der entsprechende Läufer detektiert werden. Über jedes der beiden Sensormuster kann somit eine Position des Läufers auf Basis der aufgenommenen Messwerte der jeweiligen Magnetfeldsensoren des Sensormusters bestimmt werden. Zur Positionsbestimmung des Läufers kann ein gewichteter Mittelwert der beiden durch die einzelnen Sensormuster bestimmten Positionen des Läufers erstellt werden. Hierdurch kann eine präzise Positionsbestimmung des Läufers erreicht werden, bei der zwei individuelle Positionsbestimmungen unter Berücksichtigung einer Gewichtung berücksichtigt werden.

Der gewichtete Mittelwert kann ein gewichtetes arithmetisches Mittel sein. Alternativ kann der gewichtete Mittelwert ein gewichtetes harmonisches Mittel sein. Alternativ kann der gewichtete Mittelwert ein gewichtetes geometrisches Mittel sein.

Nach einer Ausführungsform umfasst das Sensormuster ferner ein drittes Sensormuster und ein viertes Sensormuster, wobei das dritte Sensormuster und das vierte Sensormuster in eine zur ersten Orientierungsrichtung senkrecht orientierte zweite Orientierungsrichtung gegeneinander verschoben sind, und wobei der Läufermagnetfeldbestimmungsschritt umfasst:

Messen von dritten Messwerten des Läufermagnetfelds durch die Magnetfeldsensoren des dritten Sensormusters in einem dritten Läufermagnetfeldteilbestimmungsschritt;

Messen von vierten Messwerten des Läufermagnetfelds durch die Magnetfeldsensoren des vierten Sensormusters in einem vierten Läufermagnetfeldteilbestimmungsschritt;

wobei der Positionsbestimmungsschritt umfasst:

Detektieren des Läufers und Bestimmen einer dritten Teilposition des Läufers auf Basis der von den Magnetfeldsensoren des dritten Sensormusters gemessenen dritten Messwerte des Läufermagnetfels in einem dritten Läuferteildetektionsschritt;

Detektieren des Läufers und Bestimmen einer vierten Teilposition Läufers auf Basis der von den Magnetfeldsensoren des vierten Sensormusters gemessenen Messwerte des Läufermagnetfelds in einem vierten Läuferteildetektionsschritt;

Bestimmen eines dritten Gewichtungswerts des dritten Sensormusters und eines vierten Gewichtungswerts des vierten Sensormuster im Gewichtungsschritt; und

Bestimmen der zweiten Position des Läufers als einen gewichteten Mittelwert aus der ersten Teilposition, der zweiten Teilposition, der dritten Teilposition und der vierten Teilposition unter Berücksichtigung des ersten Gewichtungswert, des zweiten Gewichtungswerts, des dritten Gewichtungswerts und vierten Gewichtungswerts im Mittelwertbildungsschritt.

Hierdurch wird der technische Vorteil erreicht, dass eine weitere Präzisierung der Positionsbestimmung ermöglicht ist. Hierbei umfasst das Sensormuster zusätzlich ein drittes Sensormuster und ein viertes Sensormuster, die jeweils in einer zur ersten Richtung senkrecht orientierten zweiten Richtung gegeneinander verschoben sind. Auf Basis der Magnetfeldsensoren der vier Sensormuster können somit vier individuell unabhängige Positionsbestimmungen des Läufers durchgeführt werden. Mittels der vier individuell bestimmten Teilpositionen kann im Folgenden unter Berücksichtigung entsprechender Gewichtungswerte eine Positionsbestimmung des Läufers in Form des gewichteten Mittelwerts durchgeführt werden. Hierdurch wird eine weitere Präzisierung der Positionsbestimmung erreicht, indem eine Position des Läufers als ein gewichteter Mittelwert aus vier individuell bestimmten Teilpositionen ermittelt wird.

Nach einer Ausführungsform umfasst der Sensormusterbestimmungsschritt:
Ermitteln einer vorbestimmten Mehrzahl von dritten zentralen Magnetfeldsensoren, die den dritten Magnetfeldsensor umgeben, und Identifizieren der Mehrzahl von dritten Magnetfeldsensoren als drittes Sensormuster in einem dritten Identifikationsschritt, wobei der dritte zentrale Magnetfeldsensor in einem dritten geometrischen Zentrum des dritten Sensormusters angeordnet ist; und Ermitteln einer vorbestimmten Mehrzahl von ersten Magnetfeldsensoren, die den vierten zentralen Magnetfeldsensor umgeben, und Identifizieren der Mehrzahl von vierten Magnetfeldsensoren als viertes Sensormuster in einem vierten Identifikationsschritt, wobei der vierte zentrale Magnetfeldsensor in einem vierten geometrischen Zentrum des vierten Sensormusters angeordnet ist.

Hierdurch wird der technische Vorteil erreicht, dass eine präzise Bestimmung der Sensormuster bereitgestellt werden kann. Insbesondere wird erreicht, dass die Magnetfeldsensoren als Sensormuster ausgewählt werden, die benachbart zur ersten Position des Läufers auf dem Statormodul angeordnet sind. Durch die Auswahl der zur ersten Position benachbarten Magnetfeldsensoren als die Sensormuster zur Bestimmung der zweiten Position, kann die zweite Position auf Basis der Messwerte des Läufermagnetfelds der Magnetfeldsensoren bestimmt werden, die bereits zur Positionsbestimmung der ersten Position beigetragen haben. Hierdurch ist eine einfache Auswahl von Magnetfeldsensoren erreicht. Insbesondere für den Fall, dass die ersten und zweiten Positionen nur geringfügig voneinander abweichen, kann über die zur ersten Position benachbarten Magnetfeldsensoren eine präzise Positionsbestimmung der zweiten Position erreicht werden, da aufgrund der Ausbildung der Sensormuster und der von den Sensormustern abgedeckten Fläche, die zweite Position innerhalb wenigstens eines der Sensormuster positioniert sein wird.

Nach einer Ausführungsform umfasst das Verfahren ferner:
Bestimmen eines ersten Übereinstimmungswerts der ersten Position des Läufers auf dem Statormodul mit einer ersten Positionierung des ersten Sensormusters auf dem Statormodul und Bestimmen eines zweiten Übereinstimmungswerts der ersten Position des Läufers auf dem Statormodul mit einer zweiten Positionierung des zweiten Sensormusters auf dem Statormodul und/oder Bestimmen eines dritten Übereinstimmungswerts der ersten Position des Läufers auf dem Statormodul mit einer dritten Positionierung des dritten Sensormusters auf dem Statormodul und Bestimmen eines vierten Übereinstimmungswerts der ersten Position des Läufers auf dem Statormodul mit einer vierten Positionierung des vierten Sensormusters auf dem Statormodul in einem Übereinstimmungsbestimmungsschritt, wobei ein Übereinstimmungswert bei Übereinstimmung der ersten Position des Läufers mit einer Positionierung eines Sensormusters den Wert 1, bei fehlender Übereinstimmung der ersten Position des Läufers mit einer Positionierung eines Sensormusters den Wert 0 und bei Teilübereinstimmung der ersten Position des Läufers mit einer Positionierung eines Sensormusters eine beliebigen Wert zwischen 1 und 0 annimmt; und Identifizieren des ersten Gewichtungswerts mit dem ersten Übereinstimmungswert und Identifizieren des zweiten Gewichtungswerts mit dem zweiten Übereinstimmungswert und/oder Identifizieren des dritten Gewichtungswerts mit dem dritten Übereinstimmungswert und Identifizieren des vierten Gewichtungswerts mit dem vierten Übereinstimmungswert in einem Gewichtungswertidentifikationsschritt.

Hierdurch wird der technische Vorteil erreicht, dass eine Auswahl der Magnetfeldsensoren der zur Positionsbestimmung der zweiten Position verwendeten Sensormuster auf Basis der für die Positionsbestimmung der ersten Position verwendeten Magnetfeldsensoren vorgenommen werden kann. Hierdurch wird eine Auswahl der für die Positionsbestimmung der zweiten Position relevanten Magnetfeldsensoren vereinfacht. Hierzu wird gewährleistet, dass die zur Bestimmung der zweiten Position ausgewählten ersten bis vierten Sensormuster Flächen auf dem Statormodul belegen, die die erste Position des Läufers auf dem Statormodul umfassen. Zur Bestimmung der ersten bis vierten Gewichtungswerte werden ferner Übereinstimmungen der ersten Position mit den Positionierungen der ersten bis vierten Sensormuster ermittelt.

Eine Positionierung eines Sensormusters ergibt sich hierbei über die Positionierung der Magnetfeldsensoren des Sensormusters auf dem Statormodul.

Bei einer hohen Übereinstimmung der ersten Position mit der Positionierung eines der Sensormuster wird in der Bestimmung der zweiten Position die durch das jeweilige Sensormuster bestimmte Teilposition mit einem entsprechenden hohen Gewichtungswert versehen, während bei einer geringen Übereinstimmung der ersten Position mit der Positionierung eines Sensormusters die durch das jeweilige Sensormuster bestimmte Teilposition mit einem entsprechenden geringen Gewichtungswert versehen wird. Die Auswahl, der zur Bestimmung der zweiten Position benötigten Sensormuster, kann somit an der zum Zeitpunkt der Auswahl der Sensormuster bekannten ersten Position des Läufers orientiert werden. Hierdurch wird eine möglichst einfache Auswahl der zur Bestimmung der zweiten Position benötigten Magnetfeldsensoren erreicht, indem die zur Bestimmung der ersten Position verwendeten Magnetfeldsensoren berücksichtigt werden.

Durch die in zwei senkrecht zueinander orientierte Richtungen ausgerichtete Verschiebung der vier Sensormuster wird erreicht, dass bei einer substanziellen Abweichung der zweiten Position des Läufers von der ersten Position die zweite Position durch wenigstens eines der vier Sensormuster abgedeckt ist. Zur Auswahl der Magnetfeldsensoren zur Bestimmung der zweiten Position in Form der vier bestimmten Sensormuster ist neben der bekannten ersten Position des Läufers eine Berücksichtigung der Richtung des Steuerpfads, den der Läufer auf dem Statormodul zwischen der ersten Position und der zweiten Position zurücklegt, nicht notwendig.

Nach einer Ausführungsform liegt eine Übereinstimmung der ersten Position des Läufers auf dem Statormodul mit einer Positionierung eines Sensormusters vor, falls ein Abstand der ersten Position des Läufers zu einem ausgezeichneten Punkt des Sensormusters kleiner oder gleich einem ersten vorbestimmten Grenzwert ist, wobei keine Übereinstimmung der ersten Position des Läufers auf dem Statormodul mit einer Positionierung eines Sensormusters vorliegt, falls ein Abstand der ersten Position des Läufers zu dem ausgezeichneten Punkt des Sensormusters größer oder gleich einem zweiten vorbestimmten Grenzwert ist, und wobei eine Teilübereinstimmung der ersten Position des Läufers auf dem Statormodul mit der Positionierung des Sensormusters vorliegt, falls der Abstand der ersten Position des Läufers zum ausgezeichneten Punkt des Sensormusters größer als der erste vorbestimmte Grenzwert und kleiner als der zweite vorbestimmte Grenzwert ist.

Hierdurch wird der technische Vorteil erreicht, dass eine möglichst präzise Positionsbestimmung des Läufers ermöglicht ist. Durch Wahl des ausgezeichneten Punktes des Sensormusters durch ein geometrisches Zentrum des Sensormusters kann gewährleistet sein, dass bei entsprechender Auswahl der Größe des Sensormusters bei vollständiger Übereinstimmung der Positionierung des Sensormusters mit der zu bestimmenden Position des Läufers alle Magnetfeldsensoren des jeweiligen Sensormusters bei Positionierung des Läufers in der zu bestimmenden Position von dem Läufer abgedeckt werden. Hierdurch tragen alle Magnetfeldsensoren des ausgewählten Sensormusters zur Positionsbestimmung des Läufers bei, wodurch eine möglichst präzise Positionsbestimmung bei einer minimalen Anzahl verwendeter Magnetfeldsensoren erreicht wird.

Nach einer Ausführungsform ist der ausgezeichnete Punkt des Sensormusters durch ein geometrisches Zentrum des Sensormusters definiert.

Hierdurch wird der technische Vorteil erreicht, dass bei einer hohen Übereinstimmung zwischen einer Position des Läufers und einer Positionierung eines Sensormusters, die Fläche des Sensormusters vollständig vom Läufer bedeckt ist und somit alle Magnetfeldsensoren des Sensormusters zur Positionsbestimmung beitragen. Hierdurch kann die Messgenauigkeit und damit verbunden die Präzision der Positionsbestimmung erhöht werden.

Nach einer Ausführungsform umfasst das Verfahren ferner:

Verschieben des ersten Sensormusters und des zweiten Sensormusters entlang der ersten Orientierungsrichtung und Bestimmen eines verschobenen ersten Sensormusters und eines verschobenen zweiten Sensormusters in einem Verschiebungsschritt;

Messen von weiteren ersten Messwerten des Läufermagnetfelds durch die Magnetfeldsensoren des verschobenen ersten Sensormusters in einem fünften Läufermagnetfeldteilbestimmungsschritt;

Messen von weiteren zweiten Messwerten des Läufermagnetfelds durch die Magnetfeldsensoren des verschobenen zweiten Sensormusters in einem sechsten Läufermagnetfeldteilbestimmungsschritt;

Detektieren des Läufers und Bestimmen einer weiteren ersten Teilposition des Läufers auf Basis der von den Magnetfeldsensoren des verschobenen ersten Sensormusters gemessenen weiteren ersten Messwerte des Läufermagnetfels in einem fünften Läuferteildetektionsschritt;

Detektieren des Läufers und Bestimmen einer weiteren zweiten Teilposition Läufers auf Basis der von den Magnetfeldsensoren des verschobenen zweiten Sensormusters gemessenen Messwerte des Läufermagnetfelds in einem sechsten Läuferteildetektionsschritt;

Bestimmen eines weiteren ersten Gewichtungswerts des verschobenen ersten Sensormusters und eines weiteren zweiten Gewichtungswerts des verschobenen zweiten Sensormuster in einem weiteren Gewichtungsschritt; und

Bestimmen einer dritten Position des Läufers als einen gewichteten Mittelwert aus der weiteren ersten Teilposition und der weiteren zweiten Teilposition unter Berücksichtigung des weiteren ersten Gewichtungswerts und des weiteren zweiten Gewichtungswerts in einem weiteren Mittelwertbildungsschritt.

Hierdurch wird der technische Vorteil erreicht, dass bei fortschreitender Bewegung des Läufers auf dem Statormodul eine Positionsbestimmung entlang des vom Läufer zurückgelegten Steuerpfads kontinuierlich erfolgen kann, indem die ausgewählten Sensormuster der Bewegung des Läufers nachfolgen können.

Der Verschiebungsschritt kann beispielsweise durchgeführt werden, falls im Gewichtungsschritt der erste Gewichtungswert oder der zweite Gewichtungswert den Wert 1 und der jeweils andere Gewichtungswert den Wert 0 annehmen.

Da das Sensormuster mit Gewichtungswert 0 bei der Positionsbestimmung, bzw. im gewichteten Mittelwert der vier Sensormuster, nicht berücksichtigt wird, trägt dieses zur Positionsbestimmung des Läufers in der dritten Position nicht bei. Durch eine Verschiebung der vier Sensormuster kann somit erreicht werden, dass zur Positionsbestimmung des Läufers in der dritten Position alle vier Sensormuster einen Beitrag liefern, sodass eine möglichst präzise Positionsbestimmung durch Berücksichtigung der durch die Magnetfeldsensoren der vier Sensormuster aufgenommenen Messwerte des Läufermagnetfelds erreicht wird.

Durch die Berücksichtigung des Gewichtungswerts, der der Übereinstimmung zwischen der Position des Läufers und der Positionierung der vier Sensormuster entspricht, wird erreicht, dass bei fehlender Übereinstimmung zwischen der zuletzt bestimmten Position des Läufers und der Positionierung eines Sensormusters, die einem Gewichtungswert von 0 entspricht, eine Verschiebung der Sensormuster bewirkt wird, da davon auszugehen ist, dass die zu bestimmende dritte Position ebenfalls keine Übereinstimmung mit dem jeweiligen Sensormuster mit Gewichtungswert 0 aufweisen wird. Hierdurch kann auf Basis der zuletzt bestimmten Position des Läufers und der entsprechenden Übereinstimmung der zuletzt bestimmten Position des Läufers mit den Positionierungen der vier Sensormuster bewirkt werden, dass die vier Sensormuster zur Positionsbestimmung des Läufers der Bewegung des Läufers entlang dem Steuerpfad mitgeführt werden können, um so auf Basis der durch die Magnetfeldsensoren der vier Sensormuster aufgenommenen Messwerte des Läufermagnetfelds Positionsbestimmungen des Läufers zu ermöglichen. Eine Kenntnis der Bewegungsrichtung des Läufers auf dem Statormodul ist zur Auswahl der entsprechenden Sensormuster zur Bestimmung einer zukünftigen Position des Läufers nicht notwendig.

Durch die vier in jeweils zwei senkrecht orientierten Richtungen angeordnete Sensormuster, die durch entsprechende Verschiebungen der Bewegung des Läufers angepasst mitgeführt werden können, kann erreicht werden, dass auch bei Änderung der Bewegungsrichtung des Läufers zwischen der zweiten Position und der zukünftigen dritten Position eine Neubestimmung der vier Sensormuster zur Positionsbestimmung des Läufers in der dritten Position nicht notwendig ist. Die vier Sensormuster können hierbei derart ausgestaltet sein, dass verhindert wird, dass selbst bei einer Änderung der Bewegungsrichtung der Läufer zwischen der ersten Position bzw. der zweiten Position und der dritten Position aus dem durch die vier Sensormuster aufgespannten Raumbereich herausbewegt wird.

Nach einer Ausführungsform umfasst das Verfahren ferner:

Verschieben des dritten Sensormusters und des vierten Sensormusters entlang der ersten Orientierungsrichtung und Bestimmen eines verschobenen dritten Sensormusters und eines verschobenen vierten Sensormusters im Verschiebungsschritt;
Messen von weiteren dritten Messwerten des Läufermagnetfelds durch die Magnetfeldsensoren des verschobenen dritten Sensormusters in einem siebten Läufermagnetfeldteilbestimmungsschritt;
Messen von weiteren vierten Messwerten des Läufermagnetfelds durch die Magnetfeldsensoren des verschobenen vierten Sensormusters in einem achten Läufermagnetfeldteilbestimmungsschritt;
Detektieren des Läufers und Bestimmen einer weiteren dritten Teilposition des Läufers auf Basis der von den Magnetfeldsensoren des verschobenen dritten Sensormusters gemessenen weiteren dritten Messwerte des Läufermagnetfelds in einem siebten Läuferteildetektionsschritt;
Detektieren des Läufers und Bestimmen einer weiteren vierten Teilposition des Läufers auf Basis der von den Magnetfeldsensoren des verschobenen vierten Sensormusters gemessenen Messwerte des Läufermagnetfelds in einem achten Läuferteildetektionsschritt; Bestimmen eines weiteren dritten Gewichtungswerts des verschobenen dritten Sensormusters und eines weiteren vierten Gewichtungswerts des verschobenen vierten Sensormuster im weiteren Gewichtungsschritt; und
Bestimmen der dritten Position des Läufers als einen gewichteten Mittelwert aus der weiteren ersten Teilposition, der weiteren zweiten Teilposition, der weiteren dritten Teilposition und der weiteren vierten Teilposition unter Berücksichtigung des weiteren ersten Gewichtungswerts, des weiteren zweiten Gewichtungswerts, des weiteren dritten Gewichtungswerts und des weiteren vierten Gewichtungswerts im weiteren Mittelwertbildungsschritt.

Hierdurch wird der technische Vorteil erreicht, dass ein Mitführen der vier Sensormuster entlang der Bewegung des Läufers auf dem Statormodul erreicht wird. Hierdurch kann auf Basis der zuletzt bestimmten Position und der entsprechend ermittelten Gewichtungswerte der einzelnen Sensormuster eine durchgehende Positionsbestimmung des Läufers entlang des Steuerpfads erreicht werden, ohne dass hierzu eine Bewegungsrichtung des Läufers berücksichtigt werden muss. Hierdurch kann eine möglichst einfache Positionsbestimmung des Läufers und eine entsprechende Auswahl der zur Positionsbestimmung relevanten Magnetfeldsensoren erreicht werden, bei der ein Minimum von Information bezüglich der Bewegung des Läufers auf dem Statormodul benötigt wird.

Nach einer Ausführungsform umfasst der Verschiebungsschritt:

Bestimmen eines weiteren ersten zentralen Magnetfeldsensors und Bestimmen eines weiteren zweiten zentralen Magnetfeldsensors und/oder Bestimmen eines weiteren dritten zentralen Magnetfeldsensors und Bestimmen eines weiteren vierten zentralen Magnetfeldsensors in einem weiteren Magnetfeldsensorbestimmungsschritt, wobei der weitere erste zentrale Magnetfeldsensor und der weitere zweite zentrale Magnetfeldsensor und/oder der weitere dritte zentrale Magnetfeldsensor und der weitere vierte zentrale Magnetfeldsensor zur zweiten Position direkt benachbart sind und kürzeste Abstände zur zweiten Position aufweisen;

Ermitteln einer vorbestimmten Mehrzahl von weiteren ersten Magnetfeldsensoren, die den weiteren ersten zentralen Magnetfeldsensor umgeben und Identifizieren der Mehrzahl von weiteren ersten Magnetfeldsensoren als verschobenes erstes Sensormuster in einem weiteren ersten Identifikationsschritt, wobei der weitere erste zentrale Magnetfeldsensor in einem weiteren ersten geometrischen Zentrum des verschobenen ersten Sensormusters angeordnet ist;

Ermitteln einer vorbestimmten Mehrzahl von weiteren zweiten Magnetfeldsensoren, die den weiteren zweiten zentralen Magnetfeldsensor umgeben, und Identifizieren der Mehrzahl von weiteren zweiten Magnetfeldsensoren als zweites verschobenes Sensormuster in einem weiteren zweiten Identifikationsschritt, wobei der weitere zweite zentrale Magnetfeldsensor in einem weiteren zweiten geometrischen Zentrum des verschobenen zweiten Sensormusters angeordnet ist; und/oder

Ermitteln einer vorbestimmten Mehrzahl von weiteren dritten zentralen Magnetfeldsensoren, die den weiteren dritten Magnetfeldsensor umgeben, und Identifizieren der Mehrzahl von weiteren dritten Magnetfeldsensoren als verschobenes drittes Sensormuster in einem weiteren dritten Identifikationsschritt, wobei der weitere dritte zentrale Magnetfeldsensor in einem weiteren dritten geometrischen Zentrum des verschobenen dritten Sensormusters angeordnet ist; und Ermitteln einer vorbestimmten Mehrzahl von weiteren vierten Magnetfeldsensoren, die den weiteren vierten zentralen Magnetfeldsensor umgeben, und Identifizieren der Mehrzahl von weiteren vierten Magnetfeldsensoren als verschobenes viertes Sensormuster in einem weiteren vierten Identifikationsschritt, wobei der weitere vierte zentrale Magnetfeldsensor in einem weiteren vierten geometrischen Zentrum des verschobenen vierten Sensormusters angeordnet ist.

Hierdurch wird der technische Vorteil erreicht, dass eine präzise Bestimmung der Sensormuster bereitgestellt werden kann. Insbesondere wird erreicht, dass die Magnetfeldsensoren als Sensormuster ausgewählt werden, die benachbart zur zuvor bestimmten zweiten Position des Läufers auf dem Statormodul angeordnet sind. Durch die Auswahl der zur zweiten Position benachbarten Magnetfeldsensoren als die Sensormuster zur Bestimmung der dritten Position, kann die dritte Position auf Basis der Messwerte des Läufermagnetfelds der Magnetfeldsensoren bestimmt werden, die bereits zur Positionsbestimmung der zweiten Position beigetragen haben. Hierdurch ist eine einfache Auswahl von Magnetfeldsensoren erreicht. Insbesondere für den Fall, dass die zweiten und dritten Positionen nur geringfügig voneinander abweichen, kann über die zur zweiten Position benachbarten Magnetfeldsensoren eine präzise Positionsbestimmung der dritten Position erreicht werden, da aufgrund der Ausbildung der Sensormuster und der von den Sensormustern abgedeckten Fläche, die dritte Position innerhalb wenigstens eines der Sensormuster positioniert sein wird.

Nach einer Ausführungsform entspricht der weitere erste Gewichtungswert einem Übereinstimmungswert zwischen der zweiten Position des Läufers und einer Positionierung des ersten Sensormusters, wobei der weitere zweite Gewichtungswert einem Übereinstimmungswert zwischen der zweiten Position des Läufers und einer Positionierung des zweiten Sensormusters entspricht, wobei der weitere dritte Gewichtungswert einem Übereinstimmungswert zwischen der zweiten Position des Läufers und einer Positionierung des dritten Sensormusters entspricht, und wobei der weitere vierte Gewichtungswert einem Übereinstimmungswert zwischen der zweiten Position des Läufers und einer Positionierung des vierten Sensormusters entspricht.

Hierdurch wird der technische Vorteil erreicht, dass bei fehlender Übereinstimmung der zweiten Position mit der Positionierung eines der vier Sensormuster die vier Sensormuster entlang einer vorbestimmten Richtung verschoben werden. Hierdurch wird erreicht, dass bei fortlaufender Bewegung ein Mitbewegen der vier Sensormuster entlang des Steuerpfads ermöglicht wird, ohne dass eine Berücksichtigung der Bewegungsrichtung des Läufers notwendig ist. Hierdurch kann eine möglichst einfache Bestimmung der zur Positionsbestimmung benötigten Magnetfeldsensoren erreicht werden.

Nach einer Ausführungsform umfasst das Verfahren ferner:

Bestimmen der ersten Position des Läufers auf dem Statormodul in einem Läuferpositionsbestimmungsschritt; wobei der Läuferpositionsbestimmungsschritt umfasst:

Aufnehmen von Messwerten von Magnetfeldsensoren des Sensormoduls in einem Messwertbesti mmungsschritt;

Identifizieren eines ersten Magnetfeldsensors des Sensormoduls, dessen Messwert einen vorbestimmten Grenzwert erreicht oder überschreitet, in einem Magnetfeldsensoridentifikationsschritt;

Aufnehmen von Messwerten von Magnetfeldsensoren des Sensormoduls in direkter Nachbarschaft zum ersten Magnetfeldsensor in einem weiteren Messwertbestimmungsschritt;

Identifizieren der Magnetfeldsensoren in direkter Nachbarschaft zum ersten Magnetfeldsensor, deren Messwerte den vorbestimmten Grenzwert erreichen oder überschreiten, in einem weiteren Magnetfeldsensoridentifikationsschritt;

Bestimmen eines Detektionssensormusters in einem Detektionsmusterbestimmungsschritt, wobei ein Detektionssensormuster identifizierte Magnetfeldsensoren umfasst; Detektieren des Läufers auf Basis der Messwerte der Magnetfeldsensoren des Detektionssensormusters in einem Läuferdetektionsschritt; und

Identifizieren der ersten Position des Läufers auf Basis der Lage der identifizierten Magnetfeldsensoren Statormodul in einem Positionsidentifikationsschritt.

Hierdurch wird der technische Vorteil erreicht, dass eine einfache Detektion eines Läufers auf dem Statormodul insbesondere beim Starten beziehungsweise bei der Inbetriebnahme des Planarantriebssystems und/oder bei fehlender Kenntnis einer Positionierung des Läufers erreicht werden kann. Hierzu werden die Magnetfeldsensoren des Sensormoduls des Statormoduls einzeln abgescannt, sodass beispielsweise der Reihe nach Messwerte der einzelnen Magnetfeldsensoren aufgenommen werden, bis ein Magnetfeldsensor identifiziert wird, dessen Messwert oberhalb eines vorbestimmten Grenzwerts liegt.

Hierauf folgend werden die zu dem identifizierten Magnetfeldsensor benachbarten Magnetfeldsensoren gescannt. Hierüber wird ein Detektionssensormuster bestimmt, das aus den zum identifizierten Magnetfeldsensor benachbarten Magnetfeldsensoren besteht, die jeweils Messwerte oberhalb des vorbestimmten Grenzwerts anzeigen. Ein Messwert, der den vorbestimmten Grenzwert überschreitet, wird als Detektion des Läufermagnetfelds des zu detektierenden Läufers interpretiert. Über eine Bestimmung der Positionierung des Detektionsmusters kann somit eine Position des Läufers bestimmt werden. Insbesondere beim Starten des Planarantriebssystems, bei dem eine exakte Position des Läufers unbekannt ist, kann somit eine einfache Detektion eines auf dem Statormodul positionierten Läufers und eine damit verbundene Bestimmung der jeweiligen Position des Läufers erreicht werden.

Nach einer Ausführungsform umfasst der Sensormusterbestimmungsschritt:

Ermitteln einer Geschwindigkeit des Läufers in einer Bewegung des Läufers entlang dem Steuerpfad in einem Geschwindigkeitsermittlungsschritt; und

Bestimmen des Sensormusters auf Basis der ermittelten Geschwindigkeit des Läufers entlang des Steuerpfads.

Hierdurch wird der technische Vorteil erreicht, dass eine einfache Ermittlung der zur Positionsbestimmung der zweiten Position benötigten Magnetfeldsensoren bereitgestellt wird. Hierzu wird eine Geschwindigkeit des Läufers in einer Bewegung entlang des Steuerpfads ermittelt. Die Geschwindigkeit umfasst hierbei einen Geschwindigkeitswert und eine Geschwindigkeitsrichtung. Auf Basis der ermittelten Geschwindigkeit ist dann eine Vorhersage möglich, in welcher Position der Läufer sich zu einem bestimmten Zeitpunkt befinden wird. Das entsprechende Sensormuster kann demnach auf der vorhergesagten Position basierend bestimmt werden, sodass eine Positionsbestimmung durch Aufnahme entsprechender Messwerte des Läufermagnetfelds durch die Magnetfeldsensoren des bestimmten Sensormusters ermöglicht ist.

Nach einer Ausführungsform werden die Bestimmung der ersten Position des Läufers auf dem Statormodul, die Bestimmung der zweiten Position des Läufers auf dem Statormodul und die Bestimmung der dritten Position des Läufers auf dem Statormodul, sowie die Bestimmung der ersten Teilposition, der zweiten Teilposition, der dritten Teilposition, der vierten Teilposition, der weiteren ersten Teilposition, der weiteren zweiten Teilposition, der weiteren dritten Teilposition und der weiteren vierten Teilposition durch ein trainiertes neuronales Netz ausgeführt, und wobei das trainierte neuronale Netz eingerichtet ist, auf Basis der Messwerte des Läufermagnetfelds der Magnetfeldsensoren des Sensormoduls unter Berücksichtigung der Positionierungen der Magnetfeldsensoren des Sensormoduls in dem Statormodul eine Position des Läufers auf dem Statormodul zu bestimmen.

Hierdurch wird der technische Vorteil erreicht, dass eine möglichst präzise und verlässliche Positionsbestimmung bereitgestellt werden kann. Durch die Verwendung eines neuronalen Netzes für die Bestimmung der in den verschiedenen Verfahrensschritten bestimmten Positionen und Teilpositionen des Läufers ist darüber hinaus eine echtzeitfähige Positionsbestimmung ermöglicht, in der mittels des entsprechend trainierten neuronalen Netzes innerhalb eines vorbestimmten Zeitraums eine Bestimmung der Position des Läufers gewährleistet werden kann. Hierzu werden die durch die Magnetfeldsensoren der einzelnen Sensormuster aufgenommenen Messwerte als Eingabewerte des trainierten neuronalen Netzes verwendet. Das neuronale Netz ist hierbei eingerichtet, auf Basis der Positionierungen der einzelnen Magnetfeldsensoren innerhalb des Sensormoduls am Statormodul und auf Basis der einzelnen Messwerte der Magnetfeldsensoren eine Position des Läufers auf dem Statormodul zu bestimmen. Hierzu kann das neuronale Netz auf eine dreidimensionale Ausgestaltung des Läufermagnetfelds des Läufers trainiert sein, sodass über das entsprechend trainierte neuronale Netz Messwerte des Läufermagnetfelds durch einzelne Magnetfeldsensoren individuellen Bereichen der dreidimensionalen Ausgestaltung des Läufermagnetfelds zugeordnet werden können. Über die Zuordnung der einzelnen Messwerte der verschiedenen Magnetfeldsensoren des Sensormusters zu den verschiedenen räumlichen Bereichen des Läufermagnetfelds ist eine exakte Positionsbestimmung des Läufers relativ zu den Magnetfeldsensoren des Sensormusters ermöglicht. Über die Positionierung der einzelnen Magnetfeldsensoren des Sensormusters im Statormodul ist dann eine Positionsbestimmung des Läufers auf dem Statormodul ermöglicht.

Nach einer Ausführungsform sind die Magnetfeldsensoren des Sensormoduls 1D-Hallsensoren, 2D-Hallsensoren oder 3D-Hallsensoren, wobei ein Messwert eines Magnetfeldsensors eine, zwei oder drei Komponenten des Läufermagnetfelds umfasst.

Hierdurch wird der technische Vorteil erreicht, dass eine präzise Bestimmung des Läufermagnetfelds durch Aufnehmen von Messwerten der Magnetfeldsensoren des Sensormoduls zur Positionsbestimmung des Läufers auf dem Statormodul ermöglicht ist. Durch die Verwendung von 1D-Hallsensoren, 2D-Hallsensoren bzw. 3D-Hallsensoren sind detaillierte Messungen des Läufermagnetfelds ermöglicht. Hierdurch ist eine verbesserte Positionsbestimmung erreichbar, indem insbesondere in Verbindung mit dem neuronalen Netz jedem Messwert der einzelnen Magnetfeldsensoren, über die verschiedenen Komponenten des Läufermagnetfelds, die in jedem Messwert des Magnetfeldsensors aufgenommen werden, eine präzise Zuordnung zwischen jedem aufgenommenen Messwert und einem bestimmten Raumbereich des Läufermagnetfelds ermöglicht ist. Hierdurch kann eine präzise Zuordnung zwischen einer Position des Läufers relativ zu den Magnetfeldsensoren des jeweiligen Sensormusters und damit verbunden relativ zum Statormodul erreicht werden.

Nach einer Ausführungsform sind die erste Position, die zweite Position und die dritte Position identisch, wobei das Steuern des Läufers entlang des Steuerpfads ein Halten des Läufers in der ersten Position umfasst.

Hierdurch wird der technische Vorteil erreicht, dass eine umfassende Steuerung des Läufers auf dem Statormodul ermöglicht wird. Diese Steuerung umfasst neben der Bewegung des Läufers entlang des Steuerpfades eine konstante Positionierung des Läufers in der ersten Position auf dem Statormodul. Über die exakte Positionsbestimmung kann somit eine exakte dauerhafte Positionierung des Läufers in einer Position auf dem Statormodul erreicht werden. Dies ist insbesondere bei jedem Startpunkt bzw. Endpunkt eines Transportweges, an denen eine Be- oder Entladung des Läufers mit einem zu transportierenden Gut vorgenommen wird, von Interesse.

Nach einer Ausführungsform entspricht die erste Position einer Position des Läufers, die der Läufer zu einem ersten Positionsbestimmungszeitpunkt auf dem Statormodul einnimmt, wobei die zweite Position einer Position des Läufers entspricht, die der Läufer zu einem zweiten Positionsbestimmungszeitpunkt auf dem Statormodul einnimmt, wobei die dritte Position einer Position des Läufers entspricht, die der Läufer zu einem dritten Positionsbestimmungszeitpunkt auf dem Statormodul einnimmt, und wobei die Bestimmung der ersten Position zum ersten Positionsbestimmungszeitpunkt und/oder die Bestimmung der zweiten Position zum zweiten Positionsbestimmungszeitpunkt und/oder die Bestimmung der dritten Position zum dritten Positionsbestimmungszeitpunkt in aufeinanderfolgenden Steuerzyklen der Steuereinheit des Planarantriebssystems durchgeführt wird.

Hierdurch wird der technische Vorteil erreicht, dass Positionsbestimmungen während verschiedenen Steuerzyklen des zyklisch gesteuerten Planarantriebssystems durchgeführt werden können. Insbesondere kann für jeden Steuerzyklus eine Position des Läufers bestimmt werden.

Nach einem zweiten Aspekt der Erfindung wird ein Planarantriebssystem mit wenigstens einer Steuereinheit, einem Statormodul und einem Läufer bereitgestellt, wobei der Läufer über eine magnetische Kopplung zwischen einem Läufermagnetfeld des Läufers und einem Statormagnetfeld des Statormoduls steuerbar ist, wobei das Statormodul zum Bestimmen einer Position des Läufers ein Sensormodul mit einer Mehrzahl von Magnetfeldsensoren umfasst, und wobei jeder Magnetfeldsensor eingerichtet ist, für einen Raumbereich das Läufermagnetfeld zu bestimmen, und wobei die Steuereinheit eingerichtet ist, ein erfindungsgemäßes Verfahren auszuführen.

Hierdurch kann ein Planarantriebssystem bereitgestellt werden, das über eine präzise und verbesserte Steuerung verfügt und eingerichtet ist, das erfindungsgemäße Verfahren mit den genannten Vorteilen auszuführen.

Die Erfindung wird anhand der beigefügten Figuren näher erläutert. Hierbei zeigen:

Fig. 1        eine schematische Darstellung eines Planarantriebssystems mit einem Statormodul und einem Läufer gemäß einer Ausführungsform;

Fig. 2        eine schematische perspektivische Ansicht eines Sensormoduls des Statormoduls gemäß einer Ausführungsform;

Fig. 3        eine schematische Darstellung einer Unterseite eines Läufers gemäß einer weiteren Ausführungsform;

Fig. 4        ein Flussdiagramm eines Verfahrens zum Steuern eines Planarantriebssystems gemäß einer Ausführungsform;

Fig. 5        eine schematische Darstellung eines Läufers auf einem Statormodul gemäß einer weiteren Ausführungsform;

Fig. 6      ein weiteres Flussdiagramm des Verfahrens zum Steuern eines Planarantriebssystems gemäß einer weiteren Ausführungsform;

Fig. 7      ein weiteres Flussdiagramm des Verfahrens zum Steuern eines Planarantriebssystems gemäß einer weiteren Ausführungsform;

Fig. 8      eine schematische Darstellung eines Statormoduls mit für eine Positionsbestimmung eines Läufers ausgewählten Magnetfeldsensoren gemäß einer weiteren Ausführungsform;

Fig. 9      eine schematische Darstellung eines Statormoduls mit für eine Positionsbestimmung eines Läufers ausgewählten Magnetfeldsensoren gemäß einer weiteren Ausführungsform;

Fig. 10      ein weiteres Flussdiagramm des Verfahrens zum Steuern eines Planarantriebssystems gemäß einer weiteren Ausführungsform;

Fig. 11      ein weiteres Flussdiagramm des Verfahrens zum Steuern eines Planarantriebssystems gemäß einer weiteren Ausführungsform;

Fig. 12      eine schematische Darstellung eines Statormoduls mit für eine Positionsbestimmung eines Läufers ausgewählten Magnetfeldsensoren gemäß einer weiteren Ausführungsform; und

Fig. 13      eine weitere schematische Darstellung eines Statormoduls mit für eine Positionsbestimmung eines Läufers ausgewählten Magnetfeldsensoren gemäß einer weiteren Ausführungsform.

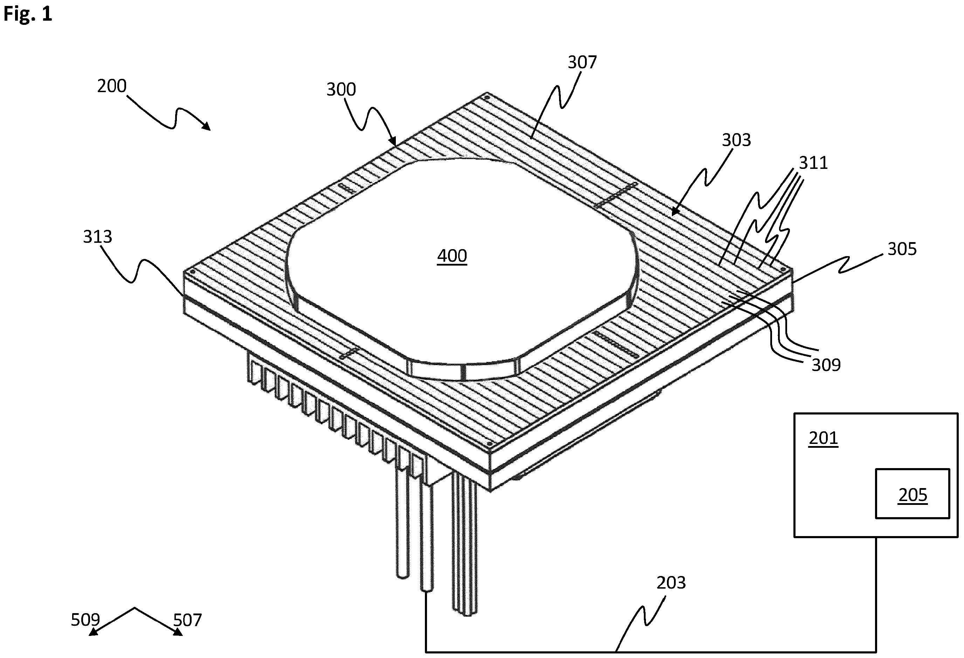

Fig. 1 zeigt eine schematische Ansicht eines Planarantriebssystems 200 mit einem Statormodul 300 und einem Läufer 400.

Gemäß der Ausführungsform in Fig.1 umfasst das Planarantriebssystem eine Steuereinheit 201, ein Statormodul 300 und einen Läufer 400. Die Steuereinheit 201 ist über eine Datenverbindung 203 mit dem Statormodul 300 verbunden. Die Steuereinheit 201 umfasst ein neuronales Netz 205 und ist eingerichtet, ein erfindungsgemäßes Verfahren zum Steuern eines Planarantriebssystems 200 auszuführen.

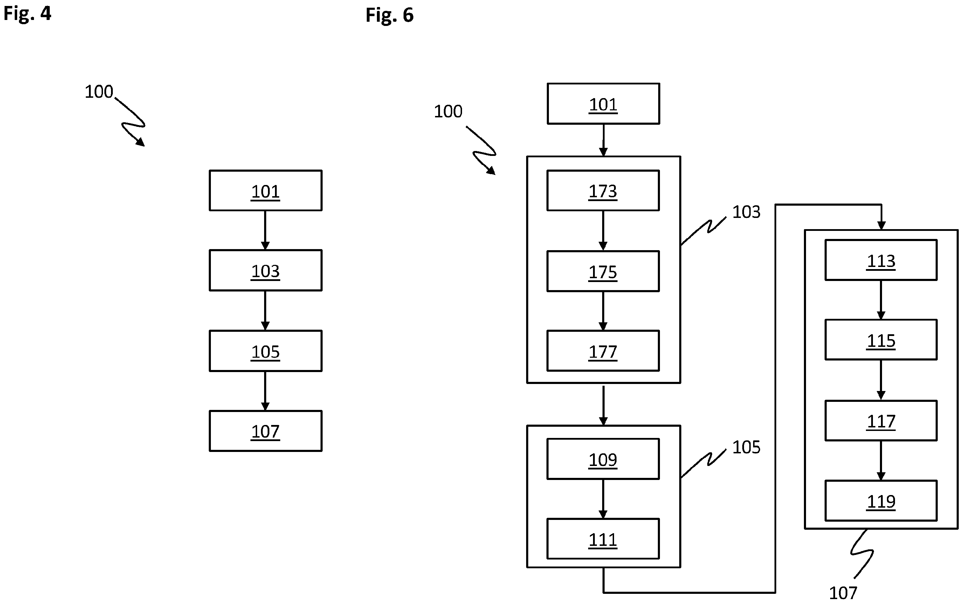

Für eine detaillierte Beschreibung des erfindungsgemäßen Verfahrens zum Steuern eines Planarantriebssystems 200 und der Funktionsweise des neuronalen Netzes 205 wird auf die Beschreibung zu den Fig. 4, Fig. 5, Fig. 7 und Fig. 8 verwiesen.

Das Statormodul 300 hat eine ebene Statoroberfläche 303. Die ebene Statoroberfläche 303 ist an einer Oberseite eines Statormodulgehäuses 305 angeordnet. Oberhalb der Statoroberfläche 303 ist ein Läufer 400 angeordnet. Die Statoroberfläche 303 ist Teil einer Statoreinheit 307 für einen elektrischen Antrieb des Läufers 400. Die Statoreinheit 307 mit der Statoroberfläche 303 kann als Leiterplatte ausgeführt sein. Die Statoroberfläche 303 ist quadratisch ausgebildet.

Der Läufer 400 ist oberhalb der Statoroberfläche 303 zumindest in eine erste Richtung 507 und in eine zweite Richtung 509 antreibbar. Darüber hinaus ist der Läufer 400 auch in einer zu der ersten Richtung 507 und der zweiten Richtung 509 senkrecht angeordneten dritten Richtung antreibbar. Die Statoroberfläche 303 weist mehrere Statorleiter 309 auf, die in der Ausführungsform in Fig. 1 als Statorleiter 309 ausgebildet sind, und die im Wesentlichen entlang der ersten Richtung 507 ausgerichtet sind. Die Statorleiter 309 sind stromleitend ausgebildet und können so bestromt werden, dass der Läufer 400 angetrieben wird. Zwischen den Statorleitern 309 ist ein Statorleiterzwischenraum 311 vorgesehen, durch den die Statorleiter 309 voneinander elektrisch isoliert sind. Die Statoroberfläche 303 ist ebenfalls elektrisch isoliert gegenüber den Statorleitern 309. Unterhalb der Statoroberfläche 303 kann eine weitere Anordnung von Statorleitern vorgesehen sein, in der die Statorleiter im Wesentlichen entlang der zweiten Richtung 509 ausgerichtet sind.

In dem Statormodulgehäuse 305 sind Elektronikmodule (nicht dargestellt) für den Antrieb und für die Steuerung des Läufers 400 angeordnet. Die Elektronikmodule können beispielsweise Leistungsmodule zur Erzeugung der Antriebsströme und Steuermodule zur Steuerung der Leistungsmodule und der Antriebsströme umfassen. Auf einer der Statoroberfläche 303 gegenüberliegenden Unterseite des Statormodulgehäuses 305 sind nicht dargestellte Anschlüsse angeordnet zur Verbindung des Statormoduls 300 mit mehreren Anschlussleitungen. Die Anschlussleitungen können beispielsweise eine Steuerleitung zur Übertragung von Steuersignalen für die Steuermodule und eine Energieversorgungsleitung zur Versorgung der Leistungs- und/oder Steuermodule mit elektrischer Energie umfassen. Insbesondere kann dem Leistungsmodul über die Energieversorgungsleitung elektrische Energie zur Erzeugung der Antriebsströme zugeführt werden.

Das Statormodulgehäuse 305, die Statoreinheit 307 und die Statoroberfläche 303 sind in der Draufsicht auf die Statoroberfläche 303 rechteckig, insbesondere quadratisch, ausgebildet.

Das Statormodulgehäuse 305 weist eine Schnittebene 313 auf. Auf Höhe der Schnittebene 313 kann innerhalb des Statormodulgehäuses 305 ein Sensormodul angeordnet sein.

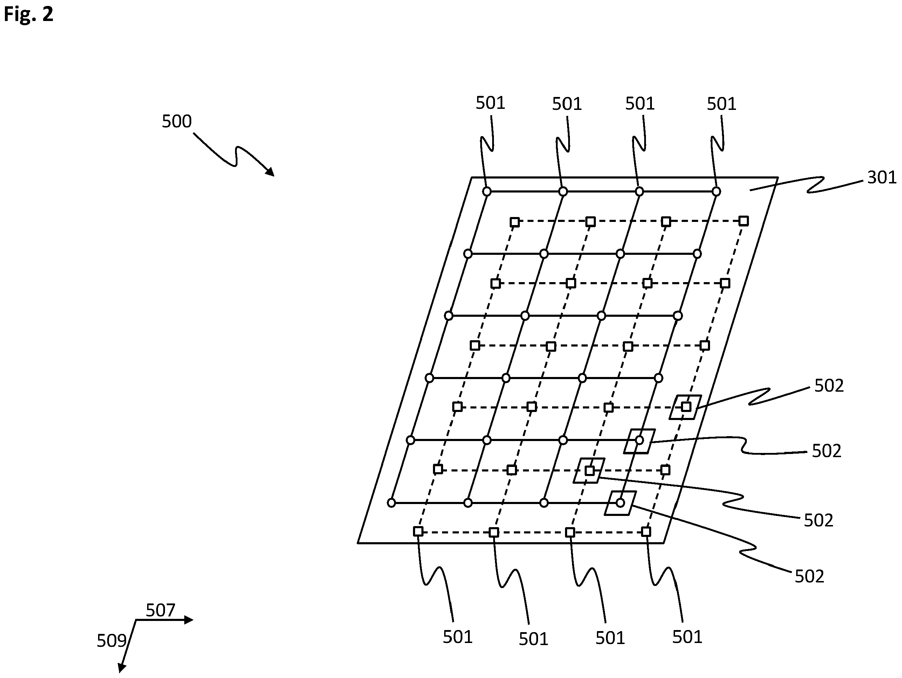

Fig. 2 zeigt eine perspektivische Ansicht eines Sensormoduls 500 zur Erfassung einer Position des Läufers 400 im Planarantriebssystem 200.

Das Sensormodul 500 ist rechteckig und weist eine zweidimensionale Anordnung von Magnetfeldsensoren 501 auf einem Träger 301 des Statormoduls 300 auf. Die Magnetfeldsensoren 501 sind also auf dem Träger 301 angeordnet. Die zweidimensionale Anordnung der Magnetfeldsensoren 501 weist ein erstes periodisches Gitter von Magnetfeldsensoren 501 und ein zweites periodisches Gitter von Magnetfeldsensoren 501 auf. Die Magnetfeldsensoren 501 des ersten Gitters sind durch runde Symbole angedeutet, während die Magnetfeldsensoren 501 des zweiten Gitters durch viereckige Symbole angedeutet sind. Alternativ kann das Sensormodul 500 beziehungsweise die Anordnung der Magnetfeldsensoren 501 quadratisch, parallelogrammförmig oder beliebig vorteilhaft geformt sein.

Die in Fig. 2 dargestellte Anordnung der Magnetfeldsensoren 501 dient ausschließlich zur Illustration und kann von der in Fig. 2 dargestellten Anordnung abweichen.

Die Magnetfeldsensoren 501 sind jeweils eingerichtet, Magnetfelder für einen Raumbereich 502 zu bestimmen. Messungen eines Magnetfeldsensors 501 sind somit auf den jeweiligen Raumbereich 502 des jeweiligen Magnetfeldsensors 501 beschränkt. In der Ausführungsform in Fig. 2 sind die Raumbereiche 502 als rechteckige beziehungsweise quadratische Flächen dargestellt. Dies ist lediglich darstellerischen Gründen geschuldet. Die Raumbereiche 502 der Magnetfeldsensoren 501 können auch geometrisch anders gestaltete räumliche Ausdehnungen aufweisen und beispielsweise kreisförmig ausgestaltet sein. Insbesondere können die Raumbereiche 502 punktförmig ausgestaltet sein, sodass durch die Magnetfeldsensoren 501 Punktmessungen der jeweiligen Magnetfelder durchgeführt werden können, bei denen einzelne Magnetfeldsensoren 501 ausschließlich Feldbeiträge der jeweiligen Magnetfelder messen, die unmittelbar an den Positionen der jeweiligen Magnetfeldsensoren 501 angeordnet sind.

Der Träger 301 ist eben, so dass die Magnetfeldsensoren 501 in einer Ebene, also in einer zweidimensionalen Anordnung, angeordnet sind.

Die Magnetfeldsensoren 501 können als Hall-Sensoren ausgebildet sein. Insbesondere können die Magnetfeldsensoren 501 als 1D-, 2D- oder 3D-Hall-Sensoren ausgebildet sein, wobei 3D-Hall-Sensoren die Magnetfeldkomponenten in drei linear unabhängigen Raumrichtungen messen. Diese Raumrichtungen können insbesondere die erste Richtung 507 und die zweite Richtung 509 sowie eine dritte Richtung senkrecht zur ersten Richtung 507 und zur zweiten Richtung 509 umfassen.

Der Träger 301 kann als eine Leiterplatte und/oder eine Platine ausgebildet sein. Dadurch kann der Träger 301 auf einfachem Weg bereitgestellt werden.

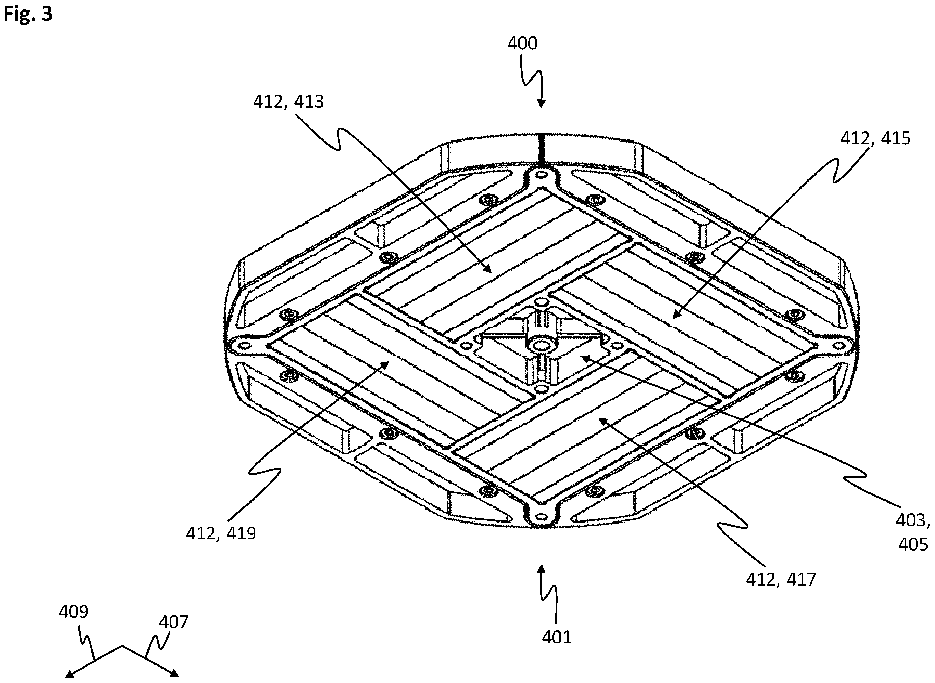

Fig. 3 zeigt den Läufer 400 des Planarantriebssystems 200 in einer Ansicht von unten auf eine Unterseite des Läufers 400. Im Betrieb des Planarantriebssystems 200 ist die Unterseite des Läufers 400 der Statoroberfläche 303 des Statormoduls 300 zugewandt angeordnet. Der Läufer 400 weist an der Unterseite eine Magnetanordnung 401 auf. Die Magnetanordnung 401 ist rechteckig, insbesondere quadratisch, ausgebildet und umfasst mehrere Magneten. Die Unterseite des Läufers 400 ist, insbesondere im Bereich der Magneten der Magnetanordnung 401, eben bzw. planar ausgebildet. Im Betrieb ist die Unterseite des Läufers 400 mit der Magnetanordnung 401 im Wesentlichen parallel zu der Statoroberfläche 303 orientiert und der Statoroberfläche 303 zugewandt angeordnet.

Die Magnetanordnung 401 umfasst eine erste Magneteinheit 413, eine zweite Magneteinheit 415, eine dritte Magneteinheit 417 und eine vierte Magneteinheit 419, die im allgemeinen als Magneteinheit 412 bezeichnet werden. Die erste Magneteinheit 413 und die dritte Magneteinheit 417 weisen jeweils in einer ersten Läuferrichtung 407 nebeneinander angeordnete und entlang einer zu der ersten Läuferrichtung 407 senkrecht orientierten zweiten Läuferrichtung 409 ausgedehnte längliche Antriebsmagnete auf. Die zweite Magneteinheit 415 und die vierte Magneteinheit 419 weisen jeweils in der zweiten Läuferrichtung 409 nebeneinander angeordnete und entlang der ersten Läuferrichtung 407 ausgedehnte längliche Antriebsmagnete auf. Die erste und dritte Magneteinheit 413, 417 dient im Betrieb einem Antrieb des Läufers 400 in der ersten Läuferrichtung 407, und die zweite und vierte Magneteinheit 415, 419 dient im Betrieb einem Antrieb des Läufers 400 in der zweiten Läuferrichtung 409. Darüber hinaus dienen die erste Magneteinheit 413, die zweite Magneteinheit 415, die dritte Magneteinheit 417 und die vierte Magneteinheit 419 einem Antrieb des Läufers 400 in einer zur ersten Läuferrichtung 407 und der zweiten Läuferrichtung 409 senkrecht angeordneten dritten Läuferrichtung.

In der Mitte der Magnetanordnung 401 weist der Läufer 400 eine Freifläche 403 auf, die nicht von Magneten der Magnetanordnung 401 bedeckt wird. Im Bereich der Freifläche 403 weist der Läufer 400 eine Befestigungsstruktur 405 auf. In der Freifläche 403 können auch weitere Komponenten, wie beispielsweise eine Leiterkarte angeordnet sein.

Fig. 4 zeigt ein Flussdiagramm eines Verfahrens 100 zum Steuern eines Planarantriebssystems 200 gemäß einer Ausführungsform.

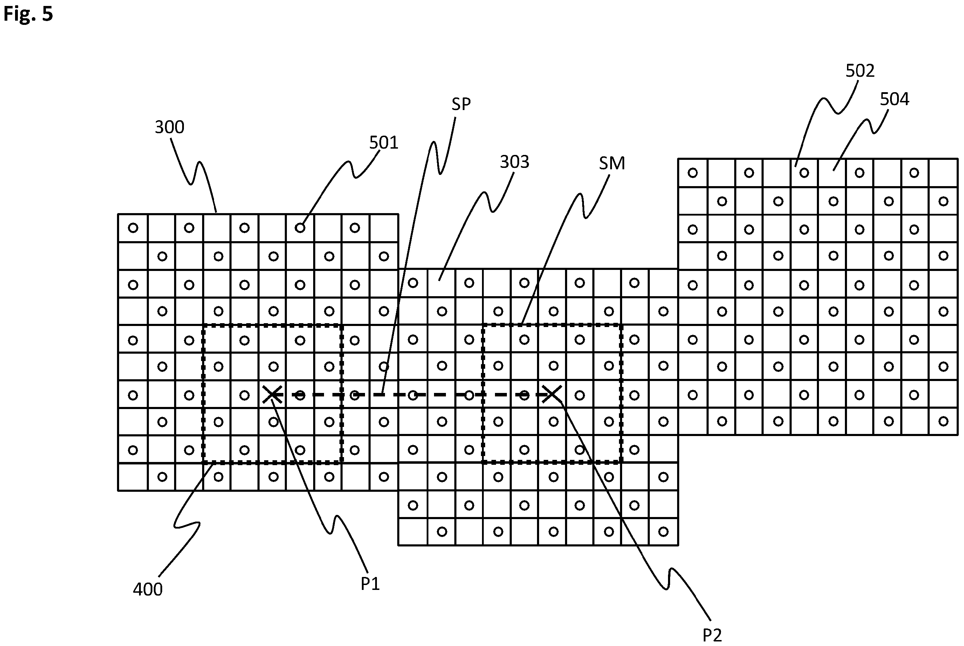

Die Ausführungsform des Verfahrens 100 in Fig. 4 wird mit Verweis auf die Fig. 5 beschrieben. Die in Fig. 4 gezeigte Ausführungsform ist nicht Teil des Schutzbereichs des Patentanspruchs 1.

Das Verfahren 100 zum Steuern eines Planarantriebssystems 200 ist auf ein Planarantriebssystem 200 gemäß der in Fig. 1 gezeigten Ausführungsform anwendbar. Das Planarantriebssystem 200 umfasst hierbei wenigstens eine Steuereinheit 201, ein Statormodul 300 und einen Läufer 400, wobei der Läufer 400 über eine magnetische Kopplung zwischen einem Läufermagnetfeld des Läufers 400 und einem Statormagnetfeld des Statormoduls 300 steuerbar ist, wobei das Statormodul 300 zum Bestimmen einer Position des Läufers 400 ein Sensormodul 500 mit einer Mehrzahl von Magnetfeldsensoren 501 umfasst, und wobei jeder Magnetfeldsensor 501 eingerichtet ist, für einen Raumbereich das Läufermagnetfeld zu bestimmen.

Gemäß der Ausführungsform in Fig. 4 umfasst das Verfahren 100 zunächst das Steuern des Läufers 400 entlang eines Steuerpfads SP ausgehend von einer ersten Position auf dem Statormodul in einem Steuerschritt 101.

Der Steuerpfad SP kann hierbei ein beliebiger Pfad von der ersten Position P1 über die Statoroberfläche 303 des Statormoduls 300 sein. Die erste Position P1 kann eine Startposition eines Transportweges sein. Alternativ kann die erste Position P1 eine beliebige Position des Läufers 400 auf dem Statormodul 300 sein. Insbesondere kann der Steuerpfad SP ein Teil eines Transportweges des Läufers 400 über die Statoroberfläche 303 des Statormoduls sein.

In einem Sensormusterbestimmungsschritt 103 wird darauf folgend ein Sensormuster SM der Magnetfeldsensoren 501 des Sensormoduls 500 bestimmt. Ein Sensormuster SM ist hierbei eine Teilmenge der Magnetfeldsensoren 501 des Sensormoduls, wobei das Sensormodul 500 wenigstens einen Magnetfeldsensor 501 umfasst, der nicht von dem bestimmten Sensormuster SM umfasst ist. Das Sensormuster SM kann eine beliebige zweidimensionale Form aufweisen und eine zusammenhängende Fläche auf dem Statormodul 300 beschreiben. Ein Sensormuster SM kann beliebig entlang der Statoroberfläche 303 des Statormoduls 300 verschoben werden. Während der Verschiebung umfasst das Sensormuster SM unterschiedliche Magnetfeldsensoren 501 des Sensormoduls 500.

Nach Bestimmung des Sensormusters SM wird in einem Läufermagnetfeldbestimmungsschritt 105 eine Mehrzahl von Messwerten des Läufermagnetfelds durch die Magnetfeldsensoren 501 des Sensormusters SM aufgenommen werden. Die Magnetfeldsensoren 501 können hierbei 1D-Hallsensoren, 2D-Hallsensoren bzw. 3D-Hallsensoren sein, sodass ein Messwert eines Magnetfeldsensors 501 eine Mehrzahl verschiedener Komponenten des Läufermagnetfelds umfassen kann.

Darauffolgend wird in einem Positionsbestimmungsschritt 107 der Läufer 400 auf Basis der von den Magnetfeldsensoren 501 des Sensormusters gemessenen Messwerte des Läufermagnetfelds detektiert und eine zweite Position P2 des Läufers 400 auf dem Statormodul 300 wird bestimmt.

Die zweite Position P2 kann hierbei eine Endposition des Steuerpfads SP des Läufers 400 auf dem Statormodul 300 sein. Alternativ kann die zweite Position P2 mit der ersten Position P1 identisch sein und eine Steuerung des Läufers 400 entlang dem Steuerpfad SP kann ein Halten des Läufers 400 in der ersten Position beinhalten.

Die Bestimmung der ersten Position P1 und die Bestimmung der zweiten Position P2 des Läufers 400 auf dem Statormodul 300 kann für zwei festgelegte Positionsbestimmungszeitpunkte, einen ersten Positionsbestimmungszeitpunkt und einen zweiten Positionsbestimmungszeitpunkt, durchgeführt werden, sodass Positionsbestimmungen des Läufers 400 zu festgelegten Zeitpunkten stattfinden. Beispielsweise kann eine Positionsbestimmung des Läufers 400 in der ersten Position P1 und der zweiten Position P2 in zwei aufeinander folgenden Steuerzyklen eines zyklisch gesteuerten Planarantriebssystems 200 durchgeführt werden. Eine erste Position P1 des Läufers 400 ergibt sich dann als Position, die der Läufer 400 zum ersten Positionsbestimmungszeitpunkt der ersten Positionsbestimmung auf dem Statormodul 300 einnimmt, während eine zweite Position P2 des Läufers 400 einer Position entspricht, die der Läufer zu einem zweiten Positionsbestimmungszeitpunkt auf dem Statormodul 300 einnimmt.

Fig. 5 zeigt eine schematische Darstellung eines Läufers 400 auf einem Statormodul 300 gemäß einer weiteren Ausführungsform.

In Fig. 5 ist eine grafische Illustration des Verfahrens 100 dargestellt. In Fig. 5 ist ein Statormodul 300 gezeigt. Das Statormodul 300 ist in einer Mehrzahl quadratischer Raumbereiche 502 und weiterer Raumbereiche 504 aufgeteilt. Jeder Raumbereich 502 umfasst einen Magnetfeldsensor 501. Jeder weitere Raumbereich 504 umfasst keinen Magnetfeldsensor 501. Die Raumbereiche 502 und insbesondere die Magnetfeldsensoren 501 sind auf dem Sensormodul 300 schachbrettförmig angeordnet, sodass in jeder Richtung abwechselnd ein Raumbereich 502 mit einem Magnetfeldsensor 501 und ein weiterer Raumbereich 504 ohne Magnetfeldsensor 501 aufeinander folgend angeordnet sind.

Ferner zeigt die Fig. 5 einen Läufer 400, der schematisch an einer ersten Position P1 angeordnet dargestellt ist. Der Läufer 400 wird entlang einem Steuerpfad SP von der ersten Position P1 ausgehend über die Statoroberfläche 303 des Statormoduls 300 gesteuert.

Um eine zweite Position P2 ist ferner ein Sensormuster SM angeordnet. Das Sensormuster SM umfasst eine Mehrzahl von Magnetfeldsensoren 501. Das Sensormuster SM ist in der Ausführungsform in Fig. 5 quadratisch geformt und weist die gleichen Ausmaße wie der Läufer 400 auf. Befindet sich der Läufer 400 zum zweiten Positionsbestimmungszeitpunkt in der zweiten Position P2, so lässt sich durch Aufnehmen der Messwerte des Läufermagnetfelds durch die Magnetfeldsensoren 501 des Sensormusters SM im Läufermagnetfeldbestimmungsschritt 105 zum zweiten Positionsbestimmungszeitpunkt der Läufer 400 in der zweiten Position P2 detektieren und eine eindeutige Bestimmung der Läuferposition in der zweiten Position P2 durchführen.

Die in Fig. 5 gezeigte Darstellung ist lediglich beispielhaft und soll die vorliegende Erfindung nicht beschränken. Insbesondere sind die Größenverhältnisse nicht wahrheitsgemäß wiedergegeben. Speziell kann die Entfernung zwischen der ersten Position P1 und der zweiten Position P2 derart verringert sein, dass durch das Sensormuster SM, das an der zweiten Position P2 angeordnet ist, die erste Position P1 ebenfalls abgedeckt ist. Darüber hinaus kann der Steuerpfad SP beliebig und nichtlinear angeordnet sein.

Fig. 6 zeigt ein weiteres Flussdiagramm des Verfahrens 100 zum Steuern eines Planarantriebssystems 200 gemäß einer Ausführungsform.

Die Ausführungsform in Fig. 6 basiert auf der Ausführungsform in Fig. 4 und umfasst alle dort gezeigten Verfahrensschritte. Sofern diese in der Ausführungsform in Fig. 6 unverändert bleiben, wird von einer erneuten detaillierten Beschreibung abgesehen.

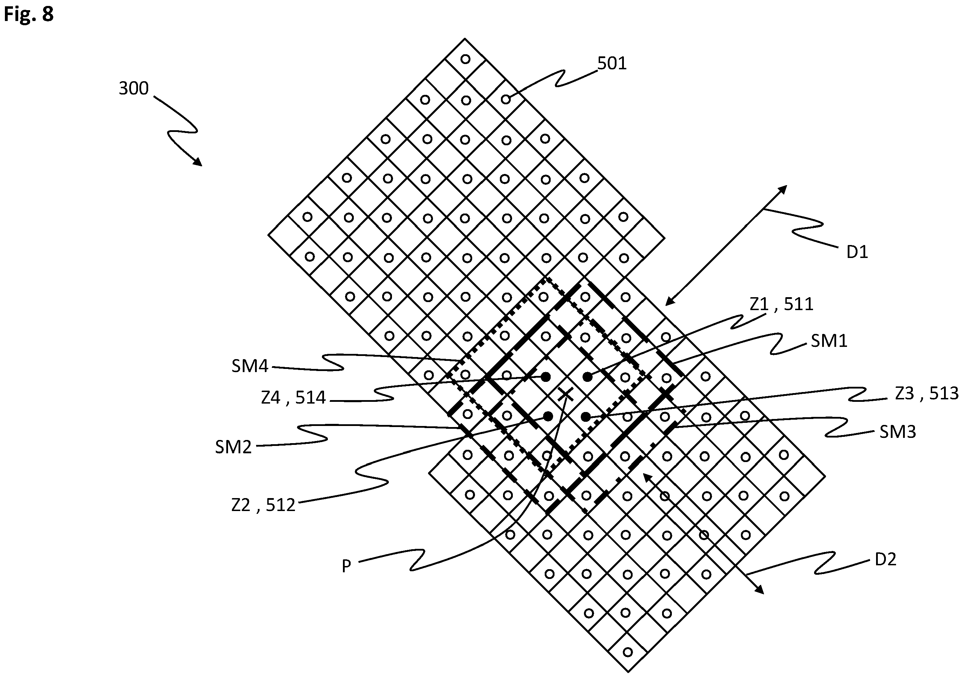

Die Beschreibung der Ausführungsform des Verfahrens 100 in Fig. 6 wird mit Bezug auf die Fig. 8 vorgenommen.

In der Ausführungsform in Fig. 6 umfasst das Sensormuster SM ein erstes Sensormuster SM1 und ein zweites Sensormuster SM2, die jeweils in einer ersten Orientierungsrichtung D1 gegeneinander verschoben sind. Das erste Sensormuster SM1 und das zweite Sensormuster SM2 können ferner einen Überlappungsbereich aufweisen, in dem die betreffenden Magnetfeldsensoren 501 sowohl Magnetfeldsensoren des ersten Sensormusters SM1 als auch des zweiten Sensormusters SM2 sind.

In der Ausführungsform in Fig. 6 umfasst der Sensormusterbestimmungsschritt 103 einen Magnetfeldsensorbestimmungsschritt 173.

Im Magnetfeldsensorbestimmungsschritt 173 werden ein erster zentraler Magnetfeldsensor 511 und ein zweiter zentraler Magnetfeldsensor 512 bestimmt. Der erste zentrale Magnetfeldsensor 511 und der zweite zentrale Magnetfeldsensor 512 sind hierbei zur ersten Position P1 direkt benachbart weisen unter allen Magnetfeldsensoren 501 des Sensormoduls 300 die beiden kürzesten Abstände zur ersten Position P1 auf.

Darüber hinaus umfasst der Sensormusterbestimmungsschritt 103 einen ersten Identifikationsschritt 175 und einen zweiten Identifikationsschritt 177 auf.

Im ersten Identifikationsschritt 175 wird eine vorbestimmte Mehrzahl von ersten Magnetfeldsensoren bestimmt, die den ersten zentralen Magnetfeldsensor 511 umgeben, und die bestimmte Mehrzahl von ersten Magnetfeldsensoren wird als erstes Sensormuster SM1 identifiziert, wobei der erste zentrale Magnetfeldsensor 511 hierbei in einem ersten geometrischen Zentrum Z1 des ersten Sensormusters SM1 angeordnet ist.

Die vorbestimmte Mehrzahl von Magnetfeldsensoren 501 bestimmt hierbei die Größe der jeweiligen Sensormuster SM beziehungsweise die von den Sensormustern SM abgedeckte Fläche des Statormoduls 300.

Im zweiten Identifikationsschritt 177 wird eine vorbestimmte Mehrzahl von zweiten Magnetfeldsensoren bestimmt, die den zweiten zentralen Magnetfeldsensor 512 umgeben, und die bestimmte Mehrzahl von ersten Magnetfeldsensoren wird als zweites Sensormuster SM2 identifiziert, wobei der zweite zentrale Magnetfeldsensor 512 hierbei in einem zweiten geometrischen Zentrum Z2 des zweiten Sensormusters SM2 angeordnet ist.

Zur Ermittlung des ersten Sensormusters SM1 und des zweiten Sensormusters SM2 werden somit die Magnetfeldsensoren 501 des Sensormoduls 300 ausgewählt, die zur ersten Position P1 benachbart sind. Die beiden Magnetfeldsensoren 501 mit geringstem Abstand zur ersten Position P1 werden darauf als geometrische Zentren Z der ersten und zweiten Sensormuster SM1, SM2 identifiziert. Hierzu werden ausgehend von den zur ersten Position P1 benachbarten Magnetfeldsensoren 501 die zu diesen Magnetfeldsensoren 501 benachbarten Magnetfeldsensoren 501 gemäß der vorbestimmten Mehrzahl von Magnetfeldsensoren 501, die ein Sensormuster SM bilden, derart ausgewählt, dass die zur ersten Position direkt benachbarten Magnetfeldsensoren die geometrischen Zentren Z der beiden Sensormuster SM bilden.

Die beiden derart bestimmten ersten und zweiten Sensormuster SM1, SM2 sind somit derart positioniert, dass das jeweilige erste geometrische Zentrum Z1 des ersten Sensormusters SM1 und das zweite geometrische Zentrum Z2 des zweiten Sensormusters SM2 direkt zur ersten Position P1 benachbart sind und insbesondere durch die zwei zur ersten Position P1 nächst benachbarten Magnetfeldsensoren 501 gegeben sind.

In der Ausführungsform in Fig. 6 umfasst der Läufermagnetfeldbestimmungsschritt 105 einen ersten Läufermagnetfeldbestimmungsschritt 109, in dem erste Messwerte des Läufermagnetfelds durch die Magnetfeldsensoren 501 des ersten Sensormusters SM1 aufgenommen werden.

Der Läufermagnetfeldbestimmungsschritt 105 umfasst ferner einen zweiten Läufermagnetfeldteilbestimmungsschritt 111, in dem zweite Messwerte des Läufermagnetfelds durch die Magnetfeldsensoren 501 des zweiten Sensormusters SM2 aufgenommen werden.

Darüber hinaus umfasst der Positionsbestimmungsschritt 107 einen ersten Läuferteildetektionsschritt 113, in dem auf Basis der von den Magnetfeldsensoren 501 des ersten Sensormusters SM1 gemessenen ersten Messwerte des Läufermagnetfelds der Läufer 400 detektiert und eine erste Teilposition des Läufers 400 bestimmt wird. Die erste Teilposition des Läufers 400 beschreibt hierbei eine Position des Läufers 400 auf dem Statormodul 300, die durch die Messungen der Magnetfeldsensoren des ersten Sensormusters SM1 bestimmt wurde.

Der Positionsbestimmungsschritt 107 umfasst ferner einen zweiten Läuferteildetektionsschritt 115, in dem auf Basis der durch die Magnetfeldsensoren 501 des zweiten Sensormusters SM2 aufgenommenen zweiten Messwerte des Läufermagnetfelds der Läufer 400 detektiert und eine zweite Teilposition des Läufers 4 auf dem Statormodul 300 bestimmt wird.

Eine Detektion des Läufers 400 durch die Magnetfeldsensoren 501 des ersten Sensormusters SM1 bzw. durch die Magnetfeldsensoren 501 des zweiten Sensormusters SM2 erfolgt insbesondere, wenn der Läufer 400 sich entlang dem Steuerpfad SP bewegend zum zweiten Positionsbestimmungszeitpunkt an der Positionierung des ersten Sensormusters SM1 und des zweiten Sensormusters SM2 befindet und das erste Sensormuster SM1 bzw. das zweite Sensormuster SM2 zumindest teilweise abdeckt. Durch diese teilweise Abdeckung des Läufers 400 der durch das erste Sensormuster SM1 und das zweite Sensormuster SM2 aufgespannten Raumbereiche der Statoroberfläche 303 sind die Magnetfeldsensoren 501 des ersten Sensormusters SM1 bzw. des zweiten Sensormusters SM2 eingerichtet, das Läufermagnetfeld des Läufers 400 durch das Aufnehmen entsprechender Messwerte zu detektieren. Durch eine entsprechende Auswertung der aufgenommenen Messwerte der Magnetfeldsensoren 501 des ersten Sensormusters und des zweiten Sensormusters kann somit der Läufer 400 in der jeweiligen Positionierung des ersten Sensormusters SM1 und des zweiten Sensormusters SM2 detektiert und eine entsprechende Position des Läufers 400 auf dem Statormodul 300 bestimmt werden.

Die erste Teilposition und die zweite Teilposition des Läufers 400 entsprechen somit eigenständigen Positionsbestimmungen, die ausschließlich auf den ersten Messwerten der Magnetfeldsensoren 501 des ersten Sensormusters SM1 und den zweiten Messwerten der Magnetfeldsensoren 501 des zweiten Sensormusters SM2 basieren.

Insbesondere kann die Bestimmung der zweiten Position P2 des Läufers 400 auf dem Statormodul 300 zu dem vorbestimmten zweiten Positionsbestimmungszeitpunkt vorgenommen werden. Zum zweiten Positionsbestimmungszeitpunkt werden die ersten Messwerte der Magnetfeldsensoren 501 des ersten Sensormusters SM1 und die zweiten Messwerte der Magnetfeldsensoren 501 des zweiten Sensormusters SM2 aufgenommen. In Abhängigkeit der Positionierung, die der Läufer 400 zu diesem zweiten Positionsbestimmungszeitpunkt auf dem Statormodul 300 einnimmt, ermitteln die Magnetfeldsensoren 501 des ersten Sensormusters SM1 und die Magnetfeldsensoren 501 des zweiten Sensormusters SM2 unterschiedliche Werte des Läufermagnetfelds des Läufers 400. Auf Basis dieser Werte des Läufermagnetfelds des Läufers 400 lassen sich dann die erste Teilposition des Läufers, die der Positionsbestimmung entspricht, die auf Basis der zum zweiten Positionsbestimmungszeitpunkt aufgenommenen ersten Messwerte der Magnetfeldsensoren 501 des ersten Sensormuster SM1 vorgenommen wurde, und die zweite Teilposition des Läufers 400 bestimmen, die der Positionsbestimmung entspricht, die auf Basis der zum zweiten Positionsbestimmungszeitpunkt aufgenommenen zweiten Messwerte der Magnetfeldsensoren 501 des zweiten Sensormuster SM2 vorgenommen wurde.

Darauffolgend werden in einem Gewichtungsschritt 117 ein erster Gewichtungswert W1 des ersten Sensormusters SM1 und ein zweiter Gewichtungswert W2 des zweiten Sensormusters SM2 bestimmt.

Nach Bestimmung der ersten und zweiten Gewichtungswerte W1, W2 im Gewichtungsschritt 117 wird die zweite Position P2 des Läufers 400 in einem Mittelwertbildungsschritt 119 als ein gewichteter Mittelwert aus der ersten Teilposition und der zweiten Teilposition unter Berücksichtigung des ersten Gewichtungswerts und des zweiten Gewichtungswerts bestimmt.

Dem obigen Beispiel folgend kann somit für eine Positionierung des Läufers 400 zum zweiten Positionsbestimmungszeitpunkt, die der Positionierung des ersten Sensormusters SM1 entspricht, und somit der Läufer 400 die Fläche des ersten Sensormusters SM1 vollständig abdeckt, und der erste Gewichtungswert W1 somit mit dem Zahlenwert 1 und der zweite Gewichtungswert mit dem Zahlenwert 0 versehen wird, die tatsächliche Positionierung des Läufers 400 in der zum zweiten Positionsbestimmungszeitpunkt aufgenommenen zweiten Position P2 durch die Ermittlung des gewichteten Mittelwerts aus der ersten Teilposition des ersten Sensormusters SM1 und der zweiten Teilposition des zweiten Sensormusters SM2 unter Berücksichtigung der ersten und zweiten Gewichtungswerte W1, W2 durch die von den Magnetfeldsensoren 501 des ersten Sensormusters SM1 ermittelten ersten Teilposition bestimmt werden, während die durch die Magnetfeldsensoren 501 des zweiten Sensormusters SM2 ermittelte zweite Teilposition mit dem Gewichtungswert 0 versehen in der Bestimmung der tatsächlichen Position des Läufers 400, sprich in dem gewichteten Mittelwert, keine Berücksichtigung findet.

Durch die Verwendung des gewichteten Mittelwerts unter Berücksichtigung der durch die Magnetfeldsensoren 501 der ersten Sensormusters SM1 und des zweiten Sensormuster SM2 bestimmten ersten und zweiten Teilpositionen unter Verwendung der ersten und zweiten Gewichtungswerte W1, W2 kann somit eine präzise Positionsbestimmung des Läufers 400 zum zweiten Positionsbestimmungszeitpunkt in der zweiten Position P2 ermittelt werden.

Der gewichtete Mittelwert kann ein gewichtetes arithmetisches Mittel sein. Für die ersten und zweiten Teilpositionen und den ersten und zweiten Gewichtungswerten W1, W2 lässt sich die zweite Position P2 somit bestimmen:

$$P2_{arithmetisch}=(W1*TP1+W2*TP2)/(W1+W2),$$

wobei TP1 die erste Teilposition und TP2 die zweite Teilposition sind.

Alternativ kann der gewichtete Mittelwert ein gewichtetes geometrisches Mittel sein. Für die ersten und zweiten Teilpositionen und den ersten und zweiten Gewichtungswerten W1, W2 lässt sich die zweite Position P2 somit bestimmen:

$$P2_{geometrisch}=(TP1^{W1}*TP2^{W2})^{1/W}, \text{ wobei } W=W1+W2 \text{ gilt.}$$

Alternativ kann der gewichtete Mittelwert ein gewichtetes harmonisches Mittel sein. Für die ersten und zweiten Teilpositionen und den ersten und zweiten Gewichtungswerten W1, W2 lässt sich die zweite Position P2 somit bestimmen:

$$P2_{harmonisch}=(W1+W2)/(W1/TP1+W2/TP2).$$

Alternativ kann der gewichtete Mittelwert auch eine beliebiges anderes gewichtetes Mittel sein.

Darüber hinaus können durch die Positionsbestimmung des Läufers 400 mittels des gewichteten Mittelwerts der ersten und zweiten Teilpositionen Sprünge in der Positionsbestimmung des Läufers 400 vermieden werden. Indem die ersten und zweiten Gewichtungswerte W1, W2 kontinuierlich Werte zwischen 0 und 1 annehmen, tragen die ersten und zweiten Sensormuster SM1, SM2 jeweils einen mit dem jeweiligen Gewichtungswert als Faktor versehen Wert zur Positionsbestimmung bei. Damit kann vermieden werden, dass bei zwei aufeinander folgenden Positionsbestimmungen diese einmal ausschließlich auf den Messwerten des einen Sensormusters und darauffolgend ausschließlich mit Messwerten des jeweils anderen Sensormusters erfolgen, was aufgrund der verschiedenen Positionierungen der beiden Sensormuster einen Sprung in der Positionsbestimmung des Läufers 400 zur Folge hätte. Die Positionsbestimmung basierend auf dem gewichteten Mittelwert ermöglicht somit für einen sich auf dem Statormodul 300 bewegenden Läufer 400 eine kontinuierliche bzw. mathematisch stetige Bestimmung der Läuferposition.

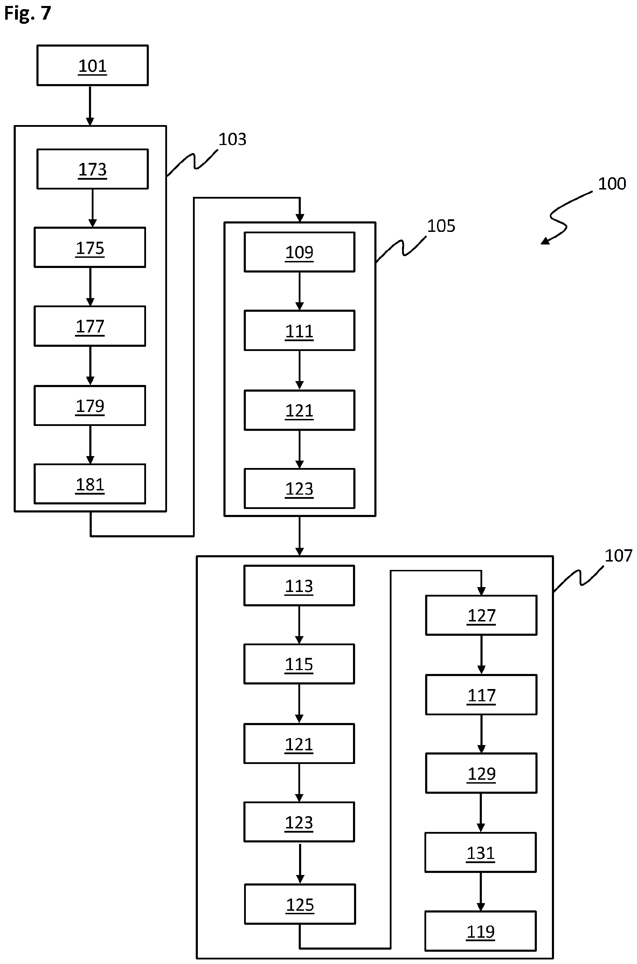

Fig. 7 zeigt ein weiteres Flussdiagramm des Verfahrens 100 zum Steuern eines Planarantriebssystems 200 gemäß einer Ausführungsform.

Die in Fig. 7 gezeigte Ausführungsform basiert auf der in Fig. 6 gezeigten Ausführungsform und umfasst alle dort beschriebenen Verfahrensschritte. Sofern diese in der Ausführungsform in Fig. 7 unverändert bleiben, wird von einer erneuten detaillierten Beschreibung abgesehen.

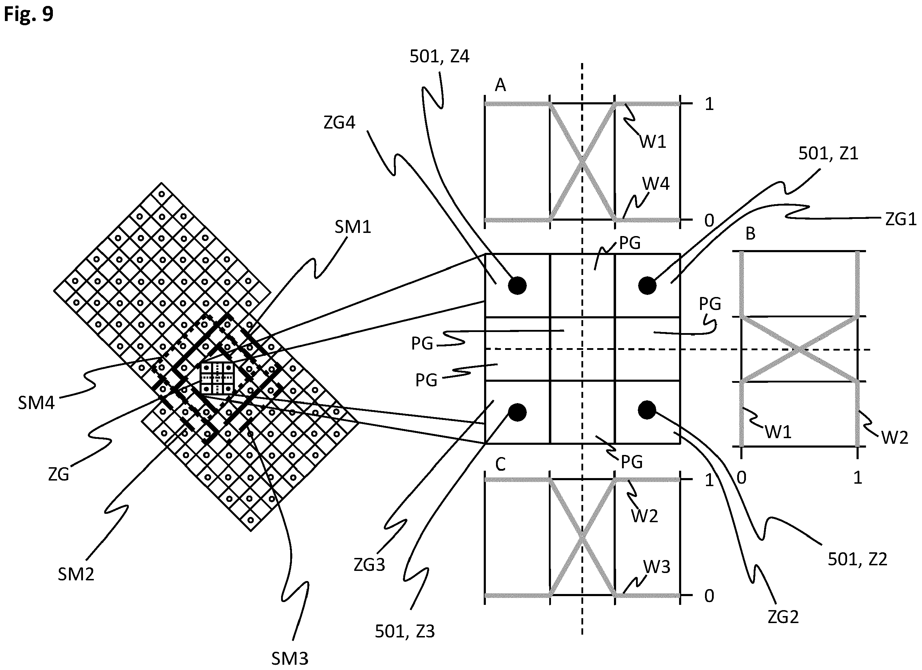

Für die folgende Beschreibung des Verfahrens 100 in der Ausführungsform in Fig. 7 wird auf die grafischen Darstellungen in Fig. 8 und Fig. 9 verwiesen, in denen relevante Merkmale des Verfahrens 100 in der Ausführungsform in Fig. 7 grafisch dargestellt sind.

Abweichend zu der Ausführungsform in Fig. 6 umfasst in der Ausführungsform in Fig. 7 das Sensormuster SM neben dem ersten Sensormuster SM1 und dem zweiten Sensormuster SM2 ein drittes Sensormuster SM3 und ein viertes Sensormuster SM4. Das dritte Sensormuster SM3 und das vierte Sensormuster SM4 sind in einer zur ersten Orientierungsrichtung D1 senkrecht orientierten zweiten Orientierungsrichtung D2 gegeneinander verschoben und weisen einen Überlappungsbereich auf, in dem die jeweilig dort angeordneten Magnetfeldsensoren 501 sowohl vom dritten Sensormuster SM3 als auch vom vierten Sensormuster SM4 umfasst sind.

In der Ausführungsform in Fig. 7 werden im Magnetfeldsensorbestimmungsschritt 173 somit zusätzlich ein dritter zentraler Magnetfeldsensor 513 und ein vierter zentraler Magnetfeldsensor 514 bestimmt. Der dritte zentrale Magnetfeldsensor 513 und der vierte zentrale Magnetfeldsensor 514 sind hierbei zur ersten Position P1 direkt benachbart und weisen neben dem ersten zentralen Magnetfeldsensor 511 und dem zweiten zentralen Magnetfeldsensor 512 die beiden kürzesten Abstände zur ersten Position P1 auf.

Darüber hinaus umfasst der Sensormusterbestimmungsschritt 103 einen dritten Identifikationsschritt 179 und einen vierten Identifikationsschritt 181 auf.

Im dritten Identifikationsschritt 179 wird eine vorbestimmte Mehrzahl von dritten Magnetfeldsensoren bestimmt, die den dritten zentralen Magnetfeldsensor 513 umgeben, und die bestimmte Mehrzahl von dritten Magnetfeldsensoren wird als drittes Sensormuster SM3 identifiziert, wobei der dritte zentrale Magnetfeldsensor 513 hierbei in einem dritten geometrischen Zentrum Z3 des dritten Sensormusters SM3 angeordnet ist.

Im vierten Identifikationsschritt 181 wird eine vorbestimmte Mehrzahl von vierten Magnetfeldsensoren bestimmt, die den vierten zentralen Magnetfeldsensor 514 umgeben, und die bestimmte Mehrzahl von vierten Magnetfeldsensoren wird als viertes Sensormuster SM4 identifiziert, wobei der vierte zentrale Magnetfeldsensor 514 hierbei in einem vierten geometrischen Zentrum Z4 des vierten Sensormusters SM4 angeordnet ist.

Die Anzahl von Magnetfeldsensoren 501, die von den einzelnen Sensormustern SM umfasst sind, können hierbei für die ersten bis vierten Sensormuster SM1, SM2, SM3, SM4 identisch sein. Ebenso können die Formen des Sensormuster SM identisch sein.

In der Ausführungsform in Fig. 7 umfasst der Läufermagnetfeldbestimmungsschritt 105 somit ferner einen dritten Läufermagnetfeldteilbestimmungsschritt, in dem dritte Messwerte des Läufermagnetfelds durch die Magnetfeldsensoren 501 des dritten Sensormusters SM3 aufgenommen werden.

Ferner umfasst der Läufermagnetfeldbestimmungsschritt 105 einen vierten Läufermagnetfeldteilbestimmungsschritt 123, in dem vierte Messwerte des Läufermagnetfelds durch die Magnetfeldsensoren 501 des vierten Sensormusters SM4 aufgenommen werden.

Im Magnetfeldbestimmungsschritt 105 werden somit vier Sätze von Messwerten des Läufermagnetfelds durch die entsprechenden Magnetfeldsensoren 501 des ersten Sensormusters SM1, des zweiten Sensormusters SM2, des dritten Sensormusters SM3 und des vierten Sensormusters SM4 aufgenommen.

In der Ausführungsform in Fig. 7 umfasst der Positionsbestimmungsschritt 107 ferner einen dritten Läuferteildetektionsschritt 125, in dem auf Basis der von den Magnetfeldsensoren 501 des dritten Sensormusters SM3 aufgenommenen dritten Messwert des Läufermagnetfelds der Läufer 400 detektiert und eine dritte Teilposition des Läufers 400 bestimmt wird.

Ferner umfasst der Positionsbestimmungsschritt 107 einen vierten Läuferteildetektionsschritt 127, in dem auf Basis der von den Magnetfeldsensoren 501 des vierten Sensormusters SM4 gemessenen vierten Messwerte des Läufermagnetfelds der Läufer 400 detektiert und eine vierte Teilposition des Läufers 400 bestimmt wird.

Im Positionsbestimmungsschritt 107 werden somit zum zweiten Positionsbestimmungszeitpunkt auf Basis der ersten bis vierten Messwerte des Läufermagnetfelds erste bis vierte Teilpositionen des Läufers 400 bestimmt. Die ersten bis vierten Teilpositionen entsprechen Positionen des Läufers 400, die durch die jeweiligen Magnetfeldsensoren 501 der ersten bis vierten Sensormuster SM1, SM2, SM3, SM4 bestimmt wurden. Dadurch, dass die ersten bis vierten Sensormuster SM1, SM2, SM3, SM4 entlang der ersten Orientierungsrichtung D1 bzw. der zweiten Orientierungsrichtung D2 gegeneinander verschoben sind, und somit unterschiedliche Positionierungen auf dem Sensormodul 300 aufweisen und unterschiedliche Magnetfeldsensoren 501 des Sensormoduls 500 umfassen, können bei einer Positionierung des Läufers 400 unterschiedliche Bereiche der einzelnen Sensormuster vom Läufer 400 bedeckt sein.

Hierdurch können durch die Magnetfeldsensoren 501 der verschiedenen Sensormuster SM1, SM2, SM3, SM4 unterschiedliche erste bis vierte Messwerte des Läufermagnetfelds gemessen werden. Daraus ergibt sich, dass aus den einzelnen Bestimmungen der ersten bis vierten Teilpositionen auf Basis der ersten bis vierten Messwerte des Läufermagnetfelds, die durch die entsprechenden Magnetfeldsensoren 501 der ersten bis vierten Sensormuster SM1, SM2, SM3, SM4 aufgenommen wurden, zum zweiten Positionsbestimmungszeitpunkt unterschiedliche Positionen des Läufers 400 ermittelt werden, sodass die auf Basis der ersten Messwerte der Magnetfeldsensoren 501 des ersten Sensormusters SM1 ermittelte erste Teilposition, die auf Basis der zweiten Messwerte der Magnetfeldsensoren 501 des zweiten Sensormusters SM2 ermittelte zweite Teilposition, die auf Basis der dritten Messwert der Magnetfeldsensoren 501 des dritten Sensormusters SM3 ermittelte dritte Teilposition und die auf Basis der vierten Messwerte der Magnetfeldsensoren 501 des vierten Sensormusters SM4 ermittelte vierte Teilposition voneinander abweichen.

Darauf folgend werden im Gewichtungsschritt 117 neben dem ersten Gewichtungswert W1 und dem zweiten Gewichtungswert W2 ein dritter Gewichtungswert W3 und ein vierter Gewichtungswert W4 bestimmt.

Der Positionsbestimmungsschritt 107 umfasst ferner einen Übereinstimmungsbestimmungsschritt 129, in dem Übereinstimmungen zwischen der ersten Position P1 des Läufers 400 auf dem Statormodul 300 mit einer ersten Positionierung des ersten Sensormusters SM 1, mit einer zweiten Positionierung des zweiten Sensormusters SM2, mit einer dritten Positionierung des dritten Sensormusters SM3 und einer vierten Positionierung des vierten Sensormusters SM4 bestimmt werden. Über die Übereinstimmungswerte zwischen der ersten Position P1 und der jeweiligen Positionierung des ersten Sensormusters SM1, des zweiten Sensormusters SM2, des dritten Sensormusters SM3 bzw. des vierten Sensormusters SM4 wird somit ermittelt, inwiefern die erste Position P1 des Läufers 400 auf dem Statormodul 300 durch die jeweiligen Sensormuster SM1, SM2, SM3, SM4 abgedeckt ist.

Eine Positionierung des jeweiligen Sensormusters wird hierbei durch die entsprechenden Magnetfeldsensoren 501, die von dem jeweiligen Sensormuster umfasst sind, und durch deren Positionierung innerhalb des Sensormoduls 500 gegeben.

Bei einer Übereinstimmung der ersten Position P1 des Läufers 400 und einer Positionierung eines der Sensormuster SM1, SM2, SM3, SM4 bedeckt der Läufer 400 in der ersten Position P1 alle Magnetfeldsensoren 501 des jeweiligen Sensormusters SM1, SM2, SM3, SM4.

Ferner wird im Übereinstimmungsbestimmungsschritt 129 jedem Sensormuster SM 1, SM2, SM3, SM4 ein Übereinstimmungswert zugeordnet. Ein Übereinstimmungswert kann hierbei einen beliebigen Wert zwischen 0 und 1 annehmen, wobei ein Übereinstimmungswert mit dem Zahlenwert 1 eine vollständige Übereinstimmung der ersten Position P1 mit der Positionierung eines entsprechenden Sensormusters SM entspricht, während ein Übereinstimmungswert mit dem Zahlenwert 0 einer fehlenden Übereinstimmung zwischen der ersten Position P1 und einem entsprechenden Sensormuster SM entspricht, während ein Übereinstimmungswert mit einem Zahlenwert zwischen 0 und 1 einer teilweisen Übereinstimmung bzw. einer Teilübereinstimmung der ersten Position P1 mit der jeweiligen Positionierung des Sensormusters SM entspricht.

Eine Übereinstimmung zwischen der Position P1 und der Positionierung eines der Sensormuster SM1, SM2, SM3, SM4 kann beispielsweise über eine Abstandsbestimmung zwischen der ersten Position P1 und dem geometrischen Zentrum Z des jeweiligen Sensormusters bestimmt werden. So kann beispielsweise für einen Abstand zwischen der ersten Position P1 und einem geometrischen Zentrum Z eines Sensormusters SM, der kleiner gleich einem ersten Grenzwert ist, eine vollständige Übereinstimmung zwischen der ersten Position P1 und der Positionierung des jeweiligen Sensormusters SM bestimmt werden. Für einen Abstand zwischen der ersten Position P1 und dem geometrischen Zentrum Z des jeweiligen Sensormusters SM größer gleich einem zweiten Grenzwert kann beispielsweise eine fehlende Übereinstimmung zwischen der ersten Position P1 und dem jeweiligen Sensormuster SM ermittelt werden. Für einen Abstand zwischen der ersten Position P1 und dem jeweiligen Sensormuster SM, der größer als der erste Grenzwert und kleiner als der zweite Grenzwert ist, kann somit eine Teilübereinstimmung zwischen der ersten Position P1 und der jeweiligen Positionierung des Sensormusters SM ermittelt werden.

Darauf folgend werden in einem Gewichtungswertidentifikationsschritt 131 der erste Übereinstimmungswert mit dem ersten Gewichtungswert W1, der zweite Übereinstimmungswert mit dem zweiten Gewichtungswert W2, der dritte Übereinstimmungswert mit dem dritten Gewichtungswert W3 und der vierte Übereinstimmungswert mit dem vierten Gewichtungswert W4 identifiziert.

Hiermit kann eine Gewichtung der ersten bis vierten Teilpositionen, die auf Basis der ersten bis vierten Messwerte der Magnetfeldsensoren 501 der ersten bis vierten Sensormuster SM1, SM2, SM3, SM4, die zur Positionsbestimmung des Läufers 400 zum zweiten Positionsbestimmungszeitpunkt ermittelt wurden, in Abhängigkeit von der Übereinstimmung der zum ersten Positionsbestimmungszeitpunkt bestimmten ersten Position P1 mit den jeweiligen Positionierungen der Sensormuster SM1, SM2, SM3, SM4 durchgeführt werden. Hierdurch kann erreicht werden, dass für die Positionsbestimmung des Läufers 400 zum zweiten Positionsbestimmungszeitpunkt die Teilposition des Sensormusters SM1, SM2, SM3, SM4 mit einer hohen Gewichtung berücksichtigt wird, dessen Sensormuster bereits zur Bestimmung der ersten Position zum ersten Positionsbestimmungszeitpunkt einen aufgrund hoher Übereinstimmung zwischen der Positionierung des Sensormusters zur Position des Läufers 400 zum ersten Positionsbestimmungszeitpunkt dominanten Beitrag beigetragen hat.

Somit trägt die Positionsbestimmung, die auf Basis der Messwerte der Magnetfeldsensoren 501 des Sensormusters SM1, SM2, SM3, SM4, das mit großer Übereinstimmung zur ersten Position P1 positioniert ist und dessen Magnetfeldsensoren 501 bereits zur Positionsbestimmung der ersten Position P1 den dominierenden Beitrag geleistet haben, dominierend zur Positionsbestimmung des Läufers 400 in der zweiten Position P2 bei.

Bei Änderung des Läufers von der ersten Position P1 zum ersten Positionsbestimmungszeitpunkt entlang dem Steuerpfad SP in die zweite Position P2 zum zweiten Positionsbestimmungszeitpunkt werden somit die Messwerte der Magnetfeldsensoren 501 zur Positionsbestimmung des Läufers 400 in der zweiten Position P2 bevorzugt berücksichtigt, die bereits zur Positionsbestimmung des Läufers 400 in der ersten Position P1 bevorzugt beigetragen haben. Hierdurch kann erreicht werden, dass bei geringen Änderungen zwischen der ersten Position P1 und der zweiten Position P2 keine neue Auswahl der zur Positionsbestimmung des Läufers 400 in der zweiten Position P2 zu verwendenden Magnetfeldsensoren 501 vorgenommen werden muss. Stattdessen werden die Magnetfeldsensoren 501 zur Positionsbestimmung des Läufers 400 in der zweiten Position P2 verwendet, die bereits zur Positionsbestimmung des Läufers 400 in der ersten Position P1 verwendet wurden, wobei hierbei über die entsprechenden Gewichtungswerte diejenigen Magnetfeldsensoren 501 mit erhöhtem Beitrag berücksichtigt werden, die bereits zur Positionsbestimmung des Läufers 400 in der ersten Position P1 den dominanten Beitrag lieferten und die exakteste Positionsbestimmung beitrugen.

Dies ist insbesondere für den Fall von Interesse, dass zwischen dem ersten Positionsbestimmungszeitpunkt und dem zweiten Positionsbestimmungszeitpunkt lediglich eine derart kurze Zeitspanne liegt, dass ein Läufer 400 nicht in der Lage ist, auf dem Statormodul 300 eine Strecke zurückzulegen, die den Läufer 400 aus der durch die Sensormuster SM1, SM2, SM3, SM4 bedeckten Fläche herausführt. Dies ist insbesondere für den Fall gegeben, dass die erste Positionsbestimmungszeitpunkt und der zweite Positionsbestimmungszeitpunkt durch zwei aufeinander folgende Steuerzyklen der Steuereinheit 201 des Planarantriebssystems definiert sind.

Darauf folgend werden im Mittelwertbildungsschritt 119 die erste Teilposition mit dem entsprechenden ersten Gewichtungswert W1, die zweite Teilposition mit dem entsprechenden zweiten Gewichtungswert W2, die dritte Teilposition mit dem entsprechenden dritten Gewichtungswert W3 und die vierte Teilposition mit dem entsprechenden vierten Gewichtungswert W4 zur Bestimmung der Position des Läufers 400 in der zweiten Position P2 in Form eines gewichteten Mittelwerts berücksichtigt. Die tatsächliche Position des Läufers 400 zum zweiten Positionsbestimmungszeitpunkt wird hierbei über den gewichteten Mittelwert aus den ersten bis vierten Teilpositionen unter Berücksichtigung der entsprechenden ersten bis vierten Gewichtungswerte bestimmt, sodass in der Positionsbestimmung die Teilposition mit höchstem Gewichtungswert dominant und die jeweiligen Teilpositionen mit niedrigstem Gewichtungswert vernachlässigbar berücksichtigt werden.

Wie oben bereits für das ersten Sensormuster SM1 und das zweite Sensormuster SM2, kann auch in dieser Ausführungsform der gewichtete Mittelwert ein gewichtetes arithmetisches Mittel sein. Für die ersten, zweiten, dritten und vierten Teilpositionen und die ersten, zweiten, dritten und vierten Gewichtungswerten W1, W2, W3, W4 lässt sich die zweite Position P2 somit bestimmen:

$$P2_{arithmetisch}=(W1*TP1+W2*TP2+W3*TP3+W4*TP4)/(W1+W2+W3+W4),$$

wobei TP1 die erste Teilposition, TP2 die zweite Teilposition, TP3 die dritte Teilposition und TP4 die vierte Teilposition sind.

Alternativ kann der gewichtete Mittelwert ein gewichtetes geometrisches Mittel sein. Für die ersten, zweiten, dritten und vierten Teilpositionen und die ersten, zweiten, dritten und vierten Gewichtungswerten W1, W2, W3, W4 lässt sich die zweite Position P2 somit bestimmen:

$$P2_{geometrisch}=(TP1^{W1}*TP2^{W2}*TP3^{W3}*TP4^{W4})^{1/W}, \text{ wobei } W=W1+W2+W3+W4 \text{ gilt.}$$

Alternativ kann der gewichtete Mittelwert ein gewichtetes harmonisches Mittel sein. Für die ersten, zweiten, dritten und vierten Teilpositionen und die ersten, zweiten, dritten und vierten Gewichtungswerten W1, W2, W3, W4 lässt sich die zweite Position P2 somit bestimmen:

$$P2_{harmonisch}=(W1+W2+W3+W4)/(W1/TP1+W2/TP2+W3/TP3+W4/TP4).$$

Alternativ kann der gewichtete Mittelwert auch eine beliebiges anderes gewichtetes Mittel sein.

Fig. 8 zeigt eine schematische Darstellung eines Statormoduls 300 mit für eine Positionsbestimmung eines Läufers 400 ausgewählten Magnetfeldsensoren 501 gemäß einer weiteren Ausführungsform.

Fig. 8 zeigt eine grafische Darstellung der im Verfahren 100 gemäß der Ausführungsform in Fig. 7 verwendeten Sensormuster.

In Fig. 8 sind ein erstes Sensormuster SM1, ein zweites Sensormuster SM2, ein drittes Sensormuster SM3 und ein viertes Sensormuster SM4 um eine Position P angeordnet. Die Position P ist eine Position, die der Läufer 400, in Fig. 8 nicht gezeigt, zu einem beliebigen Positionsbestimmungszeitunkt einnimmt.

Das erste Sensormuster SM1 und das zweite Sensormuster SM2 sind jeweils entlang der ersten Orientierungsrichtung D1 gegeneinander verschoben. Das dritte Sensormuster SM3 und das vierte Sensormuster SM4 sind jeweils um die zweite Orientierungsrichtung D2, die senkrecht zur ersten Orientierungsrichtung D1 orientiert ist, gegeneinander verschoben.

Das erste Sensormuster SM1 weist ein erstes geometrisches Zentrum Z1 auf. Das zweite Sensormuster SM2 weist ein zweites geometrisches Zentrum Z2 auf. Das dritte Sensormuster SM3 weist ein drittes geometrisches Zentrum Z3 auf. Das vierte Sensormuster SM4 weist ein viertes geometrisches Zentrum Z4 auf. Die ersten bis vierten geometrischen Zentren Z1, Z2, Z3, Z4 sind jeweils durch die zur Position P nächst benachbarten Magnetfeldsensoren 501 definiert. Das erste geometrische Zentrum Z1 ist durch den ersten zentralen Magnetfeldsensor 511 gegeben. Das zweite geometrische Zentrum Z2 ist durch den zweiten zentralen Magnetfeldsensor 512 gegeben. Das dritte geometrische Zentrum Z3 ist durch den dritten zentralen Magnetfeldsensor 513 gegeben. Das vierte geometrische Zentrum Z4 ist durch den vierten zentralen Magnetfeldsensor 514 gegeben.

Die Sensormuster SM1, SM2, SM3, SM4 sind jeweils quadratisch ausgebildet und weisen eine identische Anzahl von Magnetfeldsensoren 501 auf. Die Sensormuster SM1, SM2, SM3, SM4 können beispielsweise der Form des Läufers 400 entsprechen. Alternativ können die Sensormuster SM1, SM2, SM3, SM4 eine beliebige zweidimensionale Form aufweisen.

Zur Bestimmung der Position P des Läufers 400 werden gemäß dem Verfahren 100 zu einem entsprechenden Positionsbestimmungszeitpunkt durch die Magnetfeldsensoren 501 des ersten Sensormusters SM1 erste Messwerte durch die Magnetfeldsensoren 501 des zweiten Sensormusters SM2 zweite Messwerte, durch die Magnetfeldsensoren 501 des dritten Sensormusters SM3 dritte Messwerte und durch die Magnetfeldsensoren 501 des vierten Sensormusters SM4 vierte Messwerte des Läufermagnetfelds des Läufers 400 aufgenommen. Auf Basis der ersten bis vierten Messwerte werden eine erste Teilposition, eine zweite Teilposition, eine dritte Teilposition und eine vierte Teilposition bestimmt, die jeweils eine Positionsbestimmung des Läufers 400 auf Basis der Messwerte der Magnetfeldsensoren 501 der jeweiligen Sensormuster SM 1, SM2, SM3, SM4 entsprechen.

Eine tatsächliche Position P des Läufers 400 wird darauffolgend durch einen gewichteten Mittelwert aus den ersten bis vierten Teilpositionen unter Berücksichtigung der entsprechenden ersten bis vierten Gewichtungswerte bestimmt.

Die ersten bis vierten Gewichtungswerte können auf Basis einer Übereinstimmung zwischen einer zuvor bestimmten Position und der Positionierung des jeweiligen Sensormusters bestimmt werden.

Analog kann in einer Positionsbestimmung zu einem folgenden späteren Positionsbestimmungszeitpunkt die Übereinstimmung der in Fig. 8 gezeigten Position P mit den jeweiligen Positionierungen der ersten bis vierten Sensormuster SM1, SM2, SM3, SM4 berücksichtigt werden. In Fig. 8 ist die gezeigte Position P in exakt gleichem Abstand zum ersten geometrischen Zentrum Z1 des ersten Sensormusters SM1, zum zweiten geometrischen Zentrum Z2 des zweiten Sensormusters SM2, zum dritten geometrischen Zentrum Z3 des dritten Sensormusters SM3 und zum vierten geometrischen Zentrum Z4 des vierten Sensormusters SM4 angeordnet. Für eine folgende Positionsbestimmung einer zukünftigen Position würden somit die Messwerte der Magnetfeldsensoren 501 des ersten Sensormusters SM1, des zweiten Sensormusters SM2, des dritten Sensormusters SM3 und des vierten Sensormusters SM4 in gleicher Gewichtung beitragen.

Die in Fig. 8 gezeigte Positionierung der vier Sensormuster relativ zur dargestellten Position P ist lediglich beispielhaft.

Fig. 9 zeigt eine weitere schematische Darstellung eines Statormoduls 300 mit für eine Positionsbestimmung eines Läufers 400 ausgewählten Magnetfeldsensoren 501 gemäß einer weiteren Ausführungsform.

In Fig. 9 ist eine grafische Darstellung zur Illustration der Bestimmung der ersten bis vierten Gewichtungswerte W1, W2, W3, W4 auf Basis einer Übereinstimmung bzw. eines Abstands zwischen einer Position P und einem geometrischen Zentrum Z eines entsprechenden Sensormusters SM dargestellt.

Hierzu ist für jedes geometrische Zentrum ein zentraler Gewichtungsbereich ZG und ein peripherer Gewichtungsbereich PG bestimmt. So ist um das erste geometrische Zentrum Z1 des ersten Sensormusters SM1 ein quadratisch geformter erster zentraler Gewichtungsbereich ZG1 angeordnet. Um das zweite geometrische Zentrum Z2 des zweiten Sensormusters SM2 ist ein quadratischer zweiter zentraler Gewichtungsbereich ZG2 angeordnet. Um das dritte geometrische Zentrum Z3 des dritten Sensormusters SM3 ist ein quadratischer dritter zentraler Gewichtungsbereich ZG3 angeordnet. Um das vierte geometrische Zentrum Z4 des vierten Sensormusters SM4 ist ein quadratischer vierter zentraler Gewichtungsbereich ZG4 angeordnet.

Zwischen dem ersten zentralen Gewichtungsbereich ZG1 des ersten geometrischen Zentrums Z1 und dem zweiten zentralen Gewichtungsbereich ZG2 des zweiten geometrischen Zentrums Z2 ist ein ebenfalls quadratisch geformter peripherer Gewichtungsbereich PG angeordnet. Zwischen dem zweiten zentralen Gewichtungsbereich ZG2 des zweiten geometrischen Zentrums Z2 und dem dritten zentralen Gewichtungsbereich ZG3 des dritten geometrischen Zentrums Z3 ist wiederum ein quadratisch geformter peripherer Gewichtungsbereich PG angeordnet. Zwischen dem dritten zentralen Gewichtungsbereich ZG3 des dritten geometrischen Zentrums Z3 und dem vierten zentralen Gewichtungsbereich ZG4 des vierten geometrischen Zentrums Z4 ist wiederum ein quadratisch geformter peripherer Gewichtungsbereich PG angeordnet. Zwischen dem vierten zentralen Gewichtungsbereich ZG4 des vierten geometrischen Zentrums Z4 und dem ersten zentralen Gewichtungsbereich ZG1 des ersten geometrischen Zentrums Z1 ist wiederum ein quadratisch geformter peripherer Gewichtungsbereich PG angeordnet. Im Zentrum der ersten bis vierten zentralen Gewichtungsbereiche ZG1, ZG2, ZG3, ZG4 ist ebenfalls ein peripherer Gewichtungsbereich PG angeordnet.

In Fig. 9 sind ferner drei Verläufe des ersten Gewichtungswerts W1, des zweiten Gewichtungswerts W2, des dritten Gewichtungswerts W3 und des vierten Gewichtungswerts W4 dargestellt. Die dargestellten Verläufe der Gewichtungswerte W1, W2, W3, W4 zeigen die Abhängigkeit der Gewichtungswerte W1, W2, W3, W4 von der Übereinstimmung der Positionierung des jeweiligen Sensormusters SM mit einer zuvor bestimmten Position P, die in Fig. 9 nicht dargestellt ist.

So zeigt der erste Verlauf A den Verlauf des ersten Gewichtungswerts W1 und des vierten Gewichtungswerts W4 in Abhängigkeit zum Abstand der entsprechenden Position P zum ersten geometrischen Zentrum Z1 und zum vierten geometrischen Zentrum Z4. Gemäß dem Verlauf A wird eine Gewichtungsverteilung des ersten Gewichtungswerts W1 und des vierten Gewichtungswerts W4 derart vorgenommen, dass bei einer Positionierung der Position P innerhalb des ersten zentralen Gewichtungsbereichs ZG1 des ersten geometrischen Zentrums Z1 der erste Gewichtungswert W1 den Wert 1 und der vierte Gewichtungswert W4 den Wert 0 annehmen. Bei einer Positionierung der Position P innerhalb des vierten zentralen Gewichtungsbereichs ZG4 des vierten geometrischen Zentraums Z4 so beträgt der erste Gewichtungswert W1 den Wert 0 und der vierte Gewichtungswert W4 den Wert 1. Bei einer Positionierung der Position P innerhalb des peripheren Gewichtungsbereichs PG zwischen dem ersten zentralen Gewichtungsbereich ZG1 und dem vierten zentralen Gewichtungsbereich ZG4 so weisen sowohl der erste Gewichtungswert W1 als auch der vierte Gewichtungswert W4 einen linearen Verlauf zwischen dem Wert 0 und dem Wert 1 auf. Ein Verlauf der Gewichtungswerte innerhalb des peripheren Gewichtungsbereichs PG ist in Fig. 9 linear ausgebildet. Ein anders gestalteter Verlauf ist aber auch möglich.

Analog ist im Verlauf B eine Abhängigkeit des ersten Gewichtungswerts W1 und des zweiten Gewichtungswerts W2 von einer Positionierung einer Position P innerhalb des ersten zentralen Gewichtungsbereichs ZG1 bzw. des zweiten zentralen Gewichtungsbereichs ZG2 dargestellt. Bei einer Positionierung der Position P innerhalb des ersten zentralen Gewichtungsbereichs ZG1 nimmt der erste Gewichtungswert W1 den Wert 1 an, während der zweite Gewichtungswert W2 den Wert 0 annimmt. Bei einer Positionierung der Position P innerhalb des zweiten zentralen Gewichtungsbereichs ZG2 nimmt der erste Gewichtungswert W1 den Wert 0 an, während der zweite Gewichtungswert W2 den Wert 1 annimmt. Für eine Positionierung der Position P innerhalb des peripheren Gewichtungsbereichs PG weisen sowohl der erste Gewichtungswert W1 als auch der zweite Gewichtungswert W2 einen linearen Verlauf auf.

Analog stellt der Verlauf C eine Abhängigkeit des zweiten Gewichtungswerts W2 und des dritten Gewichtungswerts W3 von einer Positionierung einer Position P dar. Bei einer Positionierung der Position P im zweiten zentralen Gewichtungsbereich ZG2 weist der zweite Gewichtungswert W2 den Wert 1 auf, während der dritte Gewichtungswert W3 den Wert 0 aufweist. Bei einer Positionierung einer Position P innerhalb des dritten zentralen Gewichtungsbereichs ZG3 weist der zweite Gewichtungswert W2 den Wert 0 auf, während der dritte Gewichtungswert W3 den Wert 3 aufweist. Innerhalb des peripheren Gewichtungsbereichs PG weisen sowohl der zweite Gewichtungswert W2 als auch der dritte Gewichtungswert W3 einen linearen Verlauf auf.

Analog zu den Verläufen A, B, C weisen der dritte Gewichtungswert W3 und der vierte Gewichtungswert W4 eine Abhängigkeit zu einer Positionierung innerhalb der zentralen Gewichtungsbereiche auf. Bei einer Positionierung einer Position P innerhalb des dritten zentralen Gewichtungsbereichs ZG3 weist der dritte Gewichtungswert W3 einen Wert 1 auf, während der vierte Gewichtungswert W4 den Wert 0 aufweist. Bei einer Positionierung der Position P innerhalb des vierten zentralen Gewichtungsbereichs ZG4 weist der dritte Gewichtungswert W3 den Wert 0 auf, während der vierte Gewichtungswert W4 den Wert 1 aufweist.

Alternativ zu dem linearen Verlauf der Gewichtungswerte W1, W2, W3, W4 innerhalb der peripheren Gewichtungsbereiche PG können die Gewichtungswerte W1, W2, W3, W4 einen beliebig ausgestalteten Verlauf aufweisen.

In Fig. 9 nicht dargestellt sind Verläufe zwischen dem ersten geometrischen Zentrum Z1 und dem dritten geometrischen Zentrum Z3, wie zwischen dem zweiten geometrischen Zentrum Z2 und dem vierten geometrischen Zentrum Z4. Derartige Verläufe sind analog zu den in Fig. 9 dargestellten Verläufen ausgebildet, indem im zentral angeordneten peripheren Gewichtungsbereich PG zwischen den ersten bis vierten zentralen Gewichtungsbereiche ZG1, ZG2, ZG3, ZG4 ein linearer Verlauf der jeweiligen Gewichtungswerte auftritt. Für eine Position P innerhalb des zentralen peripheren Gewichtungsbereichs PG zwischen den ersten bis vierten zentralen Gewichtungsbereichen ZG1, ZG2, ZG3, ZG4 nehmen die ersten bis vierten Gewichtungswerte W1, W2, W3, W4 einen von 0 verschiedenen Wert an, sodass alle vier Sensormuster SM1, SM2, SM3, SM4 zur Positionsbestimmung beitragen.

Gemäß den in den Verläufen dargestellten Abhängigkeiten der Werte der Gewichtungswerte W1, W2, W3, W4 zu den Positionierungen einer vorherigen Position P relativ zu den geometrischen Zentren Z1, Z2, Z3, Z4 der Sensormuster SM1, SM2, SM3, SM4 kann für eine Positionsbestimmung eine entsprechende Gewichtung der durch die Magnetfeldsensoren 501 der jeweiligen Sensormuster SM1, SM2, SM3, SM4 bestimmten ersten bis vierten Teilpositionen ermittelt werden, die in die Bestimmung der zu bestimmenden Position gemäß dem gewichteten Mittelwert eingehen, sodass zur Positionsbestimmung die Magnetfeldsensoren 501 des Sensormusters SM1, SM2, SM3, SM4 bevorzugt berücksichtigt werden, dessen geometrisches Zentrum Z1, Z2, Z3, Z4 den geringsten Abstand zur zuvor bestimmten Position P aufweist. Die so durchgeführte Gewichtung stellt sicher, dass die Magnetfeldsensoren 501 bevorzugt berücksichtigt werden, die bereits zur vorangegangenen Position den dominierenden Beitrag erbracht haben.

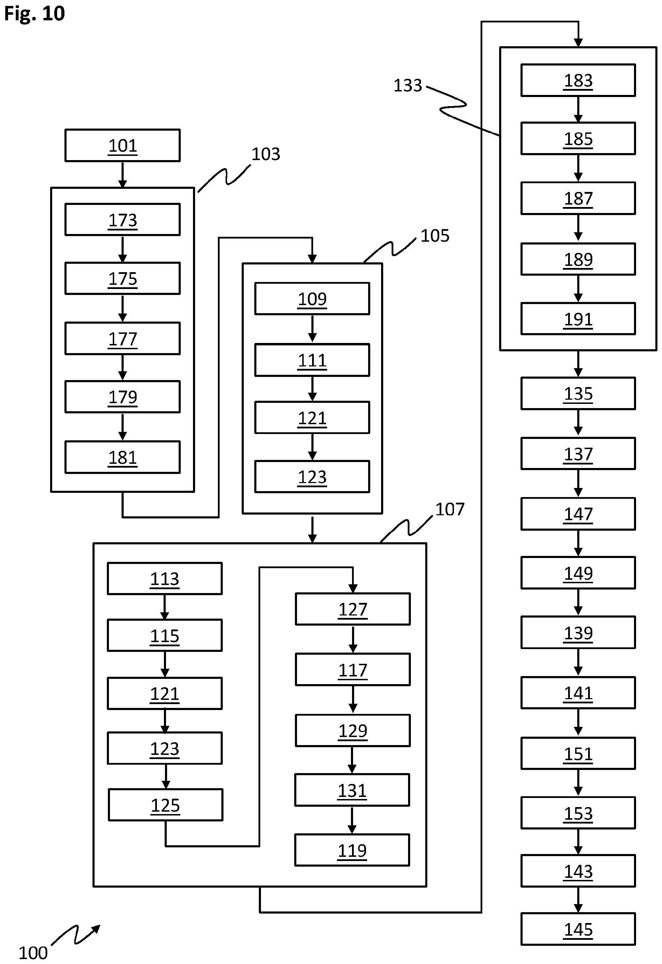

Fig. 10 zeigt ein weiteres Flussdiagramm des Verfahrens 100 zum Steuern eines Planarantriebssystems 200 gemäß einer Ausführungsform.

Die Ausführungsform in Fig. 10 basiert auf der Ausführungsform in Fig. 7 und umfasst alle dort beschriebenen Verfahrensschritte. Soweit diese in der Ausführungsform in Fig. 10 unverändert bleiben, wird auf eine erneute detaillierte Beschreibung verzichtet.

In der Ausführungsform in Fig. 10 umfasst das Verfahren ferner einen Verschiebungsschritt 133, in dem das erste Sensormuster SM1, das zweite Sensormuster SM2, das dritte Sensormuster SM3 und das vierte Sensormuster SM4 entlang der ersten Orientierungsrichtung D1 verschoben werden.

Eine Verschiebung kann vorgenommen werden, falls im Gewichtungsschritt 117 der erste Gewichtungswert W1 oder der zweite Gewichtungswert W2 den Wert 1 und der jeweils andere Gewichtungswert den Wert 0 annehmen. Nimmt ein Gewichtungswert den Wert 0 an, so bestand für die Bestimmung einer vorangegangenen Position P keine Übereinstimmung zwischen der Position P und der Positionierung des jeweiligen Sensormusters. Für eine darauf folgende Positionsbestimmung zu einem späteren Positionsbestimmungszeitpunkt, beispielsweise in einem folgenden Steuerzyklus, einer weiteren Position trägt die auf den Messwerten der Magnetfeldsensoren 501 des jeweiligen Sensormusters SM bestimmte Teilposition nicht zum gewichteten Mittelwert und damit verbunden zur Bestimmung der Position bei.

Für eine wiederum weitere Positionsbestimmung zu einem wiederum späteren Positionsbestimmungszeitpunkt ist somit eine Verschiebung der jeweiligen Sensormuster SM notwendig, um zu gewährleisten, dass bei der wiederum weiteren Positionsbestimmung alle vier Sensormuster SM1, SM2, SM3, SM4 einen Beitrag zur Positionsbestimmung leisten können.

Durch eine Verschiebung eines Sensormusters wird die Positionierung des jeweiligen Sensormusters auf dem Statormodul 300 verändert. Eine Form bzw. Ausgestaltung des Sensormusters kann durch die Verschiebung unverändert bestehen bleiben. Durch die Verschiebung eines Sensormusters wird erreicht, dass andere Magnetfeldsensoren 501 des Sensormoduls 500 von dem verschobenen Sensormuster umfasst sind.

Zur Verschiebung der Sensormuster SM werden zunächst in einem weiteren Magnetfeldsensorbestimmungsschritt 183 ein weiterer erster zentraler Magnetfeldsensor, ein weiterer zweiter zentraler Magnetfeldsensor, ein weiterer dritter zentraler Magnetfeldsensor ein weiterer vierter zentraler Magnetfeldsensor bestimmt, wobei der weitere erste zentrale Magnetfeldsensor, der weitere zweite zentrale Magnetfeldsensor, der weitere dritte zentrale Magnetfeldsensor und der weitere vierte zentrale Magnetfeldsensor zur zweiten Position P2 direkt benachbart sind und die Magnetfeldsensoren 501 mit den kürzesten Abständen zur zweiten Position P2 sind.

In einem weiteren ersten Identifikationsschritt 185 wird eine vorbestimmte Mehrzahl von weiteren ersten Magnetfeldsensoren bestimmt, die den weiteren ersten zentralen Magnetfeldsensor umgeben, und die Mehrzahl von weiteren ersten Magnetfeldsensoren wird als verschobenes erstes Sensormuster identifiziert, wobei der weitere erste zentrale Magnetfeldsensor in einem weiteren ersten geometrischen Zentrum des verschobenen ersten Sensormusters angeordnet ist.

In einem weiteren zweiten Identifikationsschritt 187 wird eine vorbestimmte Mehrzahl von weiteren zweiten Magnetfeldsensoren bestimmt, die den weiteren zweiten zentralen Magnetfeldsensor umgeben, und die Mehrzahl von weiteren zweiten Magnetfeldsensoren wird als verschobenes zweites Sensormuster identifiziert, wobei der weitere zweite zentrale Magnetfeldsensor in einem weiteren zweiten geometrischen Zentrum des verschobenen zweiten Sensormusters angeordnet ist.

In einem weiteren dritten Identifikationsschritt 189 wird eine vorbestimmte Mehrzahl von weiteren dritten Magnetfeldsensoren bestimmt, die den weiteren dritten zentralen Magnetfeldsensor umgeben, und die Mehrzahl von weiteren dritten Magnetfeldsensoren wird als verschobenes drittes Sensormuster identifiziert, wobei der weitere dritte zentrale Magnetfeldsensor in einem weiteren dritten geometrischen Zentrum des verschobenen dritten Sensormusters angeordnet ist.

In einem weiteren vierten Identifikationsschritt 191 wird eine vorbestimmte Mehrzahl von weiteren vierten Magnetfeldsensoren bestimmt, die den weiteren vierten zentralen Magnetfeldsensor umgeben, und die Mehrzahl von weiteren vierten Magnetfeldsensoren wird als verschobenes viertes Sensormuster identifiziert, wobei der weitere vierte zentrale Magnetfeldsensor in einem weiteren vierten geometrischen Zentrum des verschobenen vierten Sensormusters angeordnet ist.

Die Verschiebung der Sensormuster SM wird somit dadurch realisiert, dass die verschobenen Sensormuster auf die zweite Position P2 zentriert werden und diese verschobenen Sensormuster zur Bestimmung der dritten Position verwendet werden.

In einem fünften Läufermagnetfeldteilbestimmungsschritt 135 werden zu einem dritten Positionsbestimmungszeitpunkt weitere erste Messwerte des Läufermagnetfelds durch die Magnetfeldsensoren 501 des verschobenen ersten Sensormusters aufgenommen.

In einem sechsten Läufermagnetfeldteilbestimmungsschritt 137 werden zum dritten Positionsbestimmungszeitpunkt weitere zweite Messwerte des Läufermagnetfelds durch die Magnetfeldsensoren 501 des verschobenen zweiten Sensormusters aufgenommen.

In einem siebten Läufermagnetfeldteilbestimmungsschritt 147 werden zum dritten Positionsbestimmungszeitpunkt weitere dritte Messwerte des Läufermagnetfelds durch die Magnetfeldsensoren 501 des verschobenen dritten Sensormusters gemessen.

In einem achten Läufermagnetfeldteilbestimmungsschritt 149 werden zum dritten Positionsbestimmungszeitpunkt weitere vierte Messwerte des Läufermagnetfelds durch die Magnetfeldsensoren 501 des verschobenen vierten Sensormusters gemessen.

In einem fünften Läuferteildetektionsschritt 139 wird auf Basis der von den Magnetfeldsensoren 501 des verschobenen ersten Sensormusters gemessenen weiteren ersten Messwerte des Läufermagnetfelds der Läufer 400 detektiert und eine weitere erste Teilposition des Läufers 400 bestimmt.

In einem sechsten Läuferteildetektionsschritt 141 werden auf Basis der von den Magnetfeldsensoren 501 des verschobenen zweiten Sensormusters gemessenen weiteren zweiten Messwerte des Läufermagnetfelds der Läufer 400 detektiert und eine weitere zweite Teilposition des Läufers 400 bestimmt.

In einem siebten Läuferteildetektionsschritt 151 werden auf Basis der von den Magnetfeldsensoren 501 des verschobenen dritten Sensormusters gemessenen weiteren dritten Messwerte des Läufermagnetfelds der Läufer 400 detektiert und eine weitere dritte Teilposition des Läufers 400 bestimmt.

In einem achten Läuferteildetektionsschritt 153 werden auf Basis der von den Magnetfeldsensoren 501 des verschobenen vierten Sensormusters gemessenen weitere vierte Messwerte der Läufer 400 detektiert und eine weitere vierte Teilposition des Läufers 400 bestimmt.

In einem weiteren Gewichtungsschritt 143 werden ein weiterer erster Gewichtungswert des verschobenen ersten Sensormusters, ein weiterer zweiter Gewichtungswert des verschobenen zweiten Sensormusters, ein weiterer dritter Gewichtungswert des verschobenen dritten Sensormusters und ein weiterer vierter Gewichtungswert des verschobenen vierten Sensormusters bestimmt.

Analog zu dem in Fig. 9 dargestellten Vorgehen werden die weiteren ersten bis vierten Gewichtungswerte ermittelt, indem Abstände der weiteren ersten bis vierten geometrischen Zentren der verschobenen ersten bis vierten Sensormuster zur zweiten Position P2 ermittelt werden.

In einem weiteren Mittelwertbildungsschritt 145 wird auf Basis der weiteren ersten Teilposition, der weiteren zweiten Teilposition, der weiteren dritten Teilposition, der weiteren vierten Teilposition und unter Berücksichtigung des weiteren ersten Gewichtungswerts, des weiteren zweiten Gewichtungswerts, des weiteren dritten Gewichtungswerts und des weiteren vierten Gewichtungswerts eine dritte Position des Läufers 400 als ein gewichteter Mittelwert bestimmt.

Durch die Verschiebung der ersten bis vierten Sensormuster SM1, SM2, SM3, SM4 entlang einer beliebigen Richtung können somit für beliebige Positionsbestimmungszeitpunkte Positionen P, die der Läufers 400 zu den Positionsbestimmungszeitpunkten auf dem Statormodul 300 einnimmt, und die entlang des Steuerpfads SP des Läufers 400 angeordnet sind, mittels entsprechender Positionsbestimmungen durch entsprechende Messungen der Magnetfeldsensoren 501 der jeweiligen verschobenen ersten bis vierten Sensormuster bestimmt werden. Für jedes Sensormuster wird dabei auf Basis der Messwerte der jeweiligen Magnetfeldsensoren 501 für den jeweiligen Positionsbestimmungszeitpunkt eine Teilposition bestimmt. Diese Teilpositionen werden mit entsprechenden Gewichtungswerten versehen, die darauf basieren, wie weit das jeweilige Sensormuster vor der Verschiebung mit der zuvor bestimmten Position des Läufers 400 übereinstimmt. Auf Basis derart bestimmter Teilpositionen unter Berücksichtigung der entsprechenden Gewichtungswerte kann somit in Form eines gewichteten Mittelwerts für eine beliebige Position des Läufers eine entsprechende Positionsbestimmung durchgeführt werden.

Bei der Verschiebung der einzelnen Sensormuster kann die in Fig. 8 bzw. Fig. 9 dargestellte Anordnung der ersten bis vierten Sensormuster SM1, SM2, SM3, SM4 beibehalten werden, sodass die jeweilige Anordnung simultan um einen entsprechenden Betrag in die jeweilige Verschiebungsrichtung verschoben werden.

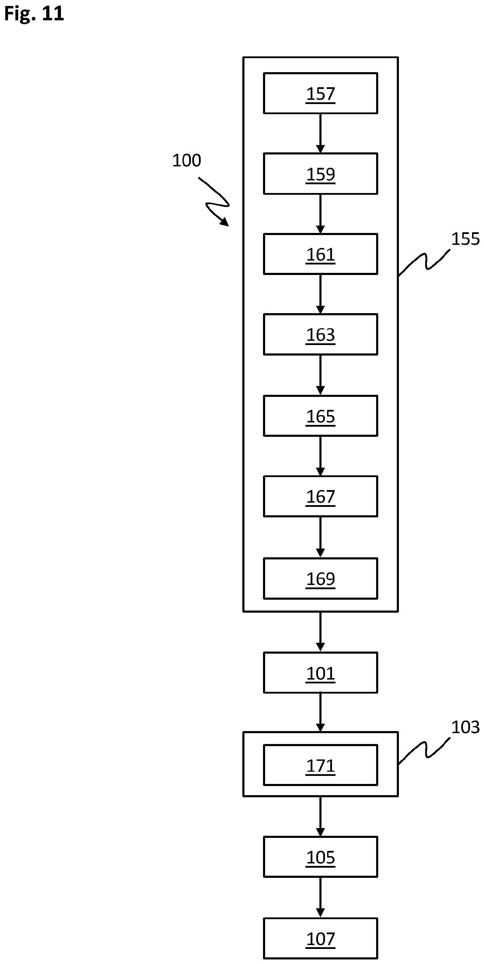

Fig. 11 zeigt ein weiteres Flussdiagramm des Verfahrens 100 zum Steuern eines Planarantriebssystems 200 gemäß einer Ausführungsform.

Die Ausführungsform in Fig. 11 basiert auf der Ausführungsform in Fig. 4 und umfasst alle dort beschriebenen Verfahrensschritte. Sofern diese in der Ausführungsform in Fig. 11 unverändert bleiben, wird von einer erneuten detaillierten Beschreibung abgesehen.

Die Ausführungsform in Fig. 11 umfasst ferner einen Läuferpositionsbestimmungsschritt 155, in dem die erste Position P1 bestimmt wird.

Der Läuferpositionsbestimmungsschritt 155 umfasst hierbei einen Messwertbestimmungsschritt 157, in dem Messwerte der Magnetfeldsensoren 501 des Sensormoduls 500 aufgenommen werden. Hierzu kann beispielsweise jeder Magnetfeldsensor 501 des Sensormoduls 500 der Reihe nach einen entsprechenden Messwert bzw. eine Mehrzahl von Messwerten aufnehmen.

Sobald einer der Magnetfeldsensoren 501, die der Reihe nach jeweils einen bzw. mehrere Messwerte aufnehmen, einen Messwert aufweist, der einen vorbestimmten Grenzwert erreicht oder überschreitet, wird dieser Magnetfeldsensor in einem Magnetfeldsensoridentifikationsschritt 159 identifiziert. Das Überschreiten des vorbestimmten Grenzwerts eines Messwerts eines Magnetfeldsensors 501 des Sensormoduls 500 kann hierbei als eine Detektion eines Läufermagnetfelds eines Läufers 400 auf dem Statormodul 300 interpretiert werden.

Nach Identifikation des zuerst identifizierten Magnetfeldsensors 503 im Magnetfeldsensoridentifikationsschritt 159 werden in einem weiteren Messwertbestimmungsschritt 161 weitere Messwerte von Magnetfeldsensoren des Sensormoduls 500 in direkter Nachbarschaft zum zuerst identifizierten Magnetfeldsensor 503 aufgenommen. Im weiteren Messwertbestimmungsschritt 161 werden ausschließlich die direkt benachbarten Magnetfeldsensoren 505 des zuerst identifizierten Magnetfeldsensors 503 gescannt bzw. werden von diesem entsprechende Messwerte aufgenommen. Weitere Magnetfeldsensoren 501 des Sensormoduls 500 bleiben im weiteren Messwertbestimmungsschritt 161 unberücksichtigt.

In einem weiteren Magnetfeldsensoridentifikationsschritt 163 werden die zum zuerst identifizierten Magnetfeldsensor 503 benachbarten Magnetfeldsensoren 505 identifiziert, deren Messwerte den vorbestimmten Grenzwert erreichen oder überschreiten.

In einem Detektionsmusterbestimmungsschritt 165 wird ein Detektionssensormuster DSM bestimmt, wobei das Detektionssensormuster DSM die identifizierten Magnetfeldsensoren 505 umfasst.

Darauffolgend wird auf Basis der Messwerte der identifizierten Magnetfeldsensoren 505 des Detektionsmusters DSM der Läufer 400 detektiert.

Nach Detektion des Läufers 400 wird in einem Positionsidentifikationsschritt 169 die erste Position P1 des Läufers 400 auf Basis der Positionierungen der identifizierten Magnetfeldsensoren 505 im Statormodul 300 identifiziert.

Zur Identifizierung der ersten Position P1 werden somit die Magnetfeldsensoren 501 des Sensormoduls 500 der Reihe nach gescannt, indem jeder Sensor 501 des Sensormoduls 500 einen Messwert aufnimmt. Sobald ein Magnetfeldsensor 501 identifiziert wird, der einen Messwert aufweist, der einen Wert größer oder gleich eines vorbestimmten Grenzwerts aufweist, so werden alle benachbarten Magnetfeldsensoren 501, die in direkter Nachbarschaft zum identifizierten Magnetfeldsensor 503 angeordnet sind, gescannt, indem Messwerte der benachbarten Magnetfeldsensoren 505 aufgenommen werden. Die benachbarten Magnetfeldsensoren 505, deren Messwerte den vorbestimmten Grenzwert erreichen oder überschreiten, werden als solche identifiziert. Auf Basis der identifizierten Magnetfeldsensoren 505 wird ein Detektionsmuster DSM ermittelt, das einen zusammenhängenden Bereich von Magnetfeldsensoren 501 beschreibt, die jeweils einen Messwert ermittelt haben, der den zuvor bestimmten Grenzwert erreicht oder überschreitet.

Messwerte der Magnetfeldsensoren 501, die den zuvor bestimmten Grenzwert erreichen oder überschreiten, werden als Detektion des Läufermagnetfelds eines auf dem Statormodul 300 platzierten Läufers 400 identifiziert. Durch Bestimmung der Positionierung des Detektionssensormusters DSM auf Basis der Positionierungen der identifizierten Magnetfeldsensoren 505 des Detektionssensormusters DSM wird der Läufer 400 an der Positionierung des Detektionssensormusters DSM detektiert und eine erste Position P1 des Läufers 400 in der Positionierung des Detektionssensormusters DSM bestimmt. Hierdurch kann eine Detektion von Läufern auf dem Statormodul 300 erreicht werden, für die eine exakte Position auf dem Statormodul 300 unbekannt ist. Dies kann insbesondere beim Starten des Planarantriebssystems 200 durchgeführt werden, bei dem exakte Positionen der einzelnen Läufer 400 auf dem Statormodul 300 unbekannt sind.

In der Ausführungsform in Fig. 11 umfasst der Sensormusterbestimmungsschritt 103 zur Bestimmung der zweiten Position P2 ferner einen Geschwindigkeitsermittlungsschritt 171. Im Geschwindigkeitsermittlungsschritt 171 wird eine Geschwindigkeit des Läufers 400 in einer Bewegung des Läufers 400 entlang dem Steuerpfad SP zwischen der ersten Position P1 und der zweiten Position P2 bestimmt. Die Geschwindigkeit kann hierbei einen Geschwindigkeitswert und eine Geschwindigkeitsrichtung umfassen. Auf Basis der Geschwindigkeit kann somit für einen vorbestimmten Zeitpunkt ermittelt werden, in welchem Bereich auf dem Statormodul 300 der Läufer 400 sich befinden wird. Auf Basis dieser Bestimmung kann ein entsprechendes Sensormuster SM ausgewählt werden, um den Läufer 400 in der entsprechend zweiten Position P2 auf Basis der Messwerte der jeweiligen Magnetfeldsensoren 501 des unter Berücksichtigung der Geschwindigkeit des Läufers bestimmten Sensormusters SM zu ermitteln.

Die in Fig. 11 dargestellte Ausführungsform stellt eine alternative Lösung der Sensormusterbestimmung und damit eine alternative Ausführungsform des Verfahrens 100 dar. Insbesondere kann der Läuferpositionsbestimmungsschritt 155 und die von diesem umfassten Teilschritte auch mit den Ausführungsformen der Fig. 4, 6, 7 und 10 kombiniert werden.

Die Positionsbestimmung der einzelnen Positionen bzw. Teilpositionen durch Aufnahme entsprechender Messwerte der Magnetfeldsensoren 501 der einzelnen Sensormuster SM zu entsprechenden Positionsbestimmungszeitpunkten, wie dies in den oben beschriebenen Ausführungsformen dargestellt ist, kann durch ein entsprechend trainiertes neuronales Netz 205 vorgenommen werden. Das entsprechend trainierte neuronale Netz 205 ist hierbei ausgebildet, auf Basis der jeweiligen Messwerte der Magnetfeldsensoren der entsprechenden Sensormuster SM eine Positionierung des Läufers relativ zu den jeweiligen Magnetfeldsensoren 501 zu ermitteln. Auf Basis der Positionierungen der einzelnen Magnetfeldsensoren 501 im Statormodul 300 kann somit eine Positionierung des Läufers 400 relativ zum Statormodul 300 ermittelt werden. Hierzu kann das entsprechend trainierte neuronale Netz 205 jeden Messwert des Läufermagnetfelds durch die Magnetfeldsensoren 501 des entsprechenden Sensormoduls einem dreidimensionalen Raumbereich des Läufermagnetfelds des Läufers 400 zuordnen. Auf Basis der Zuordnungen der einzelnen Messwerte der Magnetfeldsensoren 501 zu einzelnen Raumbereichen des Läufermagnetfelds kann somit eine eindeutige Zuordnung des Läufers 400 zu den jeweiligen Magnetfeldsensoren 501 des Sensormusters SM vorgenommen werden.

Positionsbestimmungen gemäß den oben genannten Verfahrensschritten des Verfahrens 100 können insbesondere in jedem Steuerzyklus des Automatisierungssystems 200 durchgeführt werden. Durch die Verwendung von neuronalen Netzen kann eine Positionsbestimmung gemäß den oben beschriebenen Verfahrensschritten des Verfahrens 100 in Echtzeit durchgeführt werden, sodass in jedem Steuerzyklus eine Positionsbestimmung des Läufers in einer zu bestimmenden Position auf dem Statormodul vorgenommen werden kann. Beispielsweise kann für jeden Läufer 400 des Planarantriebssystems 200 ein individuell trainiertes neuronales Netz verwendet werden.

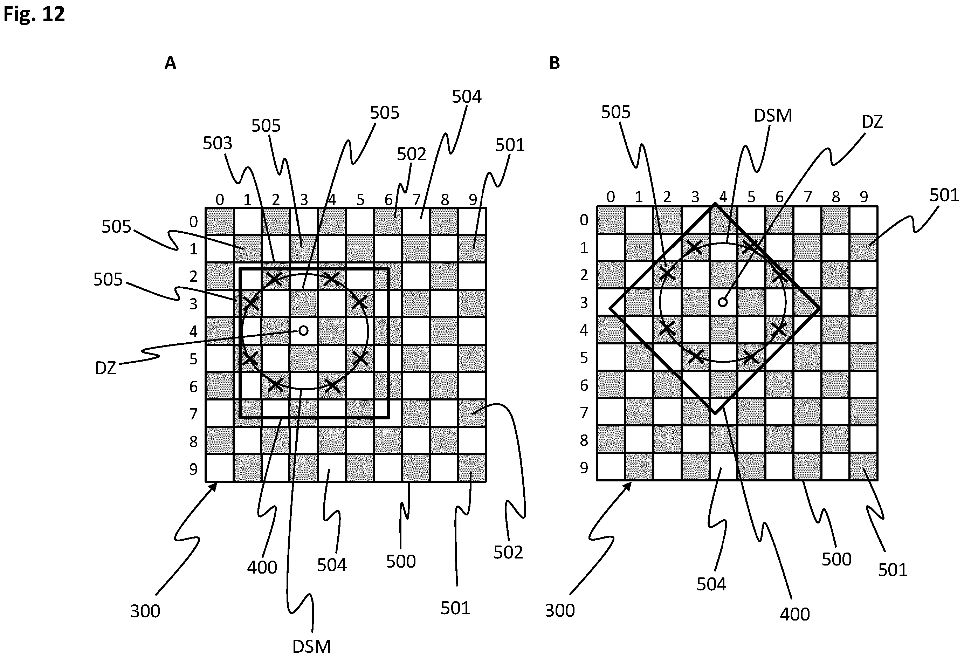

Fig. 12 zeigt eine schematische Darstellung eines Statormoduls 300 mit für eine Positionsbestimmung eines Läufers 400 ausgewählten Magnetfeldsensoren gemäß einer weiteren Ausführungsform.

In Fig. 12 ist eine grafische Darstellung der Positionsbestimmung der ersten Position gemäß der Ausführungsform des Verfahrens 100 in Fig. 11 illustriert. Die Teile A und B der Fig. 12 unterscheiden sich hierbei lediglich durch eine Orientierung des Läufers 400 auf dem Statormodul 300.

In Fig. 12 ist ein Statormodul 300 mit einer Mehrzahl von Magnetfeldsensoren 501 dargestellt, die auf dem Statormodul 300 in einer Schachbrettanordnung angeordnet sind, in der abwechselnd Raumbereiche 502 mit Magnetfeldsensoren 501, in Fig. 12 grau dargestellt, und weitere Raumbereiche 504 ohne Magnetfeldsensoren, in Fig. 12 weiß dargestellt, angeordnet sind. In Fig. 12 ist ferner ein Läufer 400 in quadratischer Form dargestellt.

Zur Positionsbestimmung der ersten Position P1 gemäß der Ausführungsform in Fig. 11 werden nacheinander die Magnetfeldsensoren 501 der mit 0 und 1 gekennzeichneten Spalten gescannt und Messwerte der einzelnen Magnetfeldsensoren 501 aufgenommen. In Spalte 2 wird darauffolgend der zuerst identifizierte Magnetfeldsensor 503 identifiziert, der als erster Magnetfeldsensor des Statormoduls 300 einen Messwert aufweist, der oberhalb des vorbestimmten Grenzwerts liegt. Der gekennzeichnete Magnetfeldsensor 503 ist vom Läufer 400 in der ersten Position bedeckt und misst somit das Läufermagnetfeld des Läufers 400. Darauf folgend werden die direkt benachbarten Magnetfeldsensoren 505 des identifizierten Magnetfeldsensors 503 gescannt. Von diesen direkt benachbarten Magnetfeldsensoren 505 weist der in der Spalte 4 und in Zeile 2 angeordnete Magnetfeldsensor 505 sowie der in der Spalte 1 und in Zeile 3 angeordnete Magnetfeldsensor 505 einen Wert oberhalb des vorbestimmten Grenzwerts auf, da beide Magnetfeldsensoren von dem Läufer 400 bedeckt sind.

Darauffolgend werden weitere Magnetfeldsensoren in direkter Nachbarschaft der hierdurch identifizierten benachbarten Magnetfeldsensoren 505 gescannt und die Magnetfeldsensoren 501 identifiziert, die vom Läufer 400 bedeckt sind und somit einen Messwert oberhalb des vorbestimmten Grenzwerts aufweisen. Hierüber wird im Folgenden das Detektionssensormuster DSM ermittelt, das in Fig. 12 durch die mit dem Kreuz versehenen Magnetfeldsensoren bzw. der diese umgebenden Raumbereiche 502 bestimmt ist. In Fig. 12 ist das Detektionssensormuster DSM kreisförmig ausgebildet. Eine Positionierung des Detektionssensormusters DSM kann über eine Positionierung des Detektionszentrums Z des Detektionssensormusters DSM ermittelt werden. Über die Bestimmung des Detektionssensormusters DSM kann der Läufer 400 in seiner jeweiligen Position detektiert werden. Über die Positionierung des Detektionssensormusters DSM, die der Positionierung des Detektionszentrums Z des Detektionssensormusters DSM entspricht, kann eine Position des Läufers 400 bestimmt und mit der ersten Position P1 identifiziert werden.

In Fig. 12 ist das Verfahren zur Detektion der auf dem Statormodul 300 positionierten Läufer 400 für lediglich einen Läufer 400 beschrieben. Zur Detektion weiterer auf dem Statormodul 300 positionierten Läufer 400 werden die zu Fig. 11 beschriebenen Verfahrensschritte weiter fortgeführt. Hierüber können alle auf dem Statormodul 300 positionierten Läufer 400 detektiert und deren Positionen bestimmt werden.

Das vorliegende Verfahren 100 ist auf eine Mehrzahl von verschiedenen Läufern 400 auf einem Statormodul bzw. auf einer Mehrzahl von aneinandergekoppelter Statormodule 300 anwendbar.

Eine Detektion von Läufern 400 des Planarantriebssystems 200 gemäß dem Läuferpositionsbestimmungsschritt 155 kann insbesondere beim Starten des Planarantriebssystems 200 durchgeführt werden, um eine erste Positionsbestimmung der Läufer 400 des Planarantriebssystems 200 durchzuführen, auf der basierend eine Steuerung der Läufer 400 durchgeführt werden kann. Alternativ kann eine Detektion von Läufern 400 des Planarantriebssystems 200 gemäß dem Läuferpositionsbestimmungsschritt 155 durchgeführt werden, nachdem das Planarantriebssystem 200 beispielsweise aufgrund einer Störung im Betrieb unterbrochen wurde und wieder angesteuert wird. Alternativ kann eine Detektion von Läufern 400 des Planarantriebssystems 200 gemäß dem Läuferpositionsbestimmungsschritt 155 durchgeführt werden, wenn ein neuer Läufer 400 in das System eingeführt wird. Alternativ kann eine Detektion von Läufern 400 des Planarantriebssystems 200 gemäß dem Läuferpositionsbestimmungsschritt 155 zu einem beliebigen Zeitpunkt durchgeführt werden, beispielsweise wenn eine fehlerhafte Positionsbestimmung eines oder mehrerer Läufer 400 ermittelt wurde.

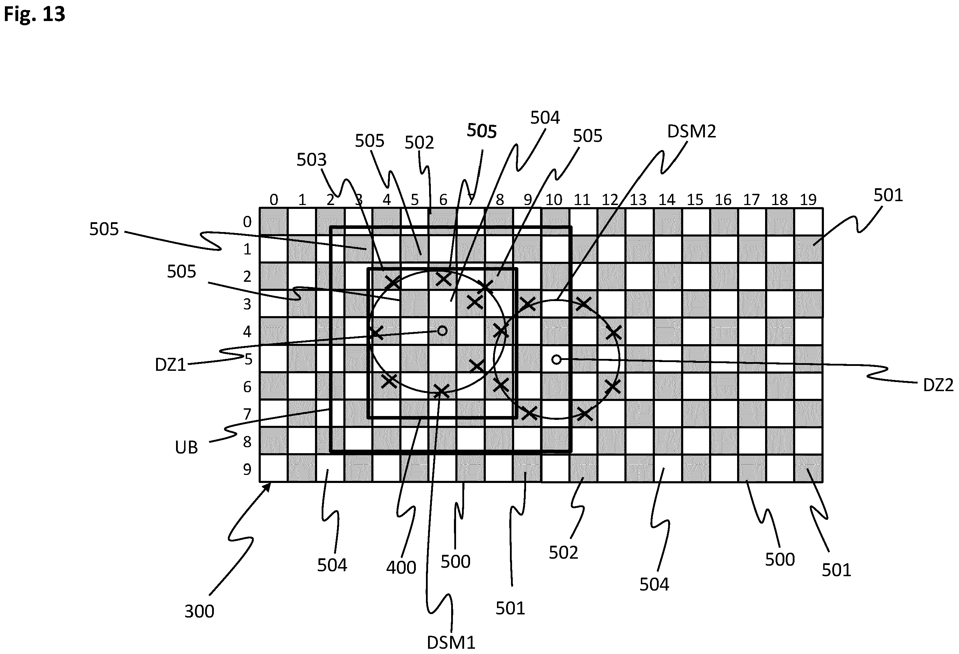

Fig. 13 zeigt eine weitere schematische Darstellung eines Statormoduls 300 mit für eine Positionsbestimmung eines Läufers 400 ausgewählten Magnetfeldsensoren gemäß einer weiteren Ausführungsform.

In Fig. 13 ist der Fall dargestellt, dass nach einer Detektion eines Läufers 400 gemäß dem zu Fig. 12 beschriebenen Verfahren 100 weitere Läufer detektiert werden sollen.

In Fig. 13 wird dies anhand eines Läufers 400, der mittels eines, wie oben bestimmten, ersten Detektionssensormusters DSM1 mit einem ersten Detektionszentrum DZ1 detektiert wurde.

Bei erneutem Ausführen des Läuferpositionsbestimmungsschritts 155 wurde gemäß den Teilschritten des Läuferpositionsbestimmungsschritt 155 ein zweites Detektionssensormuster DSM2 mit einem zweiten Detektionszentrums DZ2 detektiert.

Zur Detektion einer Mehrzahl von Läufern kann der Läuferpositionsbestimmungsschritt 155 mit allen umfassenden Teilschritten, wie oben beschrieben, mehrfach durchgeführt werden.

Um zu vermeiden, dass bei mehrfachem Ausführen des Läuferpositionsbestimmungsschritt 155 bereits detektierte Läufer 400 erneut detektiert werden, wird um die Position des bereits detektierten Läufers 400 ein Umgebungsbereich UB definiert. Der Umgebungsbereich UB, der in der Ausführungsform in Fig. 13 um das erste Detektionszentrum DZ1 des ersten Detektionssensormusters DSM1 angeordnet ist, beschreibt einen Bereich, der für erneute Detektionen weiterer Läufer gesperrt ist. Messwerte von Magnetfeldsensoren 501, die in diesem Bereich angeordnet sind, werden bei erneuter Messung als Messwerte des Läufermagnetfelds des bereits detektierten Läufers 400 interpretiert. Der Umgebungsbereich UB ergibt sich aus den Ausmaßen der Läufer 400, die bewirken, dass zentrale Punkte der Läufer 400, die im Läuferpositionsbestimmungsschritt 155 mit den Detektionszentren DZ1 identifiziert werden, mit einem Mindestabstand zueinander beabstandet sein müssen, da ein geringerer Abstand einem Aufeinanderliegen der beiden Läufer 400 entsprechen würde.

Bei erneutem Ausführen des Läuferpositionsbestimmungsschritts 155 wird somit für eine zweites Detektionssensormuster DSM2 mit einem entsprechenden zweiten Detektionszentrum DZ2, die jeweils gemäß dem Läuferpositionsbestimmungsschritt 155 ermittelt wurden, bestimmt, ob das zweite Detektionszentrum DZ2 innerhalb des Umgebungsbereichs UB des detektierten Läufers 400 angeordnet ist. Ist dies, wie in Fig. 13 gezeigt, der Fall, werden die durch die Magnetfeldsensoren 501 des zweiten Detektionssensormuster DSM2 aufgenommenen Messwerte verworfen beziehungsweise dem Läufermagnetfeld des bereits detektierten Läufers 400 zugeordnet.

Für den in Fig. 13 nicht dargestellten Fall, dass das ein weiteres Detektionszentrum außerhalb des Umgebungsbereichs UB angeordnet ist, wird diesem weiteren Detektionssensormuster ein weiterer Läufer zugeordnet, der hierdurch detektiert ist und für den eine dem jeweiligen Detektionszentrum des weiteren Detektionssensormusters entsprechende Position zugeordnet ist.

Bezugszeichenliste

| | |
|---|---|
| 100 | Verfahren zum Steuern eines Planarantriebssystems |
| 101 | Steuerschritt |
| 103 | Sensormusterbestimmungsschritt |
| 105 | Läufermagnetfeldbestimmungsschritt |
| 107 | Positionsbestimmungsschritt |
| 109 | erster Läufermagnetfeldteilbestimmungsschritt |
| 111 | zweiter Läufermagnetfeldteilbestimmungsschritt |
| 113 | erster Läuferteildetektionsschritt |
| 115 | zweiter Läuferteildetektionsschritt |
| 117 | Gewichtungsschritt |
| 119 | Mittelwertbildungsschritt |
| 121 | dritter Läufermagnetfeldteilbestimmungsschritt |
| 123 | vierter Läufermagnetfeldteilbestimmungsschritt |
| 125 | dritter Läuferteildetektionsschritt |
| 127 | vierter Läuferteildetektionsschritt |
| 129 | Übereinstimmungsbestimmungsschritt |
| 131 | Gewichtungswertidentifikationsschritt |
| 133 | Verschiebungsschritt |
| 135 | fünfter Läufermagnetfeldteilbestimmungsschritt |
| 137 | sechster Läufermagnetfeldteilbestimmungsschritt |
| 139 | fünfter Läuferteildetektionsschritt |
| 141 | sechster Läuferteildetektionsschritt |
| 143 | weiterer Gewichtungsschritt |
| 145 | weiterer Mittelwertbildungsschritt |
| 147 | siebter Läufermagnetfeldteilbestimmungsschritt |
| 149 | achter Läufermagnetfeldteilbestimmungsschritt |
| 151 | siebter Läuferteildetektionsschritt |
| 153 | achter Läuferteildetektionsschritt |
| 155 | Läuferpositionsbestimmungsschritt |
| 157 | Messwertbestimmungsschritt |
| 159 | Magnetfeldsensoridentifikationsschritt |
| 161 | weiterer Messwertbestimmungsschritt |
| 163 | weiterer Magnetfeldsensoridentifikationsschritt |
| 165 | Detektionsmusterbestimmungsschritt |
| 167 | Läuferdetektionsschritt |
| 169 | Positionsidentifikationsschritt |
| 171 | Geschwindigkeitsermittlungsschritt |
| 173 | Magnetfeldsensorbestimmungsschritt |
| 175 | erster Identifikationsschritt |
| 177 | zweiter Identifikationsschritt |
| 179 | dritter Identifikationsschritt |
| 181 | vierter Identifikationsschritt |
| 183 | weiterer Magnetfeldsensorbestimmungsschritt |
| 185 | weiterer erster Identifikationsschritt |
| 187 | weiterer zweiter Identifikationsschritt |
| 189 | weiterer dritter Identifikationsschritt |
| 191 | weiterer vierter Identifikationsschritt |
| | |
| 200 | Planarantriebssystem |
| 201 | Steuereinheit |
| 203 | Datenverbindung |

205 neuronales Netz

300 Statormodul
301 Träger
303 Statoroberfläche
305 Statormodulgehäuse
307 Statoreinheit
309 Statorleiter
311 Statorleiterzwischenraum
313 Schnittebene

400 Läufer
401 Magnetanordnung
402 Läufermagnetfeld
403 Freifläche
405 Befestigungsstruktur
407 erste Läuferrichtung
409 zweite Läuferrichtung
411 dritte Läuferrichtung
412 Magneteinheit
413 erste Magneteinheit
415 zweite Magneteinheit
417 dritte Magneteinheit
419 vierte Magneteinheit
420 Positionsbereich
421 erster Positionsbereich
422 zweiter Positionsbereich
423 Bewegungsspur
425 Magnetisierungseinheit

500 Sensormodul
501 Magnetfeldsensor
502 Raumbereich
503 zuerst identifizierter Magnetfeldsensor
504 weiterer Raumbereich
505 benachbarter Magnetfeldsensor
507 erste Richtung
509 zweite Richtung
511 erster zentraler Magnetfeldsensor
512 zweiter zentraler Magnetfeldsensor
513 dritter zentraler Magnetfeldsensor
514 vierter zentraler Magnetfeldsensor

SP Steuerpfad

P Position des Läufers
P1 erste Position
P2 zweite Position

SM Sensormuster
SM1 erstes Sensormuster
SM2 zweites Sensormuster
SM3 drittes Sensormuster
SM4 viertes Sensormuster
DSM Detektionssensormuster

D1 erste Orientierungsrichtung
D2 zweite Orientierungsrichtung

W1 erster Gewichtungswert
W2 zweiter Gewichtungswert
W3 dritter Gewichtungswert
W4 vierter Gewichtungswert

Z geometrisches Zentrum
Z1 erstes geometrisches Zentrum
Z2 zweites geometrisches Zentrum
Z3 drittes geometrisches Zentrum
Z4 viertes geometrisches Zentrum

DZ Detektionszentrum
DZ1 erstes Detektionszentrum
DZ2 zweites Detektionszentrum
UB Umgebungsbereich

ZG1 erster zentraler Gewichtungsbereich
ZG2 zweiter zentraler Gewichtungsbereich
ZG3 dritter zentraler Gewichtungsbereich
ZG4 vierter zentraler Gewichtungsbereich

PG peripherer Gewichtungsbereich

## Patentansprüche

1. Verfahren (100) zum Steuern eines Planarantriebssystems (200), wobei das Planarantriebssystem (200) wenigstens eine Steuereinheit (201), ein Statormodul (300) und einen Läufer (400) umfasst, wobei der Läufer (400) über eine magnetische Kopplung zwischen einem Läufermagnetfeld des Läufers (400) und einem Statormagnetfeld des Statormoduls (300) steuerbar ist, wobei das Statormodul (300) zum Bestimmen einer Position des Läufers (400) ein Sensormodul (500) mit einer Mehrzahl von Magnetfeldsensoren (501) umfasst, und wobei jeder Magnetfeldsensor (501) eingerichtet ist, für einen Raumbereich das Läufermagnetfeld zu bestimmen, **gekennzeichnet durch** die folgenden Verfahrensschritte:

   Steuern des Läufers (400) entlang eines Steuerpfads (SP) ausgehend von einer ersten Position (P1) auf dem Statormodul (300), in einem Steuerschritt (101);
   Bestimmen eines Sensormusters (SM) der Magnetfeldsensoren (501) des Sensormoduls (500) in einem Sensormusterbestimmungsschritt (103), wobei ein Sensormuster (SM) eine Teilmenge der Magnetfeldsensoren (501) des Sensormoduls (500) des Statormoduls (300) umfasst, wobei das Sensormodul (500) wenigstens einen Magnetfeldsensor (501) umfasst, der nicht vom Sensormuster (SM) umfasst ist, und wobei eine Fläche des Sensormusters (SM) vom Läufer in einer Position entlang des Steuerpfads wenigstens teilweise abgedeckt ist, wobei das Sensormuster (SM) wenigstens ein erstes Sensormuster (SM1) und ein zweites Sensormuster (SM2) umfasst, wobei das erste Sensormuster (SM1) und das zweite Sensormuster (SM2) in eine erste Orientierungsrichtung (D1) gegeneinander verschoben sind, wobei der Sensormusterbestimmungsschritt (103) umfasst:

   Bestimmen eines ersten zentralen Magnetfeldsensors (511) und Bestimmen eines zweiten zentralen Magnetfeldsensors (512) in einem Magnetfeldsensorbestimmungsschritt (173), wobei der erste zentrale Magnetfeldsensor (511) und der zweite zentrale Magnetfeldsensor (512) zur ersten Position (P1) direkt benachbart sind und kürzeste Abstände zur ersten Position (P1) aufweisen;
   Ermitteln einer vorbestimmten Mehrzahl von ersten Magnetfeldsensoren, die den ersten zentralen Magnetfeldsensor (511) umgeben, und Identifizieren der Mehrzahl von ersten Magnetfeldsensoren als erstes Sensormuster (SM1) in einem ersten Identifikationsschritt (175), wobei der erste zentrale Magnetfeldsensor (511) in einem ersten geometrischen Zentrum (Z1) des ersten Sensormusters (SM1) angeordnet ist;
   Ermitteln einer vorbestimmten Mehrzahl von zweiten Magnetfeldsensoren, die den zweiten zentralen Magnetfeldsensor (512) umgeben, und Identifizieren der Mehrzahl von zweiten Magnetfeldsensoren als zweites Sensormuster (SM2) in einem zweiten Identifikationsschritt (177), wobei der zweite zentrale Magnetfeldsensor (512) in einem zweiten geometrischen Zentrum (Z2) des zweiten Sensormusters (SM2) angeordnet ist;
Messen von Messwerten des Läufermagnetfelds durch die Magnetfeldsensoren (501) des Sensormusters (SM) in einem Läufermagnetfeldbestimmungsschritt (105), wobei der Läufermagnetfeldbestimmungsschritt (105) umfasst:

Messen von ersten Messwerten des Läufermagnetfelds durch die Magnetfeldsensoren (501) des ersten Sensormusters (SM1) in einem ersten Läufermagnetfeldteilbestimmungsschritt (109);
Messen von zweiten Messwerten des Läufermagnetfelds durch die Magnetfeldsensoren (501) des zweiten Sensormusters (SM2) in einem zweiten Läufermagnetfeldteilbestimmungsschritt (111);
Detektieren des Läufers (400) und Bestimmen einer zweiten Position (P2) des Läufers (400) auf Basis der von den Magnetfeldsensoren (501) des Sensormusters (SM) gemessenen Messwerte des Läufermagnetfelds in einem Positionsbestimmungsschritt (107), wobei der Positionsbestimmungsschritt (107) umfasst:

Detektieren des Läufers (400) und Bestimmen einer ersten Teilposition des Läufers (400) auf Basis der von den Magnetfeldsensoren (501) des ersten Sensormusters (SM1) gemessenen ersten Messwerte des Läufermagnetfelds in einem ersten Läuferteildetektionsschritt (113);
Detektieren des Läufers (400) und Bestimmen einer zweiten Teilposition des Läufers (400) auf Basis der von den Magnetfeldsensoren (501) des zweiten Sensormusters (SM2) gemessenen Messwerte des Läufermagnetfelds in einem zweiten Läuferteildetektionsschritt (115);
Bestimmen eines ersten Gewichtungswerts des ersten Sensormusters (SM1) und eines zweiten Gewichtungswerts des zweiten Sensormuster (SM2) in einem Gewichtungsschritt (117); und
Bestimmen der zweiten Position (P2) des Läufers (400) als einen gewichteten Mittelwert aus der ersten Teilposition und der zweiten Teilposition unter Berücksichtigung des ersten Gewichtungswerts und des zweiten Gewichtungswerts in einem Mittelwertbildungsschritt (119).

2. Verfahren nach Anspruch 1, wobei das Sensormuster (SM) ferner ein drittes Sensormuster (SM3) und ein viertes Sensormuster (SM4) umfasst, wobei das dritte Sensormuster (SM3) und das vierte Sensormuster (SM4) in eine zur ersten Orientierungsrichtung (D1) senkrecht orientierte zweite Orientierungsrichtung (D2) gegeneinander verschoben sind wobei der Sensormusterbestimmungsschritt (103) umfasst:

Bestimmen eines dritten zentralen Magnetfeldsensors (513) und Bestimmen eines vierten zentralen Magnetfeldsensors (514) im Magnetfeldsensorbestimmungsschritt (173), wobei der dritte zentrale Magnetfeldsensor (513) und der vierte zentrale Magnetfeldsensor (514) zur ersten Position (P1) direkt benachbart sind und kürzeste Abstände zur ersten Position (P1) aufweisen;
Ermitteln einer vorbestimmten Mehrzahl von dritten Magnetfeldsensoren, die den dritten zentralen Magnetfeldsensor (513) umgeben, und Identifizieren der Mehrzahl von dritten Magnetfeldsensoren als drittes Sensormuster (SM3) in einem dritten Identifikationsschritt (179), wobei der dritte zentrale Magnetfeldsensor (513) in einem dritten geometrischen Zentrum (Z3)des dritten Sensormusters (SM3) angeordnet ist; und Ermitteln einer vorbestimmten Mehrzahl von vierten Magnetfeldsensoren, die den vierten zentralen Magnetfeldsensor (514) umgeben, und Identifizieren der Mehrzahl von vierten Magnetfeldsensoren als viertes Sensormuster (SM4) in einem vierten Identifikationsschritt (181), wobei der vierte zentrale Magnetfeldsensor (514) in einem vierten geometrischen Zentrum (Z4) des vierten Sensormusters (SM4) angeordnet ist, und wobei der Läufermagnetfeldbestimmungsschritt (105) umfasst:

Messen von dritten Messwerten des Läufermagnetfelds durch die Magnetfeldsensoren (501) des dritten Sensormusters (SM3) in einem dritten Läufermagnetfeldteilbestimmungsschritt (121);
Messen von vierten Messwerten des Läufermagnetfelds durch die Magnetfeldsensoren (501) des vierten Sensormusters (SM4) in einem vierten Läufermagnetfeldteilbestimmungsschritt (123);
wobei der Positionsbestimmungsschritt (107) umfasst:

Detektieren des Läufers (400) und Bestimmen einer dritten Teilposition des Läufers (400) auf Basis der von den Magnetfeldsensoren (501) des dritten Sensormusters (SM3) gemessenen dritten Messwerte des Läufermagnetfelds in einem dritten Läuferteildetektionsschritt (125);
Detektieren des Läufers (400) und Bestimmen einer vierten Teilposition des Läufers (400) auf Basis der von den Magnetfeldsensoren (501) des vierten Sensormusters (SM4) gemessenen vierten Messwerte des Läufermagnetfelds in einem vierten Läuferteildetektionsschritt (127);
Bestimmen eines dritten Gewichtungswerts des dritten Sensormusters (SM3) und eines vierten Gewichtungswerts des vierten Sensormuster (SM4) im Gewichtungsschritt (117); und
Bestimmen der zweiten Position (P2) des Läufers (400) als einen gewichteten Mittelwert aus der ersten Teilposition, der zweiten Teilposition, der dritten Teilposition und der vierten Teilposition unter Berücksichtigung des ersten Gewichtungswert, des zweiten Gewichtungswerts, des dritten Gewichtungswerts und vierten Gewichtungswerts im Mittelwertbildungsschritt (119).

3. Verfahren nach Anspruch 2, ferner umfassend:
Bestimmen eines ersten Übereinstimmungswerts der ersten Position (P1) des Läufers (400) auf dem Statormodul (300) mit einer ersten Positionierung des ersten Sensormusters (SM1) auf dem Statormodul (300) und Bestimmen eines zweiten Übereinstimmungswerts der ersten Position (P1) des Läufers (400) auf dem Statormodul (300) mit einer zweiten Positionierung des zweiten Sensormusters (SM2) auf dem Statormodul (300) und/oder Bestimmen eines dritten Übereinstimmungswerts der ersten Position (P1) des Läufers (400) auf dem Statormodul (300) mit einer dritten Positionierung des dritten Sensormusters (SM3) auf dem Statormodul (300) und Bestimmen eines vierten Übereinstimmungswerts der ersten Position des Läufers (400) auf dem Statormodul (300) mit einer vierten Positionierung des vierten Sensormusters (SM4) auf dem Statormodul (300) in einem Übereinstimmungsbestimmungsschritt (129), wobei ein Übereinstimmungswert bei Übereinstimmung der ersten Position (P1) des Läufers (400) mit einer Positionierung eines Sensormusters (SM) den Wert 1, bei fehlender Übereinstimmung der ersten Position des Läufers (400) mit einer Positionierung eines Sensormusters (SM) den Wert 0 und bei Teilübereinstimmung der ersten Position (P1) des Läufers (400) mit einer Positionierung eines Sensormusters (SM) eine beliebigen Wert zwischen 1 und 0 annimmt; und Identifizieren des ersten Gewichtungswerts mit dem ersten Übereinstimmungswert und Identifizieren des zweiten Gewichtungswerts mit dem zweiten Übereinstimmungswert und/oder Identifizieren des dritten Gewichtungswerts mit dem dritten Übereinstimmungswert und Identifizieren des vierten Gewichtungswerts mit dem vierten Übereinstimmungswert in einem Gewichtungswertidentifikationsschritt (131).

4. Verfahren nach Anspruch 2, wobei eine Übereinstimmung der ersten Position (P1) des Läufers (400) auf dem Statormodul (300) mit einer Positionierung eines Sensormusters (SM1) vorliegt, falls ein Abstand der ersten Position (P1) des Läufers (400) zu einem ausgezeichneten Punkt des Sensormusters (SM) kleiner oder gleich einem ersten vorbestimmten Grenzwert ist, wobei keine Übereinstimmung der ersten Position (P1) des Läufers (400) auf dem Statormodul (300) mit einer Positionierung eines Sensormusters (SM1) vorliegt, falls ein Abstand der ersten Position des Läufers (400) zu dem ausgezeichneten Punkt des Sensormusters (SM1) größer gleich einem zweiten vorbestimmten Grenzwert ist, und wobei eine Teilübereinstimmung der ersten Position (P1) des Läufers (400) auf dem Statormodul (300) mit der Positionierung des Sensormusters (SM) vorliegt, falls der Abstand der ersten Position (P1) des Läufers (400) zum ausgezeichneten Punkt des Sensormusters (SM) größer als der erste vorbestimmte Grenzwert und kleiner als der zweite vorbestimmte Grenzwert ist.

5. Verfahren nach Anspruch 4, wobei der ausgezeichnete Punkt des Sensormusters (SM) durch ein geometrisches Zentrum (Z) des Sensormusters (SM) definiert ist.

6. Verfahren nach einem der voranstehenden Ansprüche, ferner umfassend:

Verschieben des ersten Sensormusters (SM1) und des zweiten Sensormusters (SM2) entlang der ersten Orientierungsrichtung (D1) und Bestimmen eines verschobenen ersten Sensormusters (SM1) und eines verschobenen zweiten Sensormusters (SM2) in einem Verschiebungsschritt (133);
Messen von weiteren ersten Messwerten des Läufermagnetfelds durch die Magnetfeldsensoren (501) des verschobenen ersten Sensormusters in einem fünften Läufermagnetfeldteilbestimmungsschritt (135);
Messen von weiteren zweiten Messwerten des Läufermagnetfelds durch die Magnetfeldsensoren (501) des verschobenen zweiten Sensormusters in einem sechsten Läufermagnetfeldteilbestimmungsschritt (137);
Detektieren des Läufers (400) und Bestimmen einer weiteren ersten Teilposition des Läufers (400) auf Basis der von den Magnetfeldsensoren (501) des verschobenen ersten Sensormusters gemessenen weiteren ersten Messwerte des Läufermagnetfelds in einem fünften Läuferteildetektionsschritt (139);
Detektieren des Läufers (400) und Bestimmen einer weiteren zweiten Teilposition Läufers (400) auf Basis der von den Magnetfeldsensoren (501) des verschobenen zweiten Sensormusters gemessenen weiteren zweiten Messwerte des Läufermagnetfelds in einem sechsten Läuferteildetektionsschritt (141);
Bestimmen eines weiteren ersten Gewichtungswerts des verschobenen ersten Sensormusters und eines weiteren zweiten Gewichtungswerts des verschobenen zweiten Sensormuster in einem weiteren Gewichtungsschritt (143); und
Bestimmen einer dritten Position des Läufers (400) als einen gewichteten Mittelwert aus der weiteren ersten Teilposition und der weiteren zweiten Teilposition unter Berücksichtigung des weiteren ersten Gewichtungswerts und des weiteren zweiten Gewichtungswerts in einem weiteren Mittelwertbildungsschritt (145).

7. Verfahren nach Anspruch 6, ferner umfassend:

Verschieben des dritten Sensormusters (SM3) und des vierten Sensormusters (SM4) entlang der ersten Orientierungsrichtung (D1) und Bestimmen eines verschobenen dritten Sensormusters und eines verschobenen vierten Sensormusters im Verschiebungsschritt (133);

Messen von weiteren dritten Messwerten des Läufermagnetfelds durch die Magnetfeldsensoren (501) des verschobenen dritten Sensormusters in einem siebten Läufermagnetfeldteilbestimmungsschritt (147);

Messen von weiteren vierten Messwerten des Läufermagnetfelds durch die Magnetfeldsensoren (501) des verschobenen vierten Sensormusters in einem achten Läufermagnetfeldteilbestimmungsschritt (149);

Detektieren des Läufers (400) und Bestimmen einer weiteren dritten Teilposition des Läufers (400) auf Basis der von den Magnetfeldsensoren (501) des verschobenen dritten Sensormusters gemessenen weiteren dritten Messwerte des Läufermagnetfelds in einem siebten Läuferteildetektionsschritt (151);

Detektieren des Läufers (400) und Bestimmen einer weiteren vierten Teilposition Läufers (400) auf Basis der von den Magnetfeldsensoren (501) des verschobenen vierten Sensormusters gemessenen weiteren vierten Messwerte des Läufermagnetfelds in einem achten Läuferteildetektionsschritt (153);

Bestimmen eines weiteren dritten Gewichtungswerts des verschobenen dritten Sensormusters und eines weiteren vierten Gewichtungswerts des verschobenen vierten Sensormuster im weiteren Gewichtungsschritt (143); und

Bestimmen der dritten Position des Läufers (400) als einen gewichteten Mittelwert aus der weiteren ersten Teilposition, der weiteren zweiten Teilposition, der weiteren dritten Teilposition und der weiteren vierten Teilposition unter Berücksichtigung des weiteren ersten Gewichtungswerts, des weiteren zweiten Gewichtungswerts, des weiteren dritten Gewichtungswerts und des weiteren vierten Gewichtungswerts im weiteren Mittelwertbildungsschritt (145).

8. Verfahren nach Anspruch 6 oder 7, wobei der Verschiebungsschritt (133) umfasst:

Bestimmen eines weiteren ersten zentralen Magnetfeldsensors und Bestimmen eines weiteren zweiten zentralen Magnetfeldsensors und/oder Bestimmen eines weiteren dritten zentralen Magnetfeldsensors und Bestimmen eines weiteren vierten zentralen Magnetfeldsensors in einem weiteren Magnetfeldsensorbestimmungsschritt (183), wobei der weitere erste zentrale Magnetfeldsensor und der weitere zweite zentrale Magnetfeldsensor und/oder der weitere dritte zentrale Magnetfeldsensor und der weitere vierte zentrale Magnetfeldsensor zur zweiten Position (P2) direkt benachbart sind und kürzeste Abstände zur zweiten Position (P2) aufweisen;

Ermitteln einer vorbestimmten Mehrzahl von weiteren ersten Magnetfeldsensoren, die den weiteren ersten zentralen Magnetfeldsensor umgeben und Identifizieren der Mehrzahl von weiteren ersten Magnetfeldsensoren als verschobenes erstes Sensormuster in einem weiteren ersten Identifikationsschritt (185), wobei der weitere erste zentrale Magnetfeldsensor in einem weiteren ersten geometrischen Zentrum des verschobenen ersten Sensormusters angeordnet ist;

Ermitteln einer vorbestimmten Mehrzahl von weiteren zweiten Magnetfeldsensoren, die den weiteren zweiten zentralen Magnetfeldsensor umgeben, und Identifizieren der Mehrzahl von weiteren zweiten Magnetfeldsensoren als zweites verschobenes Sensormuster in einem weiteren zweiten Identifikationsschritt (187), wobei der weiter zweite zentrale Magnetfeldsensor in einem weiteren zweiten geometrischen Zentrum des verschobenen zweiten Sensormusters angeordnet ist; und/oder Ermitteln einer vorbestimmten Mehrzahl von weiteren dritten zentralen Magnetfeldsensoren, die den weiteren dritten Magnetfeldsensor umgeben, und Identifizieren der Mehrzahl von weiteren dritten Magnetfeldsensoren als verschobenes drittes Sensormuster in einem weiteren dritten Identifikationsschritt (189), wobei der weitere dritte zentrale Magnetfeldsensor in einem weiteren dritten geometrischen Zentrum des verschobenen dritten Sensormusters angeordnet ist; und Ermitteln einer vorbestimmten Mehrzahl von weiteren vierten Magnetfeldsensoren, die den weiteren vierten zentralen Magnetfeldsensor umgeben, und Identifizieren der Mehrzahl von weiteren vierten Magnetfeldsensoren als verschobenes viertes Sensormuster in einem weiteren vierten Identifikationsschritt (191), wobei der weitere vierte zentrale Magnetfeldsensor in einem weiteren vierten geometrischen Zentrum des verschobenen vierten Sensormusters angeordnet ist.

9. Verfahren nach Anspruch 6, 7 oder 8, wobei der weitere erste Gewichtungswert einem Übereinstimmungswert zwischen der zweiten Position (P2) des Läufers (400) und einer Positionierung des ersten Sensormusters (SM1) entspricht, wobei der weitere zweite Gewichtungswert einem Übereinstimmungswert zwischen der zweiten Position (P2) des Läufers (400) und einer Positionierung des zweiten Sensormusters (SM2) entspricht, wobei der weitere dritte Gewichtungswert einem Übereinstimmungswert zwischen der zweiten Position (P2) des Läufers (400) und einer Positionierung des dritten Sensormusters (SM3) entspricht, und wobei der weitere vierte Gewichtungswert einem Übereinstimmungswert zwischen der zweiten Position (P2) des Läufers (400) und einer Positionierung des vierten Sensormusters (SM4) entspricht.

10. Verfahren nach einem der voranstehenden Ansprüche, ferner umfassend:

Bestimmen der ersten Position (P1) des Läufers (400) auf dem Statormodul (300) in einem Läuferpositionsbestimmungsschritt (155);
wobei der Läuferpositionsbestimmungsschritt umfasst (155):

Aufnehmen von Messwerten von Magnetfeldsensoren (501) des Sensormoduls (500) in einem Messwertbestimmungsschritt (157);
Identifizieren eines Magnetfeldsensors (503) des Sensormoduls (500), dessen Messwert einen vorbestimmten Grenzwert erreicht oder überschreitet, in einem Magnetfeldsensoridentifikationsschritt (159);
Aufnehmen von Messwerten von Magnetfeldsensoren (504) des Sensormoduls (500) in direkter Nachbarschaft zum zuerst identifizierten Magnetfeldsensor (503) in einem weiteren Messwertbestimmungsschritt (161);
Identifizieren der Magnetfeldsensoren (504) in direkter Nachbarschaft zum zuerst identifizierten Magnetfeldsensor (503), deren Messwerte den vorbestimmten Grenzwert erreichen oder überschreiten, in einem weiteren Magnetfeldsensoridentifikationsschritt (163);
Bestimmen eines Detektionssensormusters (DSM) in einem Detektionsmusterbestimmungsschritt (165), wobei ein Detektionssensormuster (DSM) identifizierte Magnetfeldsensoren (504) umfasst;
Detektieren des Läufers (400) auf Basis der Messwerte der Magnetfeldsensoren (504) des Detektionssensormusters (DSM) in einem Läuferdetektionsschritt (167); und
Identifizieren der ersten Position (P1) des Läufers (400) auf Basis der Lage der identifizierten Magnetfeldsensoren (504) im Statormodul (300) in einem Positionsidentifikationsschritt (169).

11. Verfahren nach Anspruch 1, wobei der Sensormusterbestimmungsschritt (103) umfasst:

Ermitteln einer Geschwindigkeit des Läufers (400) in einer Bewegung des Läufers (400) entlang dem Steuerpfad (SP) in einem Geschwindigkeitsermittlungsschritt (171); und
Bestimmen des Sensormusters (SM) auf Basis der ermittelten Geschwindigkeit des Läufers (400) entlang des Steuerpfads.

12. Verfahren (100) nach einem der voranstehenden Ansprüche, wobei die Bestimmung der ersten Position (P1) des Läufers (400) auf dem Statormodul (300), die Bestimmung der zweiten Position (P2) des Läufers (400) auf dem Statormodul (300) und die Bestimmung der dritten Position des Läufers (400) auf dem Statormodul (300), sowie die Bestimmung der ersten Teilposition, der zweiten Teilposition, der dritten Teilposition, der vierten Teilposition, der weiteren ersten Teilposition, der weiteren zweiten Teilposition, der weiteren dritten Teilposition und der weiteren vierten Teilposition durch ein trainiertes neuronales Netz (205) ausgeführt wird, und wobei das trainierte neuronale Netz (205) eingerichtet ist, auf Basis der Messwerte des Läufermagnetfelds der Magnetfeldsensoren (501) des Sensormoduls (500) unter Berücksichtigung der Positionierungen der Magnetfeldsensoren (501) des Sensormoduls (500) in dem Statormodul (300) eine Position des Läufers (400) auf dem Statormodul (300) zu bestimmen.

13. Verfahren (100) nach einem der voranstehenden Ansprüche, wobei die erste Position (P1), die zweite Position (P2) und die dritte Position identisch sind, und wobei das Steuern des Läufers (400) entlang des Steuerpfads ein Halten des Läufers (400) in der ersten Position umfasst.

14. Verfahren (100) nach einem der voranstehenden Ansprüche, wobei die erste Position (P1) einer Position des Läufers (400) entspricht, die der Läufer (400) zu einem ersten Positionsbestimmungszeitpunkt auf dem Statormodul (300) einnimmt, wobei die zweite Position (P2) einer Position des Läufers (400) entspricht, die der Läufer (400) zu einem zweiten Positionsbestimmungszeitpunkt auf dem Statormodul (300) einnimmt, wobei die dritte Position einer Position des Läufers (400) entspricht, die der Läufer (400) zu einem dritten Positionsbestimmungszeitpunkt auf dem Statormodul (300) einnimmt, und wobei die Bestimmung der ersten Position (P1) und/oder die Bestimmung der zweiten Position (P2) und/oder die Bestimmung der dritten Position in aufeinanderfolgenden Steuerzyklen der Steuereinheit (201) des Planarantriebssystems (200) durchgeführt wird.

15. Planarantriebssystem (200) mit wenigstens einer Steuereinheit (201), einem Statormodul (300) und einem Läufer (400), wobei der Läufer (400) über eine magnetische Kopplung zwischen einem Läufermagnetfeld des Läufers (400) und einem Statormagnetfeld des Statormoduls (300) steuerbar ist, wobei das Statormodul (300) zum Bestimmen einer Position des Läufers (400) ein Sensormodul (500) mit einer Mehrzahl von Magnetfeldsensoren (501) umfasst, und wobei jeder Magnetfeldsensor (501) eingerichtet ist, für einen Raumbereich das Läufermagnetfeld zu bestimmen, und wobei die Steuereinheit (201) eingerichtet ist, ein Verfahren (100) nach einem der voranstehenden Ansprüche 1 bis 14 auszuführen.

**Claims**

1. Method (100) for controlling a planar drive system (200), wherein the planar drive system (200) comprises at least one control unit (201), one stator module (300) and one rotor (400), wherein the rotor (400) can be controlled by means of a magnetic coupling between a rotor magnetic field of the rotor (400) and a stator magnetic field of the stator module (300), wherein the stator module (300), for determining a position of the rotor (400), comprises a sensor module (500) having a plurality of magnetic field sensors (501), and wherein each magnetic field sensor (501) is designed to determine the rotor magnetic field for a spatial region, **characterized by** the following method steps:

controlling the rotor (400) along a control path (SP) starting from a first position (P1) on the stator module (300) in a control step (101);
determining a sensor pattern (SM) of the magnetic field sensors (501) of the sensor module (500) in a sensor pattern determining step (103), wherein a sensor pattern (SM) comprises a subset of the magnetic field sensors (501) of the sensor module (500) of the stator module (300), wherein the sensor module (500) comprises at least one magnetic field sensor (501) which is not included in the sensor pattern (SM), and wherein a surface of the sensor pattern (SM) is at least partially covered by the rotor in a position along the control path, wherein the sensor pattern (SM) comprises at least one first sensor pattern (SM1) and one second sensor pattern (SM2), wherein the first sensor pattern (SM1) and the second sensor pattern (SM2) are shifted in relation to one another in a first orientation direction (D1), wherein
the sensor pattern determining step (103) comprises:

determining a first central magnetic field sensor (511) and determining a second central magnetic field sensor (512) in a magnetic field sensor determining step (173), wherein the first central magnetic field sensor (511) and the second central magnetic field sensor (512) are directly adjacent to the first position (P1) and are at extremely short distances from the first position (P1);
ascertaining a predetermined plurality of first magnetic field sensors which surround the first central magnetic field sensor (511), and identifying the plurality of first magnetic field sensors as a first sensor pattern (SM1) in a first identification step (175), wherein the first central magnetic field sensor (511) is arranged in a first geometric centre (Z1) of the first sensor pattern (SM1) ;
ascertaining a predetermined plurality of second magnetic field sensors which surround the second central magnetic field sensor (512), and identifying the plurality of second magnetic field sensors as a second sensor pattern (SM1) in a second identification step (177), wherein the second central magnetic field sensor (512) is arranged in a second geometric centre (Z2) of the second sensor pattern (SM2);
measuring measurement values of the rotor magnetic field using the magnetic field sensors (501) of the sensor pattern (SM) in a rotor magnetic field determining step (105), wherein the rotor magnetic field determining step (105) comprises:

measuring first measurement values of the rotor magnetic field using the magnetic field sensors (501) of the first sensor pattern (SM1) in a first rotor magnetic field partial determining step (109);
measuring second measurement values of the rotor magnetic field using the magnetic field sensors (501) of the second sensor pattern (SM2) in a second rotor magnetic field partial determining step (111);
detecting the rotor (400) and determining a second position (P2) of the rotor (400) on the basis of the measurement values, measured by the magnetic field sensors (501) of the sensor pattern (SM), of the rotor magnetic field in a position determining step (107),
wherein the position determining step (107) comprises:

detecting the rotor (400) and determining a first partial position of the rotor (400) on the basis of the first measurement values, measured by the magnetic field sensors (501) of the first sensor pattern (SM1), of the rotor magnetic field in a first rotor partial detection step (113);
detecting the rotor (400) and determining a second partial position of the rotor (400) on the basis of the measurement values, measured by the magnetic field sensors (501) of the second sensor pattern (SM2), of the rotor magnetic field in a second rotor partial detection step (115);
determining a first weighting value of the first sensor pattern (SM1) and a second weighting value of the second sensor pattern (SM2) in a weighting step (117); and
determining the second position (P2) of the rotor (400) as a weighted mean value from the first partial position and the second partial position taking into consideration the first weighting value and the second weighting value in an averaging step (119).

2. Method according to Claim 1, wherein the sensor pattern (SM) further comprises a third sensor pattern (SM3) and a fourth sensor pattern (SM4), wherein the third sensor pattern (SM3) and the fourth sensor pattern (SM4) are shifted in relation to one another in a second orientation direction (D2) oriented perpendicularly to the first orientation direction (D1), wherein the sensor pattern determining step (103) comprises:

determining a third central magnetic field sensor (513) and determining a fourth central magnetic field sensor (514) in the magnetic field sensor determining step (173), wherein the third central magnetic field sensor (513) and the fourth central magnetic field sensor (514) are directly adjacent to the first position (P1) and are at extremely short distances from the first position (P1) ;
ascertaining a predetermined plurality of third magnetic field sensors which surround the third central magnetic field sensor (513), and identifying the plurality of third magnetic field sensors as a third sensor pattern (SM3) in a third identification step (179), wherein the third central magnetic field sensor (513) is arranged in a third geometric centre (Z3) of the third sensor pattern (SM3); and ascertaining a predetermined plurality of fourth magnetic field sensors which surround the fourth central magnetic field sensor (514), and identifying the plurality of fourth magnetic field sensors as a fourth sensor pattern (SM4) in a fourth identification step (181), wherein the fourth central magnetic field sensor (514) is arranged in a fourth geometric centre (Z4) of the fourth sensor pattern (SM4), and wherein the rotor magnetic field determining step (105) comprises:

measuring third measurement values of the rotor magnetic field using the magnetic field sensors (501) of the third sensor pattern (SM3) in a third rotor magnetic field partial determining step (121);
measuring fourth measurement values of the rotor magnetic field using the magnetic field sensors (501) of the fourth sensor pattern (SM4) in a fourth rotor magnetic field partial determining step (123);
wherein the position determining step (107) comprises:

detecting the rotor (400) and determining a third partial position of the rotor (400) on the basis of the third measurement values, measured by the magnetic field sensors (501) of the third sensor pattern (SM3), of the rotor magnetic field in a third rotor partial detection step (125);
detecting the rotor (400) and determining a fourth partial position of the rotor (400) on the basis of the fourth measurement values, measured by the magnetic field sensors (501) of the fourth sensor pattern (SM4), of the rotor magnetic field in a fourth rotor partial detection step (127);
determining a third weighting value of the third sensor pattern (SM3) and a fourth weighting value of the fourth sensor pattern (SM4) in a weighting step (117); and
determining the second position (P2) of the rotor (400) as a weighted average from the first partial position, the second partial position, the third partial position and the fourth partial position taking into consideration the first weighting value, the second weighting value, the third weighting value and the fourth weighting value in the averaging step (119).

3. Method according to Claim 2, further comprising:
determining a first match value of the first position (P1) of the rotor (400) on the stator module (300) with the first positioning of the first sensor pattern (SM1) on the stator module (300) and determining a second match value of the first position (P1) of the rotor (400) on the stator module (300) with a second positioning of the second sensor pattern (SM2) on the stator module (300) and/or determining a third match value of the first position (P1) of the rotor (400) on the stator module (300) with a third positioning of the third sensor pattern (SM3) on the stator module (300) and determining a fourth match value of the first position of the rotor (400) on the stator module (300) with a fourth positioning of the fourth sensor pattern (SM4) on the stator module (300) in a match determining step (129), wherein a match value assumes the value 1 in the event of matching of the first position (P1) of the rotor (400) with a positioning of a sensor pattern (SM), assumes the value 0 in the event of lack of matching of the first position of the rotor (400) with a positioning of the sensor pattern (SM) and assumes an arbitrary value between 1 and 0 in the event of partial matching of the first position (P1) of the rotor (400) with a positioning of a sensor pattern (SM); and identifying the first weighting value with the first match value and identifying the second weighting value with the second match value and/or identifying the third weighting value with the third match value and identifying the fourth weighting value with the fourth match value in a weighting value identification step (131).

4.  Method according to Claim 2, wherein there is matching of the first position (P1) of the rotor (400) on the stator module (300) with a positioning of a sensor pattern (SM1) if a distance of the first position (P1) of the rotor (400) from a marked point of the sensor pattern (SM) is less than or equal to a first predetermined limit value, wherein there is no matching of the first position (P1) of the rotor (400) on the stator module (300) with a positioning of a sensor pattern (SM1) if a distance of the first position of the rotor (400) from the marked point of the sensor pattern (SM1) is greater than or equal to a second predetermined limit value, and wherein there is partial matching of the first position (P1) of the rotor (400) on the stator module (300) with the positioning of the sensor pattern (SM) if the distance of the first position (P1) of the rotor (400) from the marked point of the sensor pattern (SM) is greater than the first predetermined limit value and less than the second predetermined limit value.

5.  Method according to Claim 4, wherein the marked point of the sensor pattern (SM) is defined by a geometric centre (Z) of the sensor pattern (SM).

6.  Method according to one of the preceding claims, further comprising:

    shifting the first sensor pattern (SM1) and the second sensor pattern (SM2) along the first orientation direction (D1) and determining a shifted first sensor pattern (SM1) and a shifted second sensor pattern (SM2) in a shifting step (133);
    measuring further first measurement values of the rotor magnetic field using the magnetic field sensors (501) of the shifted first sensor pattern in a fifth rotor magnetic field partial determining step (135);
    measuring further second measurement values of the rotor magnetic field using the magnetic field sensors (501) of the shifted second sensor pattern in a sixth rotor magnetic field partial determining step (137);
    detecting the rotor (400) and determining a further first partial position of the rotor (400) on the basis of the further first measurement values, measured by the magnetic field sensors (501) of the shifted first sensor pattern, of the rotor magnetic field in a fifth rotor partial detection step (139);
    detecting the rotor (400) and determining a further second partial position of the rotor (400) on the basis of the further second measurement values, measured by the magnetic field sensors (501) of the shifted second sensor pattern, of the rotor magnetic field in a sixth rotor partial detection step (141);
    determining a further first weighting value of the shifted first sensor pattern and a further second weighting value of the shifted second sensor pattern in a further weighting step (143); and
    determining a third position of the rotor (400) as a weighted average from the further first partial position and the further second partial position taking into consideration the further first weighting value and the further second weighting value in a further averaging step (145).

7.  Method according to Claim 6, further comprising:

    shifting the third sensor pattern (SM3) and the fourth sensor pattern (SM4) along the first orientation direction (D1) and determining a shifted third sensor pattern and a shifted fourth sensor pattern in the shifting step (133);
    measuring further third measurement values of the rotor magnetic field using the magnetic field sensors (501) of the shifted third sensor pattern in a seventh rotor magnetic field partial determining step (147);
    measuring further fourth measurement values of the rotor magnetic field using the magnetic field sensors (501) of the shifted fourth sensor pattern in an eighth rotor magnetic field partial determining step (149);
    detecting the rotor (400) and determining a further third partial position of the rotor (400) on the basis of the further third measurement values, measured by the magnetic field sensors (501) of the shifted third sensor pattern, of the rotor magnetic field in a seventh rotor partial detection step (151);
    detecting the rotor (400) and determining a further fourth partial position of the rotor (400) on the basis of the further fourth measurement values, measured by the magnetic field sensors (501) of the shifted fourth sensor pattern, of the rotor magnetic field in an eighth rotor partial detection step (153);
    determining a further third weighting value of the shifted third sensor pattern and a further fourth weighting value of the shifted fourth sensor pattern in the further weighting step (143); and
    determining a third position of the rotor (400) as a weighted average from the further first partial position, the further second partial position, the further third partial position and the further fourth partial position taking into consideration the further first weighting value, the further second weighting value, the further third weighting

35

value and the further fourth weighting value in the further averaging step (145).

8.  Method according to Claim 6 or 7, wherein the shifting step (133) comprises:

    determining a further first central magnetic field sensor and determining a further second central magnetic field sensor and/or determining a further third central magnetic field sensor and determining a further fourth central magnetic field sensor in a further magnetic field sensor determining step (183), wherein the further first central magnetic field sensor and the further second central magnetic field sensor and/or the further third central magnetic field sensor and the further fourth central magnetic field sensor are directly adjacent to the second position (P2) and are at extremely short distances from the second position (P2);
    ascertaining a predetermined plurality of further first magnetic field sensors which surround the further first central magnetic field sensor, and identifying the plurality of further first magnetic field sensors as a shifted first sensor pattern in a further first identification step (185), wherein the further first central magnetic field sensor is arranged in a further first geometric centre of the shifted first sensor pattern;
    ascertaining a predetermined plurality of further second magnetic field sensors which surround the further second central magnetic field sensor, and identifying the plurality of further second magnetic field sensors as a second shifted sensor pattern in a further second identification step (187), wherein the further second central magnetic field sensor is arranged in a further second geometric centre of the shifted second sensor pattern; and/or ascertaining a predetermined plurality of further third central magnetic field sensors which surround the further third magnetic field sensor, and identifying the plurality of further third magnetic field sensors as a shifted third sensor pattern in a further third identification step (189), wherein the further third central magnetic field sensor is arranged in a further third geometric centre of the shifted third sensor pattern; and ascertaining a predetermined plurality of further fourth magnetic field sensors which surround the further fourth central magnetic field sensor, and identifying the plurality of further fourth magnetic field sensors as a shifted fourth sensor pattern in a further fourth identification step (191), wherein the further fourth central magnetic field sensor is arranged in a further fourth geometric centre of the shifted fourth sensor pattern.

9.  Method according to Claim 6, 7 or 8, wherein the further first weighting value corresponds to a match value between the second position (P2) of the rotor (400) and a positioning of the first sensor pattern (SM1), wherein the further second weighting value corresponds to a match value between the second position (P2) of the rotor (400) and a positioning of the second sensor pattern (SM2), wherein the further third weighting value corresponds to a matching value between the second position (P2) of the rotor (400) and a positioning of the third sensor pattern (SM3), and wherein the further fourth weighting value corresponds to a match value between the second position (P2) of the rotor (400) and a positioning of the fourth sensor pattern (SM4).

10. Method according to one of the preceding claims, further comprising:

    determining the first position (P1) of the rotor (400) on the stator module (300) in a rotor position determining step (155);
    wherein the rotor position determining step (155) comprises:

        magnetic field sensors (501) of the sensor module (500) recording measurement values in a measurement value determining step (157);
        identifying a magnetic field sensor (503) of the sensor module (500), the measurement value of the magnetic field sensor reaching or exceeding a predetermined limit value, in a magnetic field sensor identification step (159);
        magnetic field sensors (504) of the sensor module (500) in the direct vicinity of the first-identified magnetic field sensor (503) recording measurement values in a further measurement value determining step (161);
        identifying the magnetic field sensors (504) in the direct vicinity of the first-identified magnetic field sensor (503), the measurement values of the magnetic field sensors reaching or exceeding the predetermined limit value, in a further magnetic field sensor identification step (163);
        determining a detection sensor pattern (DSM) in a detection pattern determining step (165), wherein a detection sensor pattern (DSM) comprises identified magnetic field sensors (504);
        detecting the rotor (400) on the basis of the measurement values of the magnetic field sensors (504) of the detection sensor pattern (DSM) in a rotor detection step (167); and
        identifying the first position (P1) of the rotor (400) on the basis of the position of the identified magnetic field sensors (504) in the stator module (300) in a position identification step (169).

**11.** Method according to Claim 1, wherein the sensor pattern determining step (103) comprises:

ascertaining a speed of the rotor (400) during a movement of the rotor (400) along the control path (SP) in a speed ascertaining step (171); and

determining the sensor pattern (SM) on the basis of the ascertained speed of the rotor (400) along the control path.

**12.** Method (100) according to one of the preceding claims, wherein determining the first position (P1) of the rotor (400) on the stator module (300), determining the second position (P2) of the rotor (400) on the stator module (300) and determining the third position of the rotor (400) on the stator module (300) as well as determining the first partial position, the second partial position, the third partial position, the fourth partial position, the further first partial position, the further second partial position, the further third partial position and the further fourth partial position are executed by a trained neural network (205), and wherein the trained neural network (205) is designed to determine a position of the rotor (400) on the stator module (300) on the basis of the measurement values of the rotor magnetic field of the magnetic field sensors (501) of the sensor module (500) taking into consideration the positionings of the magnetic field sensors (501) of the sensor module (500) in the stator module (300).

**13.** Method (100) according to one of the preceding claims, wherein the first position (P1), the second position (P2) and the third position are identical, and wherein control of the rotor (400) along the control path comprises keeping the rotor (400) in the first position.

**14.** Method (100) according to one of the preceding claims, wherein the first position (P1) corresponds to a position of the rotor (400) that the rotor (400) assumes on the stator module (300) at a first position determining time, wherein the second position (P2) corresponds to a position of the rotor (400) that the rotor (400) assumes on the stator module (300) at a second position determining time, wherein the third position corresponds to a position of the rotor (400) that the rotor (400) assumes on the stator module (300) at a third position determining time, and wherein determining the first position (P1) and/or determining the second position (P2) and/or determining the third position are/is carried out in successive control cycles of the control unit (201) of the planar drive system (200).

**15.** Planar drive system (200) comprising at least one control unit (201), one stator module (300) and one rotor (400), wherein the rotor (400) can be controlled by means of a magnetic coupling between a rotor magnetic field of the rotor (400) and a stator magnetic field of the stator module (300), wherein the stator module (300), for determining a position of the rotor (400), comprises a sensor module (500) having a plurality of magnetic field sensors (501), and wherein each magnetic field sensor (501) is designed to determine the rotor magnetic field for a spatial region, and wherein the control unit (201) is designed to execute a method (100) according to one of the preceding Claims 1 to 14.

**Revendications**

**1.** Procédé (100) permettant de commander un système d'entraînement planaire (200), le système d'entraînement planaire (200) comprenant au moins une unité de commande (201), un module de stator (300) et un rotor (400), dans lequel le rotor (400) peut être commandé par l'intermédiaire d'un couplage magnétique entre un champ magnétique de rotor du rotor (400) et un champ magnétique de stator du module de stator (300), dans lequel le module de stator (300) comprend un module de capteur (500) muni d'une pluralité de capteurs de champ magnétique (501) pour déterminer une position du rotor (400), et dans lequel chaque capteur de champ magnétique (501) est conçu pour déterminer le champ magnétique de rotor pour une région spatiale, **caractérisé par** les étapes de procédé suivantes consistant à :

commander le rotor (400) le long d'un trajet de commande (SP) en partant d'une première position (P1) sur le module de stator (300), dans une étape de commande (101) ;

déterminer un motif de capteurs (SM) des capteurs de champ magnétique (501) du module de capteur (500) dans une étape de détermination de motif de capteurs (103), dans lequel un motif de capteurs (SM) comprend un sous-ensemble des capteurs de champ magnétique (501) du module de capteur (500) du module de stator (300), dans lequel le module de capteur (500) comprend au moins un capteur de champ magnétique (501) qui n'est pas compris dans le motif de capteurs (SM), et dans lequel une superficie du motif de capteurs (SM) est couverte au moins en partie par le rotor dans une position le long du trajet de commande, dans lequel le motif de capteurs (SM) comprend au moins un premier motif de capteurs (SM1) et un deuxième motif de capteurs (SM2), dans lequel le premier motif de capteurs (SM1) et le deuxième motif de capteurs (SM2) sont décalés l'un par rapport à l'autre dans une première direction d'orientation (D1), l'étape de détermination de motif de capteurs (103) comprenant :

la détermination d'un premier capteur de champ magnétique central (511) et la détermination d'un deuxième capteur de champ magnétique central (512) dans une étape de détermination de capteur de champ magnétique (173), dans lequel le premier capteur de champ magnétique central (511) et le deuxième capteur de champ magnétique central (512) sont directement adjacents à la première position (P1) et présentent les plus courtes distances jusqu'à la première position (P1);

l'établissement d'une pluralité prédéterminée de premiers capteurs de champ magnétique qui entourent le premier capteur de champ magnétique central (511), et l'identification de la pluralité de premiers capteurs de champ magnétique comme premier motif de capteurs (SM1) dans une première étape d'identification (175), dans lequel le premier capteur de champ magnétique central (511) est disposé en un premier centre géométrique (Z1) du premier motif de capteurs (SM1) ;

l'établissement d'une pluralité prédéterminée de deuxièmes capteurs de champ magnétique qui entourent le deuxième capteur de champ magnétique central (512), et l'identification de la pluralité de deuxièmes capteurs de champ magnétique comme deuxième motif de capteurs (SM1) dans une deuxième étape d'identification (177), dans lequel le deuxième capteur de champ magnétique central (512) est disposé en un deuxième centre géométrique (Z2) du deuxième motif de capteurs (SM2) ;

la mesure de valeurs de mesure du champ magnétique de rotor par les capteurs de champ magnétique (501) du motif de capteurs (SM) dans une étape de détermination de champ magnétique de rotor (105), l'étape de détermination de champ magnétique de rotor (105) comprenant :

la mesure de premières valeurs de mesure du champ magnétique de rotor par les capteurs de champ magnétique (501) du premier motif de capteurs (SM1) dans une première étape de détermination partielle de champ magnétique de rotor (109) ;

la mesure de deuxièmes valeurs de mesure du champ magnétique de rotor par les capteurs de champ magnétique (501) du deuxième motif de capteurs (SM2) dans une deuxième étape de détermination partielle de champ magnétique de rotor (111) ;

la détection du rotor (400) et la détermination d'une deuxième position (P2) du rotor (400) sur la base des valeurs de mesure du champ magnétique de rotor, mesurées par les capteurs de champ magnétique (501) du motif de capteurs (SM), dans une étape de détermination de position (107), l'étape de détermination de position (107) comprenant :

la détection du rotor (400) et la détermination d'une première position partielle du rotor (400) sur la base des premières valeurs de mesure du champ magnétique de rotor, mesurées par les capteurs de champ magnétique (501) du premier motif de capteurs (SM1), dans une première étape de détection partielle de rotor (113) ;

la détection du rotor (400) et la détermination d'une deuxième position partielle du rotor (400) sur la base des valeurs de mesure du champ magnétique de rotor, mesurées par les capteurs de champ magnétique (501) du deuxième motif de capteurs (SM2), dans une deuxième étape de détection partielle de rotor (115) ;

la détermination d'une première valeur de pondération du premier motif de capteurs (SM1) et d'une deuxième valeur de pondération du deuxième motif de capteurs (SM2) dans une étape de pondération (117) ; et

la détermination de la deuxième position (P2) du rotor (400) comme une moyenne pondérée de la première position partielle et de la deuxième position partielle en tenant compte de la première valeur de pondération et de la deuxième valeur de pondération dans une étape de calcul de moyenne (119).

2. Procédé selon la revendication 1, dans lequel le motif de capteurs (SM) comprend en outre un troisième motif de capteurs (SM3) et un quatrième motif de capteurs (SM4), dans lequel le troisième motif de capteurs (SM3) et le quatrième motif de capteurs (SM4) sont décalés l'un par rapport à l'autre dans une deuxième direction d'orientation (D2) orientée perpendiculairement à la première direction d'orientation (D1), l'étape de détermination de motif de capteurs (103) comprenant :

la détermination d'un troisième capteur de champ magnétique central (513) et la détermination d'un quatrième capteur de champ magnétique central (514) à l'étape de détermination de capteur de champ magnétique (173), dans lequel le troisième capteur de champ magnétique central (513) et le quatrième capteur de champ magnétique central (514) sont directement adjacents à la première position (P1) et présentent les plus courtes distances jusqu'à la première position (P1) ;

l'établissement d'une pluralité prédéterminée de troisièmes capteurs de champ magnétique qui entourent le troisième capteur de champ magnétique central (513), et l'identification de la pluralité de troisièmes capteurs de champ magnétique comme troisième motif de capteurs (SM3) dans une troisième étape d'identification (179), dans lequel le troisième capteur de champ magnétique central (513) est disposé en un troisième centre géométrique (Z3) du troisième motif de capteurs (SM3) ; et l'établissement d'une pluralité prédéterminée de quatrièmes capteurs de champ magnétique qui entourent le quatrième capteur de champ magnétique central (514), et l'identification de la pluralité de quatrièmes capteurs de champ magnétique comme quatrième motif de capteurs (SM4) dans une quatrième étape d'identification (181), dans lequel le quatrième capteur de champ magnétique central (514) est disposé en un quatrième centre géométrique (Z4) du quatrième motif de capteurs (SM4), et l'étape de détermination de champ magnétique de rotor (105) comprenant :

la mesure de troisièmes valeurs de mesure du champ magnétique de rotor par les capteurs de champ magnétique (501) du troisième motif de capteurs (SM3) dans une troisième étape de détermination partielle de champ magnétique (121) ;

la mesure de quatrièmes valeurs de mesure du champ magnétique de rotor par les capteurs de champ magnétique (501) du quatrième motif de capteurs (SM4) dans une quatrième étape de détermination partielle de champ magnétique de rotor (123) ;

l'étape de détermination de position (107) comprenant :

la détection du rotor (400) et la détermination d'une troisième position partielle du rotor (400) sur la base des troisièmes valeurs de mesure du champ magnétique de rotor, mesurées par les capteurs de champ magnétique (501) du troisième motif de capteurs (SM3), dans une troisième étape de détection partielle de rotor (125) ;

la détection du rotor (400) et la détermination d'une quatrième position partielle du rotor (400) sur la base des quatrièmes valeurs de mesure du champ magnétique de rotor, mesurées par les capteurs de champ magnétique (501) du quatrième motif de capteurs (SM4), dans une quatrième étape de détection partielle de rotor (127) ;

la détermination d'une troisième valeur de pondération du troisième motif de capteurs (SM3) et d'une quatrième valeur de pondération du quatrième motif de capteurs (SM4) à l'étape de pondération (117) ; et

la détermination de la deuxième position (P2) du rotor (400) comme une moyenne pondérée de la première position partielle, de la deuxième position partielle, de la troisième position partielle et de la quatrième position partielle en tenant compte de la première valeur de pondération, de la deuxième valeur de pondération, de la troisième valeur de pondération et

de la quatrième valeur de pondération à l'étape de calcul de moyenne (119).

3. Procédé selon la revendication 2, comprenant en outre les étapes consistant à :

déterminer une première valeur de concordance de la première position (P1) du rotor (400) sur le module de stator (300) avec un premier positionnement du premier motif de capteurs (SM1) sur le module de stator (300), et déterminer une deuxième valeur de concordance de la première position (P1) du rotor (400) sur le module de stator (300) avec un deuxième positionnement du deuxième motif de capteurs (SM2) sur le module de stator (300) et/ou déterminer une troisième valeur de concordance de la première position (P1) du rotor (400) sur le module de stator (300) avec un troisième positionnement du troisième motif de capteurs (SM3) sur le module de stator (300), et déterminer une quatrième valeur de concordance de la première position du rotor (400) sur le module de stator (300) avec un quatrième positionnement du quatrième motif de capteurs (SM4) sur le module de stator (300) dans une étape de détermination de concordance (129), dans lequel une valeur de concordance adopte la valeur 1 en cas de concordance de la première position (P1) du rotor (400) avec un positionnement d'un motif de capteurs (SM), adopte la valeur 0 en cas d'absence de concordance de la première position du rotor (400) avec un positionnement d'un motif de capteurs (SM), et adopte une valeur quelconque entre 1 et 0 en cas de concordance partielle de la première position (P1) du rotor (400) avec un positionnement d'un motif de capteurs (SM) ; et

identifier la première valeur de pondération avec la première valeur de concordance, et identifier la deuxième valeur de pondération avec la deuxième valeur de concordance, et/ou identifier la troisième valeur de pondération avec la troisième valeur de concordance et identifier la quatrième valeur de pondération avec la quatrième valeur de concordance dans une étape d'identification de valeur de pondération (131).

**4.** Procédé selon la revendication 2, dans lequel il existe une concordance de la première position (P1) du rotor (400) sur le module de stator (300) avec un positionnement d'un motif de capteurs (SM1) si une distance entre la première position (P1) du rotor (400) et un point désigné du motif de capteurs (SM) est inférieure ou égale à une première valeur limite prédéterminée, dans lequel il n'existe pas de concordance de la première position (P1) du rotor (400) sur le module de stator (300) avec un positionnement d'un motif de capteurs (SM1) si une distance entre la première position du rotor (400) et le point désigné du motif de capteurs (SM1) est supérieure ou égale à une deuxième valeur limite prédéterminée, et dans lequel il existe une concordance partielle de la première position (P1) du rotor (400) sur le module de stator (300) avec le positionnement du motif de capteurs (SM) si la distance entre la première position (P1) du rotor (400) et le point désigné du motif de capteurs (SM) est supérieure à la première valeur limite prédéterminée et inférieure à la deuxième valeur limite prédéterminée.

**5.** Procédé selon la revendication 4, dans lequel le point désigné du motif de capteurs (SM) est défini par un centre géométrique (Z) du motif de capteurs (SM).

**6.** Procédé selon l'une quelconque des revendications précédentes, comprenant en outre les étapes consistant à :

décaler le premier motif de capteurs (SM1) et le deuxième motif de capteurs (SM2) le long de la première direction d'orientation (D1) et déterminer un premier motif de capteurs décalé (SM1) et un deuxième motif de capteurs décalé (SM2) dans une étape de décalage (133) ;
mesurer d'autres premières valeurs de mesure du champ magnétique de rotor par les capteurs de champ magnétique (501) du premier motif de capteurs décalé dans une cinquième étape de détermination partielle de champ magnétique de rotor (135) ;
mesurer d'autres deuxièmes valeurs de mesure du champ magnétique de rotor par les capteurs de champ magnétique (501) du deuxième motif de capteurs décalé dans une sixième étape de détermination partielle de champ magnétique de rotor (137) ;
détecter le rotor (400) et déterminer une autre première position partielle du rotor (400) sur la base des autres premières valeurs de mesure du champ magnétique de rotor, mesurées par les capteurs de champ magnétique (501) du premier motif de capteurs décalé, dans une cinquième étape de détection partielle de rotor (139) ;
détecter le rotor (400) et déterminer une autre deuxième position partielle de rotor (400) sur la base des autres deuxièmes valeurs de mesure du champ magnétique de rotor, mesurées par les capteurs de champ magnétique (501) du deuxième motif de capteurs décalé, dans une sixième étape de détection partielle de rotor (141) ;
déterminer une autre première valeur de pondération du premier motif de capteurs décalé et une autre deuxième valeur de pondération du deuxième motif de capteurs décalé dans une autre étape de pondération (143) ; et
déterminer une troisième position du rotor (400) comme une moyenne pondérée de l'autre première position partielle et de l'autre deuxième position partielle en tenant compte de l'autre première valeur de pondération et de l'autre deuxième valeur de pondération dans une autre étape de calcul de moyenne (145).

**7.** Procédé selon la revendication 6, comprenant en outre les étapes consistant à :

décaler le troisième motif de capteurs (SM3) et le quatrième motif de capteurs (SM4) le long de la première direction d'orientation (D1), et déterminer un troisième motif de capteurs décalé et un quatrième motif de capteurs décalé à l'étape de décalage (133) ;
mesurer d'autres troisièmes valeurs de mesure du champ magnétique de rotor par les capteurs de champ magnétique (501) du troisième motif de capteurs décalé dans une septième étape de détermination partielle de champ magnétique de rotor (147) ;
mesurer d'autres quatrièmes valeurs de mesure du champ magnétique de rotor par les capteurs de champ magnétique (501) du quatrième motif de capteurs décalé dans une huitième étape de détermination partielle de champ magnétique de rotor (149) ;
détecter le rotor (400) et déterminer une autre troisième position partielle du rotor (400) sur la base des autres troisièmes valeurs de mesure du champ magnétique de rotor, mesurées par les capteurs de champ magnétique (501) du troisième motif de capteurs décalé, dans une septième étape de détection partielle de rotor (151) ;
détecter le rotor (400) et déterminer une autre quatrième position partielle de rotor (400) sur la base des quatrièmes autres valeurs de mesure du champ magnétique de rotor, mesurées par les capteurs de champ magnétique (501) du quatrième motif de capteurs décalé, dans une huitième étape de détection partielle de rotor (153) ;
déterminer une autre troisième valeur de pondération du troisième motif de capteurs décalé et une autre quatrième valeur de pondération du quatrième motif de capteurs décalé dans l'autre étape de pondération (143) ; et
déterminer la troisième position du rotor (400) comme une moyenne pondérée de l'autre première position partielle, de l'autre deuxième position partielle, de l'autre troisième position partielle et de l'autre quatrième position partielle en tenant compte de l'autre première valeur de pondération, de l'autre deuxième valeur de pondération, de l'autre troisième valeur de pondération et de l'autre quatrième valeur de pondération dans l'autre étape de calcul de moyenne (145) .

**8.** Procédé selon la revendication 6 ou 7, dans lequel l'étape de décalage (133) comprend les étapes consistant à :

déterminer un autre premier capteur de champ magnétique central et déterminer un autre deuxième capteur de champ magnétique central et/ou déterminer un autre troisième capteur de champ magnétique central et déterminer un autre quatrième capteur de champ magnétique central dans une autre étape de détermination de capteur de champ magnétique (183), dans lequel l'autre premier capteur de champ magnétique central et l'autre deuxième capteur de champ magnétique central et/ou l'autre troisième capteur de champ magnétique central et l'autre quatrième capteur de champ magnétique central sont directement adjacents à la deuxième position (P2) et présentent les plus courtes distances jusqu'à la deuxième position (P2) ;

établir une pluralité prédéterminée d'autres premiers capteurs de champ magnétique qui entourent l'autre premier capteur de champ magnétique central, et identifier la pluralité d'autres premiers capteurs de champ magnétique comme premier motif de capteurs décalé dans une autre première étape d'identification (185), dans lequel l'autre premier capteur de champ magnétique central est disposé en un autre premier centre géométrique du premier motif de capteurs décalé ;

établir une pluralité prédéterminée d'autres deuxièmes capteurs de champ magnétique qui entourent l'autre deuxième capteur de champ magnétique central, et identifier la pluralité d'autres deuxièmes capteurs de champ magnétique comme deuxième motif de capteurs décalé dans une autre deuxième étape d'identification (187), dans lequel l'autre deuxième capteur de champ magnétique central est disposé en un autre deuxième centre géométrique du deuxième motif de capteurs décalé ; et/ou

établir une pluralité prédéterminée d'autres troisièmes capteurs de champ magnétique centraux qui entourent l'autre troisième capteur de champ magnétique, et identifier la pluralité d'autres troisièmes capteurs de champ magnétique comme troisième motif de capteurs décalé dans une autre troisième étape d'identification (189), dans lequel l'autre troisième capteur de champ magnétique central est disposé en un autre troisième centre géométrique du troisième motif de capteurs décalé ; et établir une pluralité prédéterminée d'autres quatrièmes capteurs de champ magnétique qui entourent l'autre quatrième capteur de champ magnétique central, et identifier la pluralité d'autres quatrièmes capteurs de champ magnétique comme quatrième motif de capteurs décalé dans une autre quatrième étape d'identification (191), dans lequel l'autre quatrième capteur de champ magnétique central est disposé en un autre quatrième centre géométrique du quatrième motif de capteurs décalé.

**9.** Procédé selon la revendication 6, 7 ou 8, dans lequel l'autre première valeur de pondération correspond à une valeur de concordance entre la deuxième position (P2) du rotor (400) et un positionnement du premier motif de capteurs (SM1), dans lequel l'autre deuxième valeur de pondération correspond à une valeur de concordance entre la deuxième position (P2) du rotor (400) et un positionnement du deuxième motif de capteurs (SM2), dans lequel l'autre troisième valeur de pondération correspond à une valeur de concordance entre la deuxième position (P2) du rotor (400) et un positionnement du troisième motif de capteurs (SM3), et dans lequel l'autre quatrième valeur de pondération correspond à une valeur de concordance entre la deuxième position (P2) du rotor (400) et un positionnement du quatrième motif de capteurs (SM4).

**10.** Procédé selon l'une quelconque des revendications précédentes, comprenant en outre les étapes consistant à :

déterminer la première position (P1) du rotor (400) sur le module de stator (300) dans une étape de détermination de position de rotor (155) ;
l'étape de détermination de position de rotor comprenant (155) :

l'enregistrement de valeurs de mesure de capteurs de champ magnétique (501) du module de capteur (500) dans une étape de détermination de valeur de mesure (157) ;
l'identification d'un capteur de champ magnétique (503) du module de capteur (500) dont la valeur de mesure atteint ou dépasse une valeur limite prédéterminée, dans une étape d'identification de capteur de champ magnétique (159) ;
l'enregistrement de valeurs de mesure de capteurs de champ magnétique (504) du module de capteur (500) à proximité immédiate du capteur de champ magnétique (503) identifié en premier, dans une autre étape de détermination de valeur de mesure (161) ;
l'identification des capteurs de champ magnétique (504) à proximité immédiate du capteur de champ magnétique (503) identifié en premier dont les valeurs de mesure atteignent ou dépassent la valeur limite prédéterminée, dans une autre étape d'identification de champ magnétique (163) ;

la détermination d'un motif de capteurs de détection (DSM) dans une étape de détermination de motif de détection (165), dans lequel un motif de capteurs de détection (DSM) comprend des capteurs de champ magnétique identifiés (504) ;

la détection du rotor (400) sur la base des valeurs mesurées des capteurs de champ magnétique (504) du motif de capteurs de détection (DSM), dans une étape de détection de rotor (167) ; et

l'identification de la première position (P1) du rotor (400) sur la base de la position des capteurs de champ magnétique identifiés (504) dans le module de stator (300), dans une étape d'identification de position (169) .

11. Procédé selon la revendication 1, dans lequel l'étape de détermination de motif de capteurs (103) comprend :

l'établissement d'une vitesse du rotor (400) dans un mouvement du rotor (400) le long du trajet de commande (SP) dans une étape d'établissement de vitesse (171) ; et

la détermination du motif de capteurs (SM) sur la base de la vitesse établie du rotor (400) le long du trajet de commande.

12. Procédé (100) selon l'une quelconque des revendications précédentes, dans lequel la détermination de la première position (P1) du rotor (400) sur le module de stator (300), la détermination de la deuxième position (P2) du rotor (400) sur le module de stator (300) et la détermination de la troisième position du rotor (400) sur le module de stator (300), ainsi que la détermination de la première position partielle, de la deuxième position partielle, de la troisième position partielle, de la quatrième position partielle, de l'autre première position partielle, de l'autre deuxième position partielle, de l'autre troisième position partielle et de l'autre quatrième position partielle sont effectuées par un réseau neuronal entraîné (205), et dans lequel le réseau neuronal entraîné (205) est conçu pour déterminer une position du rotor (400) sur le module de stator (300) sur la base des valeurs mesurées du champ magnétique de rotor des capteurs de champ magnétique (501) du module de capteur (500) en tenant compte des positionnements des capteurs de champ magnétique (501) du module de capteur (500) dans le module de stator (300) .

13. Procédé (100) selon l'une quelconque des revendications précédentes, dans lequel la première position (P1), la deuxième position (P2) et la troisième position sont identiques, et dans lequel la commande du rotor (400) le long du trajet de commande comprend un maintien du rotor (400) dans la première position.

14. Procédé (100) selon l'une quelconque des revendications précédentes, dans lequel la première position (P1) correspond à une position du rotor (400) qu'adopte le rotor (400) sur le module de stator (300) à un premier instant de détermination de position, dans lequel la deuxième position (P2) correspond à une position du rotor (400) qu'adopte le rotor (400) sur le module de stator (300) à un deuxième instant de détermination de position, dans lequel la troisième position correspond à une position du rotor (400) qu'adopte le rotor (400) sur le module de stator (300) à un troisième instant de détermination de position, et dans lequel la détermination de la première position (P1) et/ou la détermination de la deuxième position (P2) et/ou la détermination de la troisième position sont effectuées dans des cycles de commande consécutifs de l'unité de commande (201) du système d'entraînement planaire (200).

15. Système d'entraînement planaire (200), comprenant au moins une unité de commande (201), un module de stator (300) et un rotor (400), dans lequel le rotor (400) peut être commandé par l'intermédiaire d'un couplage magnétique entre un champ magnétique de rotor du rotor (400) et un champ magnétique de stator du module de stator (300), dans lequel le module de stator (300) comprend un module de capteur (500) muni d'une pluralité de capteurs de champ magnétique (501) pour déterminer une position du rotor (400), et dans lequel chaque capteur de champ magnétique (501) est conçu pour déterminer le champ magnétique de rotor pour une région spatiale, et dans lequel l'unité de commande (201) est conçue pour exécuter un procédé (100) selon l'une quelconque des revendications précédentes 1 à 14.

**Fig. 1**

Fig. 2

**Fig. 3**

412, 415

403, 405

412, 417

401

400

412, 413

412, 419

407

409

**Fig. 4**

**Fig. 6**

100

101

103

105

107

100

101

173

175

177

103

109

111

105

113

115

117

119

107

Fig. 5

EP 4 143 953 B1

**Fig. 7**

Fig. 8

**Fig. 9**

**Fig. 10**

**Fig. 11**

**Fig. 12**

**Fig. 13**

**IN DER BESCHREIBUNG AUFGEFÜHRTE DOKUMENTE**

**In der Beschreibung aufgeführte Patentdokumente**

- DE 102020115449
- WO 2015017933 A1
- DE 102017131320 A1
- DE 102017131314 A1

**In der Beschreibung aufgeführte Nicht-Patentliteratur**

- A 6-DOF Measurement Solution for Permanent Magnet Synchronous Planar Motors Based on Motion Continuity Principle. **CHEN LNGMIN et al.** IEEE TRANSACTION. IEEE SERVICE CENTER, 01. Marz 2016, vol. 65, 643-655